(19) Europäisches Patentamt
European Patent Office
Office européen des brevets

(11) **EP 2 623 285 A1**

(12) **EUROPEAN PATENT APPLICATION**
published in accordance with Art. 153(4) EPC

(43) Date of publication:
**07.08.2013 Bulletin 2013/32**

(21) Application number: **11829381.0**

(22) Date of filing: **30.09.2011**

(51) Int Cl.:
**B29C 33/42** (2006.01)   **B29C 33/38** (2006.01)
**B29C 59/02** (2006.01)   **G02B 5/18** (2006.01)
**H01L 21/027** (2006.01)   **H01L 31/04** (2006.01)
**H01L 51/50** (2006.01)   **H05B 33/02** (2006.01)
**H05B 33/10** (2006.01)   **H05B 33/14** (2006.01)
**B29L 9/00** (2006.01)   **B29L 31/00** (2006.01)

(86) International application number:
**PCT/JP2011/072655**

(87) International publication number:
**WO 2012/043828 (05.04.2012 Gazette 2012/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:   **30.09.2010   JP 2010220198**
   **30.09.2010   JP 2010220197**
   **30.09.2010   JP 2010220196**

(71) Applicant: **Mitsubishi Rayon Co., Ltd.**
**Tokyo 100-8253 (JP)**

(72) Inventors:
• **SAEKI Yumiko**
**Yokohama-shi**
**Kanagawa 230-0053 (JP)**

• **ENDO Kuniaki**
**Yokohama-shi**
**Kanagawa 230-0053 (JP)**
• **HATTORI Toshiaki**
**Yokohama-shi**
**Kanagawa 230-0053 (JP)**
• **KONAMI Yukichi**
**Toyohashi-shi**
**Aichi 440-8601 (JP)**
• **FURUKAWA Kouji**
**Toyohashi-shi**
**Aichi 440-8601 (JP)**

(74) Representative: **TBK**
**Bavariaring 4-6**
**80336 München (DE)**

(54) **MOLD HAVING FINE IRREGULAR STRUCTURE ON SURFACE, METHOD OF PRODUCING PRODUCT HAVING FINE IRREGULAR STRUCTURE ON SURFACE, USE OF PRODUCT, STACK EXPRESSING HETEROCHROMIA AND SURFACE EMITTING MEMBER**

(57)   A mold having an uneven structure is provided, wherein surface roughness Ra of the uneven structure, a maximum value Ra' (max) and a minimum value Ra' (min) of line roughness Ra' satisfy the following Expression (1).

$$0.13 \leq (Ra'(max)-Ra'(min))/Ra \leq 0.82 \qquad (1)$$

FIG. 1

EP 2 623 285 A1

**Description**

Technical Field

The present invention relates to a mold having a fine uneven structure in a surface, a method of manufacturing an article having the fine uneven structure in a surface by using the mold, and a use of the article manufactured by the manufacturing method. In addition, the invention relates to a laminated body expressing an iris color and a surface-emitting body.
Priority is claimed on Japanese Patent Application Nos. 2010-220196, 2010-220197, and 2010-220198 filed September 30, 2010, the content of which is incorporated herein by reference.

Background Art

Surface-emitting bodies using an organic EL element or an inorganic EL element are known. As the surface-emitting body constituted by the organic EL element, a surface-emitting body is known including a transparent base material, a transparent electrode provided on a surface of the transparent base material, a rear surface electrode that is provided to be spaced from the transparent electrode and is formed from a metal thin film, and a light-emitting layer that is provided between the transparent electrode and the rear surface electrode and contains a light-emitting material of an organic compound.

In the surface-emitting body, when a hole supplied from the transparent electrode and an electron supplied from the rear surface electrode are coupled at the light-emitting layer, the light-emitting layer emits light. Light emitted from the light-emitting layer transmits through the transparent electrode and a transparent substrate, and is extracted from a radiation plane (a surface of the transparent substrate). In addition, a part of the light emitted from the light-emitting layer is reflected by the metal thin film of the rear surface electrode, and then transmits through the light-emitting layer, the transparent electrode, and the transparent substrate, and is extracted from the radiation plane.

However, in this surface-emitting body, when an angle of incidence of light that is incident to the transparent electrode, the transparent substrate, external air, and the like is larger than a threshold angle that is determined by a refractive index of a material that is an incidence source and a refractive index of a material that is an incidence destination, the light is totally reflected on an interface between the light-emitting layer and the transparent electrode, an interface between the transparent electrode and the transparent substrate, an interface (radiation plane) between the transparent substrate and the external air, and the like, and is trapped inside the surface-emitting body. Therefore, there is a problem in that a part of light is not extracted to the outside, and thus light extraction efficiency is low.

As a surface-emitting body to solve this problem, the following surface-emitting body is suggested.

(1) An organic EL element in which a diffraction grating constituted by a periodic fine uneven structure is formed in a surface of the rear surface electrode on a light-emitting layer side, or in a surface of the transparent substrate on a transparent electrode side (PTL 1).

In the organic EL element of (1), the light emitted from the light-emitting layer is diffracted by the diffraction grating in such a manner that the angle of incidence of the light that is incident to the transparent electrode, the transparent substrate, and the external air decreases, and thus the total reflection on the respective interfaces is reduced, and the light extraction efficiency is improved.
However, in the organic EL element of (1), since the diffraction grating is constituted by the periodic fine uneven structure, a deviation is present in an angle and a wavelength of light that is effectively diffracted by the diffraction grating. Therefore, the organic EL element of (1) is not suitable for a use in a display device, lighting equipment, and the like in which a wide range is uniformly irradiated.

In addition, as the surface-emitting body for solving the problem, the following surface-emitting body is suggested.

(2) An organic EL element using a transparent base material having a fine uneven structure (that is, a wrinkle-like fine uneven structure), which has a wide uneven period distribution and in which concavity and convexity extend in an irregular direction, formed in a surface (NPL 1).

The transparent base material that is used in the organic EL element of (2) is prepared by the following processes (i) to (iv).

(i) A process of forming a layer formed from polydimethyl siloxane (PDMS) on a surface of the base material.
(ii) A process of depositing aluminum on a surface of the PMDS layer to form a metal thin film formed from aluminum.

At this time, aluminum is deposited on the surface of the PDMS layer in a state in which the surface of the PDMS layer is expanded due to heat during the deposition.

(iii) A process of cooling the PDMS layer and the metal thin film. When the PDMS layer and the metal thin film are cooled, shrinkage occurs in the surface of the PDMS layer, and the shrinkage of the metal thin film occurs less, and thus the wrinkle-like fine uneven structure is formed in the surface of the PDMS layer due to a difference in a shrinkage rate between the PDMS layer and the metal thin film (buckling phenomenon). At this time, the metal thin film also conforms to the deformation of the surface of the PDMS layer, and thus a wrinkle-like fine uneven structure, which conforms to the wrinkle-like fine uneven structure in the surface of the PDMS layer, is also formed in the metal thin film.

(iv) A process of transferring the fine uneven structure to a PDMS layer on a surface of a separate base material by using a laminated body in which the wrinkle-like fine uneven structure is formed in the surface of the PDMS layer and the metal thin film as a mold.

(v) A process of depositing aluminum on a surface of the PDMS layer of the separate base material in which the fine uneven structure is transferred to the surface thereof to form a metal thin film formed from aluminum.

(vi) A process of repetitively forming the process (ii) to the process (v) after the process (iv) and ultimately being terminated in a process (iv). In this manner, a transparent base material, in which a wrinkle-like fine uneven structure having a high aspect ratio is formed in a surface thereof and is formed from PDMS, may be obtained.

However, in a laminated body in which the wrinkle-like fine uneven structure obtained by the process (iii) is formed in the surface of the PDMS layer and the metal thin film, adhesiveness at the interface between the PDMS layer and the metal thin film is inferior. Therefore, in the process (iv), when the fine uneven structure is transferred to the PDMS layer on the surface of the separate base material by using the laminated body as a mold, there is a tendency for peeling to occur at the interface between the PDMS layer and the metal thin film.

In addition, in fields of a decoration, a home electric appliance, an outer casing of a vehicle, and the like, paint having an iris color, an iridescent color, or a pearl tone may be coated so as to give a design feature to exterior appearance of a coated film.

For example, PTL 1 discloses a laminated body that is formed by depositing a metal on a layer that is formed on a surface of a base material and is formed from a hardened material of a specific paint composition. According to this laminated body, when the metal is deposited on the hardened material layer, a surface layer of a thin-film metal layer formed by the deposition has an irregular shape, and an iris color is expressed.

However, in the laminated body described in PTL 2, it is difficult to sufficiently express the iris color.

Citation List

Patent Literature

[PTL 1] Japanese Patent No. 2991183

[PTL 2] Japanese Unexamined Patent Application, First Publication No. 2007-54827

Non-Patent Literature

[NPL 1] Won Hoe Koo, and six other, "Light extraction from organic light-emitting diodes enhanced by spontaneously formed buckles", Nature Photonics, Volume 4, 2010, p. 222-226

Summary of Invention

Technical Problem

The invention provides a mold in which an undercoat layer and a metal thin film are sequentially formed on a surface of a mold base material, and which has a wrinkle-like fine uneven structure in the surface on a metal thin film side. The mold has excellent adhesiveness at an interface between the undercoat layer and the metal thin film. In addition, the invention provides a method of manufacturing an article having the fine uneven structure in a surface by using the mold, and a use of the article that is obtained by the manufacturing method.

In addition, the invention has been made in consideration of the above-described circumstances, and an object thereof is to provide a surface-emitting body which has high light extraction efficiency and is capable of uniformly irradiating a wide range.

In addition, the invention has been made in consideration of the above-described circumstances, and an object thereof is to provide a laminated body capable of sufficiently expressing an iris color.

Solution to Problem

The invention has the following aspects.

(1) According to an aspect of the invention, a mold having an uneven structure is provided. Surface roughness Ra of the uneven structure and a maximum value Ra' (max) and a minimum value Ra' (min) of line roughness Ra' satisfy the following Expression (1):

$$0.13 \leq (\text{Ra'(max)-Ra'(min)})/\text{Ra} \leq 0.82 \qquad (1).$$

(2) In the mold according to (1), in the mold having the uneven structure, aluminum or an alloy thereof may be deposited on a surface of an undercoat layer that is formed on a surface of a base material and is formed from a hardened material of the following composition I or II for forming an undercoat layer.
(composition I for forming an undercoat layer) comprising,
45 to 95% by mass of urethane(meth)acrylate (A),
1 to 50% by mass of a compound (B) having a radically polymerizable double bond (provided that, the urethane (meth)acrylate (A) is excluded), and
0.1 to 15% by mass of a photopolymerization initiator (C).
(composition II for forming an undercoat layer) comprising,
25 to 90% by mass of urethane(meth)acrylate (A),
1 to 50% by mass of a compound (B) having a radically polymerizable double bond (provided that, the urethane (meth)acrylate (A) is excluded),
0.1 to 15% by mass of a photopolymerization initiator (C), and
1 to 60% by mass of fine particles (D).
(3) According to another aspect of the invention, a light extraction substrate having an uneven structure for a surface-emitting body is provided. Surface roughness Ra of the uneven structure and a maximum value Ra' (max) and a minimum value Ra'(min) of line roughness Ra' satisfy the following Expression (1),

$$0.13 \leq (\text{Ra'(max)-Ra'(min)})/\text{Ra} \leq 0.82 \qquad (1)$$

(4) In the light extraction substrate for a surface-emitting body according to (3), the extraction substrate for a surface-emitting body may include a transparent base material and a layer having an uneven structure.
(5) In the light extraction substrate for a surface-emitting body according to (3) or (4), the uneven structure may be obtained by transferring concavity and convexity of the mold according to (1) or (2).
(6) In the light extraction substrate for a surface-emitting body according to (4), the layer having the uneven structure may include an undercoat layer formed from a hardened material of the following composition I or II for forming an undercoat layer, and a metal layer that is formed by depositing aluminum on the undercoat layer.
(composition I for forming an undercoat layer) comprising,
45 to 95% by mass of urethane(meth)acrylate (1A),
1 to 50% by mass of a compound (1B) having a radically polymerizable double bond (provided that, the urethane (meth)acrylate (1A) is excluded), and
0.1 to 15% by mass of a photopolymerization initiator (1C).
(composition II for forming an undercoat layer) comprising,
25 to 90% by mass of urethane(meth)acrylate (2A),
1 to 50% by mass of a compound (2B) having a radically polymerizable double bond (provided that, the urethane (meth)acrylate (2A) is excluded),
0.1 to 15% by mass of a photopolymerization initiator (2C), and
1 to 60% by mass of fine particles (2D).
(7) According to still another aspect of the invention, a light extraction substrate for a surface-emitting body is provided. The uneven structure of the light extraction substrate for a surface-emitting body according to any one of (3) to (6) is buried with and is flattened by a film in which a difference in a refractive index with the light extraction substrate for a surface-emitting body is higher by 0.1 or more.
(8) According to still another aspect of the invention, a surface-emitting body is provided, including: the light extraction substrate for a surface-emitting body according to any one of (3) to (7); a transparent electrode that is provided on a surface of the light extraction substrate for a surface-emitting body; a rear surface electrode that is provided to be spaced from the transparent electrode and is constituted by a metal thin film; and a light-emitting layer that is provided between the transparent electrode and the rear surface electrode.

(9) According to still another aspect of the invention, a protective plate for a solar cell is provided. The protective plate includes the light extraction substrate for a surface-emitting body according to any one of (3) to (7).

(10) According to still another aspect of the invention, a thin film solar cell is provided, including: the light extraction substrate for a surface-emitting body according to any one of (3) to (7); and a thin film solar cell element that is provided on a surface of the light extraction substrate for a surface-emitting body. The thin film solar cell element is provided to the light extraction substrate for a surface-emitting body on a side at which concavity and convexity are provided.

When being used as a substrate for a solar cell, the light extraction substrate for a surface-emitting body in this specification may be referred to as a fine uneven substrate.

The mold having the fine uneven structure in a surface according to the invention is formed by depositing aluminum or an alloy thereof on the surface of the undercoat layer that is formed on the surface of the mold base material and is formed from the hardened material of the following composition I or II for forming an undercoat layer.

(composition I for forming an undercoat layer) comprising,

45 to 95% by mass of urethane(meth)acrylate (A), 1 to 50% by mass of a compound (B) having a radically polymerizable double bond (provided that, the urethane(meth)acrylate (A) is excluded), and 0.1 to 15% by mass of a photopolymerization initiator (C).

In a method of manufacturing an article of having the fine uneven structure in a surface according to the invention, the mold having the fine uneven structure in a surface according to the invention is used, and an article having a fine uneven structure that is inverted from the fine uneven structure of the mold may be obtained. Examples of the article include a light extraction substrate for a surface-emitting body and the like.

The surface-emitting body of the invention is a surface-emitting body including a transparent base material, a transparent electrode that is provided on a surface of the transparent base material, a rear surface electrode that is provided to be spaced from the transparent electrode and is constituted by a metal thin film, and a light-emitting layer that is provided between the transparent electrode and the rear surface electrode. The transparent base material is an article that is obtained by the manufacturing method of the invention and has the fine uneven structure in a surface. The transparent electrode, the light-emitting layer, and the rear surface electrode are provided to the article on a surface side at which the fine uneven structure is provided.

The protective plate for a solar cell of the invention is a protective plate for a solar cell, which includes the transparent base material. The transparent base material is an article that is obtained by the manufacturing method of the invention and has the fine uneven structure in a surface. In addition, the protective plate may be obtained by adhering the article, which is obtained by the manufacturing method of the invention and has the fine uneven structure in a surface, to a surface of a base material main body.

The thin film solar cell of the invention is a thin film solar cell including a transparent base material, and a thin film solar cell element that is provided on a surface of the transparent base material. The transparent base material is an article that is obtained by the manufacturing method of the invention and has the fine uneven structure in a surface. In addition, the transparent base material may be obtained by adhering the article, which is obtained by the manufacturing method of the invention and has the fine uneven structure in a surface, to a surface of a base material main body. The thin film solar cell element is provided to the article on a surface side at which the fine uneven structure is provided.

The surface-emitting body of the invention is a surface-emitting body including a transparent base material having an uneven structure in a surface, a transparent electrode that is provided on a surface of the transparent base material, a rear surface electrode that is provided to be spaced from the transparent electrode and is constituted by a metal thin film, and a light-emitting layer that is provided between the transparent electrode and the rear surface electrode. The transparent base material include a transparent supporting body, an undercoat layer that is formed on a surface of the transparent supporting body and is formed from a hardened material of a composition for forming an undercoat layer, and a metal layer that is formed by depositing aluminum on the undercoat layer. The composition for forming an undercoat layer contains urethane (meth)acrylate (A) that is a reaction product between polyesterdiol obtained by causing (poly) alkylene glycol and adipic acid to react with each other, a diisocyanate compound, and hydroxyl group-containing (meth) acrylic acid ester; a compound (B) having one or more radically polymerizable double bonds in a molecule (provided that, the urethane(meth)acrylate (A) is excluded); and a photopolymerization initiator (C). The transparent electrode, the light-emitting layer, and the rear surface electrode are provided to the transparent base material on a surface side at which the uneven structure is provided.

In addition, the present inventors made a thorough investigation, and as a result, they found that the iris color is clearly expressed by making an uneven structure (buckling structure) of the metal layer deposited on the hardened material layer fine.

In addition, they found that a buckling structure may be controlled by making fine particles be contained in the hardened material layer, and they accomplished the invention.

That is, a laminated body of the invention is a laminated body having an uneven structure in a surface. The laminated body includes a base material, an undercoat layer that is formed on a surface of the base material and is formed from a hardened material of a composition for forming an undercoat layer, and a metal layer formed by depositing aluminum on the undercoat layer. The composition for forming an undercoat layer contains urethane (meth)acrylate (A) that is a reaction product between polyesterdiol obtained by causing (poly)alkylene glycol and adipic acid to react with each other, a diisocyanate compound, and hydroxyl group-containing (meth)acrylic acid ester; a compound (B) having one or more radically polymerizable double bonds in a molecule (provided that, the urethane(meth)acrylate (A) is excluded); a photopolymerization initiator (C); and fine particles (D).

Advantageous Effects of Invention

The mold having the fine uneven structure in a surface according to the invention is a mold in which the undercoat layer and the metal thin film are sequentially formed on the surface of the mold base material, and which has the wrinkle-like fine uneven structure in the surface on a metal thin film side. The mold has excellent adhesiveness at an interface between the undercoat layer and the metal thin film.

According to the method of manufacturing an article, which has the fine uneven structure in a surface, of the invention, an article having the fine uneven structure in a surface may be stably manufactured.

The surface-emitting body of the invention has higher light extraction efficiency compared to a surface-emitting body in the related art, and is capable of uniformly irradiating over a wide range.

According to the protective plate for a solar cell of the invention, a solar cell having high conversion efficiency may be obtained.

The thin film solar cell of the invention has high conversion efficiency.

In addition, the surface-emitting body of the invention has high light extraction efficiency and is capable of uniformly irradiating over a wide range.

In addition, the laminated body of the invention may sufficiently express an iris color.

Brief Description of Drawings

FIG. 1 is a cross-sectional diagram illustrating an example of a mold having a fine uneven structure in a surface according to the invention.

FIG. 2 is a scanning electron micrograph of the surface of the mold having the fine uneven structure in the surface according to the invention.

FIG. 3 is a cross-sectional diagram illustrating a manufacturing process of an article having the fine uneven structure in a surface.

FIG. 4 is a cross-sectional diagram illustrating an example of a surface-emitting body of the invention.

FIG. 5 is a cross-sectional diagram illustrating an example of a protective plate for a solar cell of the invention.

FIG. 6 is a cross-sectional diagram illustrating an example of a pn-junction type solar cell using the protective plate for a solar cell of the invention.

FIG. 7 is a cross-sectional diagram illustrating an example of a thin film solar cell of the invention.

FIG. 8 is a cross-sectional diagram illustrating an example of the surface-emitting body having the uneven structure in a surface according to the invention.

FIG. 9 is an atomic force microscope image of a surface of a transparent base material provided to the surface-emitting body having the uneven structure in a surface according to the invention.

FIG. 10 is a cross-sectional diagram illustrating an example of a laminated body of the invention.

FIG. 11 is a cross-sectional diagram illustrating an example of a manufacturing process of the laminated body of the invention.

FIG. 12 is an atomic force microscope image of a laminated body that is obtained in Example C1.

FIG. 13 is an atomic force microscope image of a laminated body that is obtained in Example C2.

FIG. 14 is an atomic force microscope image of a laminated body that is obtained in Comparative Example C1.

FIG. 15 is a diagram illustrating an element configuration of a device A of the invention.

FIG. 16 is a diagram illustrating an element configuration of a device B of the invention.

FIG. 17 is a diagram illustrating an element configuration of a device C of the invention.

FIG. 18 is a diagram illustrating an element configuration of a device D of the invention.

FIG. 19 is a diagram illustrating an element configuration of a device E of the invention.

FIG. 20 is a diagram illustrating an element configuration of a device F of the invention.

FIG. 21 is a diagram illustrating an element configuration of a device G of the invention.
FIG. 22 is a diagram illustrating an element configuration of a device H of the invention.
FIG. 23 is a diagram illustrating an element configuration of a device I of the invention.
FIG. 24 is a diagram illustrating an element configuration of a device J of the invention.
FIG. 25 is a diagram illustrating an element configuration of a device K of the invention.
FIG. 26 is an atomic force microscope image of a mold that is obtained in Example 1.
FIG. 27 is an atomic force microscope image of a mold that is obtained in Example 2.
FIG. 28 is an atomic force microscope image of a mold that is obtained in Example 3.
FIG. 29 is an atomic force microscope image of a mold that is obtained in Example 4.
FIG. 30 is an atomic force microscope image of a mold that is obtained in Example 5.
FIG. 31 is an atomic force microscope image of a mold that is obtained in Example 6.
FIG. 32 is an atomic force microscope image of a mold that is obtained in Example 7.
FIG. 33 is an atomic force microscope image of a mold that is obtained in Example 8.
FIG. 34 is an atomic force microscope image of a mold that is obtained in Example 9.
FIG. 35 is an atomic force microscope image of a mold that is obtained in Example 10.
FIG. 36 is an atomic force microscope image of a mold that is obtained in Example 11.
FIG. 37 is an atomic force microscope image of a mold that is obtained in Example 12.
FIG. 38 is an atomic force microscope image of a mold that is obtained in Comparative Example 4.
FIG. 39 is a diagram illustrating an element configuration of a device X of the invention.
FIG. 40 is an atomic force microscope image of a mold that is obtained in Comparative Example 3.

Description of Embodiments

In this specification, "transparent" means "capable of transmitting visible light (having a light-transmitting property)". In addition, active energy rays means visible rays, ultraviolet rays, electron rays, plasma, heat rays (infrared rays), and the like.
In addition, "(poly)alkylene glycol" means both polyalkylene glycol and alkylene glycol. In addition, in a case in which another term, for example, "acrylate" is subsequent to "(meth)", this case means both acrylate and methacrylate, and in a case in which for example, "acrylic acid" is subsequent thereto, this case means both acrylic acid and methacrylic acid.
In this specification, "fine uneven structure" and "uneven structure" have the same meaning.

<Mold Having Fine Uneven structure in Surface>

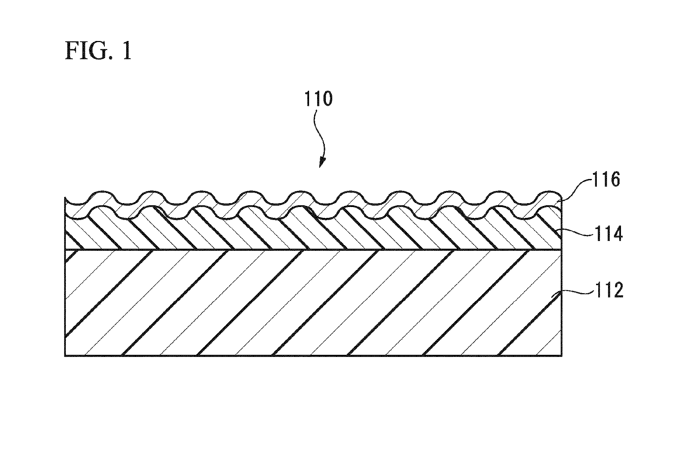

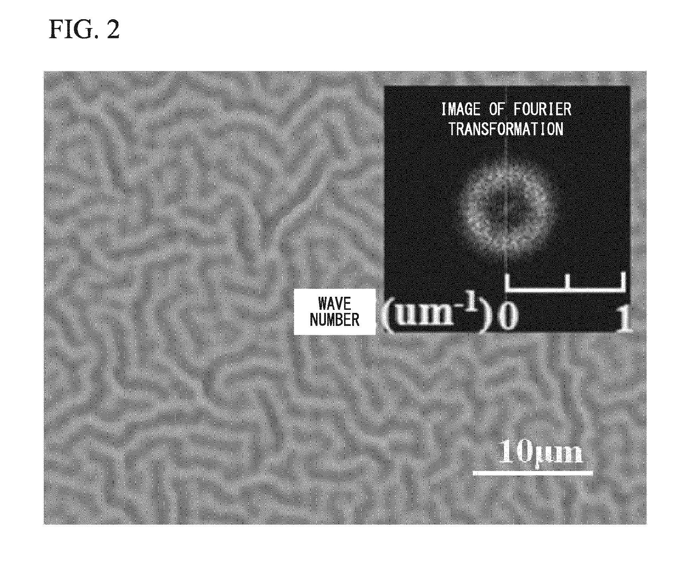

FIG. 1 shows a cross-sectional diagram illustrating an example of a mold having a fine uneven structure in a surface (hereinafter, simply referred to as a mold) according to the invention.
A mold 110 is a laminated body including a mold base material 112, an undercoat layer 114 formed on a surface of the mold base material 112, and a metal thin film 116 formed on a surface of the undercoat layer 114.
In the mold 110, aluminum or an alloy thereof is deposited on a surface of the undercoat layer 114 that is formed on a surface of the mold base material 112 and is formed from a hardened material of a composition for forming an undercoat layer to be described later to form the metal thin film 116.
In the mold 110, when aluminum or an alloy thereof is deposited on the surface of the undercoat layer 114, the buckling phenomenon described in NPL 1 occurs, and thus as shown in a scanning electron micrograph of FIG. 2, a wrinkle-like fine uneven structure is formed in the surface of the undercoat layer 114 and in the metal thin film 116.

(Mold base Material)

Examples of a type of the mold base material 112 include a film, a sheet, a plate, and the like.
Examples of a material of the mold base material 112 include polyester (such as polyethylene terephthalate and polybutylene terephthalate), an acrylic resin (such as polymethylmethacrylate), polycarbonate, polyvinyl chloride, styrene-based resin (ABS resin), a cellulose-based resin (such as triacetyl cellulose), glass, silicon, metal, and the like.

(Undercoat Layer)

The undercoat layer 114 is a layer formed from a hardened material of a composition for forming an undercoat layer to be described later.
From the viewpoint that a buckling phenomenon easily occurs, the thickness of the undercoat layer 114 is preferably 1 to 40 $\mu$m.

(Metal Thin Film)

The metal thin film 116 is a layer formed by deposition of aluminum or an alloy thereof.
From the viewpoint that the buckling phenomenon easily occurs, the thickness of the metal thin film 116 is preferably 1 to 1,000 nm.

(Fine Uneven structure)

The wrinkle-like fine uneven structure formed in the surface of the undercoat layer 114 and in the metal thin film 116 has a wide uneven period distribution, and concavity and convexity extend in an irregular direction.
The phenomenon in which the fine uneven structure has the wide uneven period distribution and concavity and convexity extend in an irregular direction may be confirmed by a fact in which a power spectrum peak obtained by Fourier-transforming an atomic force microscope or a scanning electron micrograph on the surface of the mold 110 enters a ring state having a wide width.

The mold having the uneven structure according to the invention is a mold in which surface roughness Ra of the uneven structure and a maximum value Ra'(max) and a minimum value Ra'(min) of line roughness Ra' satisfy the following Expression (1).

$$0.13 \leq (Ra'(max)-Ra'(min))/Ra \leq 0.82 \qquad (1)$$

In addition, the line roughness Ra' is a value measured according to JIS B0601-1994, and the numerator in Expression (1) is a difference between the maximum value (max) and the minimum value (min) of arithmetic average roughness in a case where a measurement direction is changed and the line roughness Ra' is measured. Therefore, in a case where the regularity is not present in the uneven structure, since the line roughness according to a direction is not different, the difference decreases, and thus a value of Expression (1) obtained by dividing the difference by the surface roughness Ra decreases and closes to 0 in a case of a random uneven structure. Conversely, in a case where the regularity is present in the uneven structure, the line roughness according to a direction is different, and thus the difference (the numerator of Expression (1)) increases.
That is, a state in which the value of the Expression (1) is 0.13 to 0.82 means that the uneven structure is neither a random structure nor a regular structure, and is an intermediate structure, that is, a structure having appropriate regularity.

From the viewpoint of light diffraction efficiency in a final article having the fine uneven structure in a surface, an average period of convexities (or concavities) in the fine uneven structure is preferably 10 to 10,000 nm, and more preferably 200 to 5,000 nm.
The average period of the convexities (or concavities) may be obtained from an image of Fourier transformation of an image measured by the atomic force microscope or scanning electron microscope.

From the viewpoint of sufficiently increasing light extraction efficiency of a surface-emitting body to be described later, arithmetic average height (roughness) (Rz) of the convexities (or concavities) in the fine uneven structure is preferably 10 to 1,000 nm, and more preferably 50 to 700 nm.
The arithmetic average height (roughness) (Rz) of the convexities (or concavities) is calculated according to the JIS standard from a numerical value measured by the atomic force microscope.

(Method of Manufacturing Mold)

For example, the mold 110 is manufactured by a method including the following processes (I) to (IV).

(I) A process of forming the undercoat layer 114 formed from a hardened material of a composition for forming an undercoat layer to be described later on a surface of the mold base material 112.
(II) A process of depositing aluminum or an alloy thereof on a surface of the undercoat layer 114 to form a metal thin film 116 formed from aluminum or an alloy thereof.
(III) A process of cooling the undercoat layer 114 and the metal thin film 116 to form a wrinkle-like fine uneven structure.
(IV) A process of repeating transferring of the wrinkle-like fine uneven structure to an undercoat layer 114 of a separate mold base material 112 and deposition of the aluminum or the alloy thereof to the undercoat layer 114 of the separate mold base material 112 to make the fine uneven structure have a high aspect ratio similarly to the above-described NPL 1 as necessary.

Process (I)

For example, the undercoat layer 114 is formed by applying a composition for forming an undercoat layer to be described later on a surface of the mold base material 112 and by curing the composition through irradiation of active energy rays.

Examples of an application method include brush coating, spray coating, dip coating, spin coating, flow coating, and the like. From the viewpoints of application workability, flatness of a coated film, and homogeneity, the spray coating method or the flow coating method is preferable.

In a case where the composition for forming an undercoat layer contains an organic solvent, the organic solvent is volatilized by heating the coated film before the curing. A heating temperature is preferably 40 to 130°C, and more preferably 60 to 130°C. A heating time is preferably 1 to 20 minutes, and more preferably 3 to 20 minutes. Examples of heating means include an IR heater, worm wind, and the like.

Examples of the active energy rays include ultraviolet rays, electron rays, and the like. In a case of using a high-pressure mercury lamp, an energy amount of ultraviolet rays is preferably 500 to 4,000 $mJ/cm^2$.

Process (II)

Examples of a deposition method include physical deposition methods such as a vacuum deposition method, a sputtering method, and an ion plating method, and the vacuum deposition method is preferable from the viewpoint that the buckling phenomenon easily occurs.

In the process (II), aluminum or an alloy thereof is deposited on the surface of the undercoat layer 114 in a state in which the surface of the undercoat layer 114 is expanded due to heat during the deposition.

Process (III)

Commonly, the cooling is performed in the air and at room temperature.

When the undercoat layer 114 and the metal thin film 116 are cooled, shrinkage occurs in the surface of the undercoat layer 114. On the other hand, since shrinkage of the metal thin film 116 occurs less, the wrinkle-like fine uneven structure is formed in the surface of the undercoat layer 114 due to a difference in a shrinkage rate between the undercoat layer 114 and the metal thin film 116 (buckling phenomenon). At this time, the metal thin film 116 also conforms to the deformation of the surface of the undercoat layer 114, and thus a wrinkle-like fine uneven structure, which conforms to the wrinkle-like fine uneven structure in the surface of the undercoat layer 114, is also formed in the metal thin film 116.

(Composition I for Forming Undercoat Layer)

The composition for forming an undercoat layer contains 45 to 95% by mass of urethane(meth)acrylate (A), 1 to 50% by mass of a compound (B) having a radically polymerizable double bond (provided that, the urethane(meth) acrylate (A) is excluded), and 0.1 to 15% by mass of a photopolymerization initiator (C).

(Urethane (meth)acrylate (A))

The urethane (meth)acrylate (A) is obtained by reacting a polyol with a polyisocyanate and a hydroxyl group-containing (meth)acrylate.

From the viewpoint of easy occurrence of the buckling phenomenon described above, the urethane (meth) acrylate (A) is preferably obtained by reacting polyesterdiol obtained from (poly)alkyleneglycol (a1) and adipic acid (a2) with a diisocyanate compound (a3) and hydroxyl group-containing (meth)acrylate (a4).

The (poly)alkyleneglycol (a1) is a collective term for polyalkyleneglycol and alkyleneglycol.

Examples of the (poly)alkyleneglycol (a1) include ethyleneglycol, polyethyleneglycol, propyleneglycol, polypropyleneglycol, tetramethyleneglycol, polytetramethyleneglycol, and the like. The (poly)alkyleneglycols (a1) may be used alone or in combination of two or more kinds.

From the viewpoint of lower viscosity of a composition for forming an undercoat layer, as the (poly)alkyleneglycol (a1), ethyleneglycol, propyleneglycol, and tetramethyleneglycol are preferable.

Examples of the diisocyanate compound (a3) include tolylenediisocyanate, xylenediisocyanate, isophoronediisocyanate, tetramethylxylylenediisocyanate, and the like. The diisocyanate compounds (a3) may be used alone or in combination of two or more kinds.

From the viewpoints of high reactivity in synthesis, low price, and commercial availability, as the diisocyanate compound (a3), tolylenediisocyanate is preferable.

The hydroxyl group-containing (meth)acrylate (a4) has at least one (meth)acryloyloxy group and at least one hydroxyl group in a molecule.

Examples of the hydroxyl group-containing (meth)acrylate (a4) include 2-hydroxyethyl (meth)acrylate, 2-hydroxypropyl (meth)acrylate, 3-hydroxypropyl (meth)acrylate, 3-hydroxybutyl (meth)acrylate, 4-hydroxybutyl (meth)acrylate, 5-hydroxypentyl (meth)acrylate, 6-hydroxyhexyl (meth)acrylate, cyclohexanedimethanol mono(meth)acrylate, an adduct of 2-hydroxyethyl (meth)acrylate and caprolactone, an adduct of 4-hydroxybutyl (meth)acrylate and caprolactone, trimethylolpropanediacrylate, pentaerythritoltriacrylate, dipentaerythritolpentacrylate, and the like. The hydroxyl group-containing (meth)acrylates (1a4) may be used alone or in combination of two more kinds.

From the viewpoint of lower viscosity of a composition for forming a undercoat layer, as the hydroxyl group-containing (meth)acrylate (a4), 2-hydroxyethyl (meth)acrylate, 2-hydroxypropyl (meth)acrylate, 3-hydroxypropyl (meth)acrylate, 3-hydroxybutyl (meth)acrylate, and 4-hydroxybutyl (meth)acrylate are preferable.

For example, the urethane (meth)acrylate (A) is prepared as described below.

The (poly)alkyleneglycol (a1) is caused to react with the adipic acid (a2) at approximately 200°C, and then dehydration condensation are performed to obtain polyesterdiol. The diisocyanate compound (a3) is added dropwise to the mixture of the polyesterdiol and a catalyst (di-n-butyltin dilaurate or the like) at 50°C to 90°C to react with each other, whereby a urethane prepolymer is obtained. The urethane prepolymer is caused to react with the hydroxyl group-containing (meth)acrylate (a4). The diisocyanate compound (a3) and the hydroxyl group-containing (meth)acrylate (a4) are caused to react with each other, and then the resultant mixture may be caused to react with the polyesterdiol obtained from the (poly)alkyleneglycol (a1) and the adipic acid (a2).

From the viewpoint of lower viscosity of a composition for forming an undercoat layer, a number average molecular weight of the urethane (meth)acrylate (A) is preferably 4000 to 6000.

The urethane (meth)acrylates (A) may be used alone or in combination of two or more kinds.

The ratio of the urethane (meth)acrylate (A) is 45 to 95% by mass, and preferably 55 to 65% by mass on the basis of the composition for forming a undercoat layer (100% by mass). When the ratio of the urethane (meth)acrylate (A) is within this range, adhesiveness at an interface between the undercoat layer and a metal thin film becomes excellent, and the buckling phenomenon described above easily occurs.

(Compound (B) Having Radically Polymerizable Double Bond)

The compound (B) having a radically polymerizable double bond is a compound having one or more radically polymerizable double bonds in a molecule (provided that the urethane (meth)acrylate (A) is excluded).

Examples of the compound (B) having a radically polymerizable double bond include the following compounds. hexafunctional (meth)acrylates (dipentaerythritol hexa(meth)acrylate, caprolactone modified dipentaerythritol hexa (meth)acrylate, and the like),

pentafuctional (meth)acrylates (dipentaerythritol hydroxypenta(meth)acrylate, caprolactone modified dipentaerythritol hydroxypenta(meth)acrylate, and the like),

tetrafunctional (meth)acrylates (ditrimethylol propane tetra(meth)acrylate, pentaerythritol tetra(meth)acrylate, pentaerythritol ethoxy-modified tetra(meth)acrylate, and the like),

trifunctional (meth)acrylates (trimethylolpropane tri(meth)acrylate, trisethoxylated trimethylolpropane tri(meth)acrylate, pentaerythritol tri(meth)acrylate, ethoxylated pentaerythritol tri(meth)acrylate, tris(2-acryloloxyethyl) isocyanurate, aliphatic hydrocarbon (having 2 to 5 carbon atoms) modified trimethylolpropane triacrylate, and the like),

di(meth)acrylates (ethyleneglycol di(meth)acrylate, 1,3-butyleneglycol di(meth)acrylate, 1,4-butanediol di(meth)acrylate, 1,6-hexanediol di(meth)acrylate, nonanediol di(meth)acrylate, neopentylglycol di(meth)acrylate, methylheptanediol di(meth)acrylate, diethylheptanediol di(meth)acrylate, neopentylglycol hydroxypivalate di(meth)acrylate, tetraethyleneglycol di(meth)acrylate, tripropyleneglycol di(meth)acrylate, polybutyleneglycol di(meth)acrylate, tricyclodecanedimethanol di(meth)acrylate, bis(2-acryloyloxyethyl)-2-hydroxyethyl isocyanurate, cyclohexanedimethanol di (meth)acrylate, polyethoxylated cyclohexanedimethanol di(meth)acrylate, polypropxylated cyclohexanedimethanol di (meth)acrylate, polyethoxylated bisphenol A di(meth)acrylate, polypropxylated bisphenol A di(meth)acrylate, hydrogenated bisphenol A di(meth)acrylate, polyethoxylated hydrogenated bisphenol A di(meth)acrylate, polypropxylated hydrogenated bisphenol A di(meth)acrylate, bisphenoxyfluorene ethanol di(meth)acrylate, neopentylglycol modified trimethylolpropane di(meth)acrylate, di(meth)acrylate of ε-caprolactone adduct (in a case where each of the addition mole numbers is designated n and m, n+m = 2 to 5) of neopentylglycol hydroxypivalate, di(meth)acrylate of γ-butyrolactone adduct (n+m = 2 to 5) of neopentylglycol hydroxypivalate, di(meth)acrylate of caprolactone adduct (n+m = 2 to 5) of neopentylglycol, di(meth)acrylate of caprolactone adduct (n+m = 2 to 5) of butyleneglycol, di(meth)acrylate of caprolactone adduct (n+m = 2 to 5) of cyclohexanedimethanol, di(meth)acrylate of caprolactone adduct (n+m = 2 to 5) of dicyclopentanediol, di(meth)acrylate of caprolactone adduct (n+m = 2 to 5) of bisphenol A, di(meth)acrylate of caprolactone adduct (n+m = 2 to 5) of hydrogenated bisphenol A, di(meth)acrylate of caprolactone adduct (n+m = 2 to 5) of bisphenol F and the like),

mono(meth)acrylates (2-hydroxyethyl (meth)acrylate, 2-hydroxypropyl (meth)acrylate, 4-hydroxybutyl (meth)acrylate, tetrahydrofurfuryl (meth)acrylate, phenoxyethyl (meth)acrylate, cyclohexyl (meth)acrylate, isobornyl (meth) acrylate, norbornyl (meth)acrylate, 2- (meth)acryloyloxymethyl-2-methylbicycloheptane, adamantyl (meth)acrylate, benzyl (meth)acrylate, phenyl (meth)acrylate, dicyclopentenyl (meth)acrylate, dicyclopentanyl (meth)acrylate, tetracyclododecanyl (meth)acrylate, cyclohexanedimethanol mono(meth)acrylate, 2-methoxyethyl (meth)acrylate, 3-methoxybutyl (meth)acrylate, methoxytriethyleneglycol (meth)acrylate, butoxyethyl (meth)acrylate, methoxydipropyleneglycol (meth) acrylate, 4-acryloyloxymethyl-2-methyl-2-ethyl-1,3-dioxoran, 4-acryloyloxymethyl-2-methyl-2-isobutyl-1,3-dioxoran, trimethylolpropane formal (meth)acrylate, ethyleneoxide modified phosphoric acid (meth)acrylate, caprolactone modified phosphoric acid (meth)acrylate, and the like,

acrylamides (acrylamide, N,N-dimethyl acrylamide, N,N-dimethyl methacrylamide, N-methylol acrylamide, N-methoxymethyl acrylamide, N-butoxymethyl acrylamide, N-t-butyl acrylamide, acryloylmorpholine, hydroxyethyl acrylamide, methylenebis acrylamide, and the like),
polyester di(meth)acrylates (obtained by reacting polybasic acid (phthalic acid, succinic acid, hexahydrophthalic acid, tetrahydrophthalic acid, terephthalic acid, azelaic acid, adipic acid, and the like) with polyhydric alcohol (ethyleneglycol, hexanediol, polyethyleneglycol, polytetramethyleneglycol, and the like) and (meth)acrylic acid or a derivative thereof),
epoxy (meth)acrylates (prepared by carrying out dehydration condensation of bisphenols (bisphenol A, bisphenol F, bisphenol S, tetrabromobisphenol A and the like) with epichlorohydrin to obtain a bisphenol type epoxy resin and reacting the bisphenol type epoxy resin with (meth)acrylic acid or a derivative thereof),

urethane di(meth)acrylates (materials obtained by reacting diisocyanate compound (tolylene diisocyanate, isophorone diisocyanate, xylene diisocyanate, dicyclohexylmethane diisocyanate, and the like) with hydroxyl group-containing (meth)acrylate (2-hydroxyethyl (meth)acrylate, 2-hydroxypropyl (meth)acrylate, 4-hydroxybutyl (meth)acrylate, and the like); materials obtained by adding the diisocyanate compound to the hydroxyl group of one or more kind of alcohols (alkanediol, polyetherdiol, polyesterdiol, and spiroglycol compound and reacting the remained isocyanate group with hydroxyl group-containing (meth)acrylate),
vinyl compounds (styrene, $\alpha$-methyl styrene, 2-hydroxyethyl vinylether, diethyleneglycol divinylether, triethyleneglycol divinylether, and the like), and
allyls (diallylphthalate, diallylterephthalate, diallylisophthalate, diethyleneglycoldiallylcarbonate, and the like), and the like. The compounds (B) having a radically polymerizable double bond may be used alone or in combination of two or more kinds.

From the viewpoint of the ease occurrence of the buckling phenomenon, the compounds (B) having a radically polymerizable double bond are preferably (meth)acrylate having three or less (meth)acryloyloxy groups in a molecule (urethane di(meth)acrylate composed of trimethylolpropane tri(meth)acrylate, tetrahydrofurfuryl (meth)acrylate, tolylene diisocyanate, and 2-hydroxypropyl (meth)acrylate), and more preferably (meth)acrylate having two or less (meth)acryloyloxy groups in a molecule (urethane di(meth)acrylate composed of tetrahydrofurfuryl (meth)acrylate, tolylene diisocyanate, and 2-hydroxypropyl (meth)acrylate).

The ratio of the compound (B) having a radically polymerizable double bond is preferably 1 to 50% by mass, and more preferably 30 to 40% by mass on the basis of the composition for forming the undercoat layer (100% by mass). When the ratio of the compound (B) having a radically polymerizable double bond is within this range, adhesiveness at an interface between the undercoat layer and a metal thin film becomes excellent, and the buckling phenomenon easily occurs.

Photopolymerization Initiator (C)

Examples of the photopolymerization initiators (C) include carbonyl compounds (benzoin, benzoinmonomethylether, benzoinisopropylether, benzoinisobutylether, acetone, benzyl, benzophenone, p-methoxybenzophenone, diethoxyacetophenone, benzyldimethylketal, 2,2-diethoxyacetophenone, 1-hydroxycyclohexylphenylketone, methylphenylglyoxylate, ethylphenylglyoxylate, 2-hydroxy-2-methyl-1-phenylpropan-1-on, 2-ethylanthraquinone, and the like), sulfur compounds (tetramethylthiurammonosulfide, tetramethylthiuramdisulfide, and the like), acylphosphineoxide (2,4,6-trimethylbenzoyldiphenylphosphineoxide, and the like), and the like.
The photopolymerization initiators (C) may be used alone or in combination of two or more kinds.
As the photopolymerization initiator (C), benzophenone, and 1-hydroxycyclohexylphenylketone are preferable.

The ratio of the photopolymerization initiator (C) is preferably 0.1 to 15% by mass and more preferably 1 to 10% by mass on the basis of the composition for forming an undercoat layer (100% by mass). When the ratio of the photopolymerization initiator (C) is 0.1% by mass or more, hardenability of the composition for forming an undercoat layer becomes satisfactory. When the ratio of the photopolymerization initiator (C) is 15% by mass or less, the cost reduction may be realized.

(Other Components)

The composition for forming an undercoat layer may contains a photosensitizer, an organic solvent, other additives (a leveling agent, a deforming agent, an anti-settling agent, a lubricant, an abrading agent, a rust prevention agent, an anti-static agent, a photostabilizer, an ultraviolet ray adsorbing agent, a polymerization inhibitor, or the like), a polymer (acrylic resin, an alkyd resin, or the like), and the like within a range not deteriorating a performance as necessary.

Examples of the photosensitizer include photosensitizers such as 4-dimethylaminobenzoic acid methyl, 4-dimethylaminobenzoic acid ethyl, 4-dimethylaminobenzoic acid amyl, and 4-dimethylamino acetophenone that are known in the related art.

Examples of the organic solvent includes a ketone-based compounds (acetone, methyl ethyl ketone, cyclohexanone, and the like), ester-based compounds (methyl acetate, ethyl acetate, butyl acetate, ethyl lactate, methoxy ethyl acetate, and the like), alcohol-based compounds (ethanol, isopropyl alcohol, butanol, and the like), ether-based compounds (diethyl ether, ethylene glycol dimethyl ether, propylene glycol monomethyl ether, diethylene glycol monoethyl ether, diethylene glycol monobutyl ether, dioxane, and the like), aromatic compounds (toluene, xylene, and the like), aliphatic compounds (pentane, hexane, petroleum naphtha, and the like), and the like.

An amount of the organic solvent is preferably 100 to 500 parts by mass on the basis of 100 parts by mass of the compound for forming an undercoat layer.

(Operational Effect)

In the mold 110, since the undercoat layer 14 is formed from a hardened material of the composition for forming an undercoat layer comprising 45 to 95% by mass of urethane(meth)acrylate (A), 1 to 50% by mass of a compound (B) having a radically polymerizable double bond, and 0.1 to 15% by mass of a photopolymerization initiator (C), when aluminum or an alloy thereof is deposited on the surface of the undercoat layer 114, there is a tendency for the undercoat layer 114 to be expanded due to heat during deposition, and there is tendency for the undercoat layer 114 to be shrunk during cooling after the deposition. In addition, a difference in a shrinkage rate between the undercoat layer 114 and the metal thin film 116 increases. Accordingly, the wrinkle-like fine uneven structure is formed in the surface of the undercoat layer 114 and in the metal thin film 16 due to the buckling phenomenon.

In addition, in the mold 110 of the invention, since the undercoat layer 114 is formed from a hardened material of the composition for forming an undercoat layer, which has adhesiveness superior to that of the PDMS in the related art, adhesiveness at the interface between the undercoat layer 114 and the metal thin film 116 is excellent.

<Method of manufacturing Article having Fine Uneven Structure in Surface>

A method of manufacturing an article having the fine uneven structure in a surface (hereinafter, simply referred to as "article") according to the invention is a method in which the mold of the invention is used, and an article having a fine uneven structure that is inverted from the fine uneven structure of the mold in a surface is produced. Examples of the method include a method (so-called optical imprint method) in which an active energy ray-curable resin composition is interposed between the mold and an article main body, and the active energy ray-curable resin composition is irradiated with active energy rays to cure the resin composition, whereby a cured resin layer having a fine uneven structure transferred from the fine uneven structure of the mold on a surface is formed on a surface of the article main body. Then, the article main body in which the cured resin layer is formed on the surface thereof is peeled from the mold.

Specific examples of the method of manufacturing an article according to the optical imprint method include a method including the following processes (a) to (d).

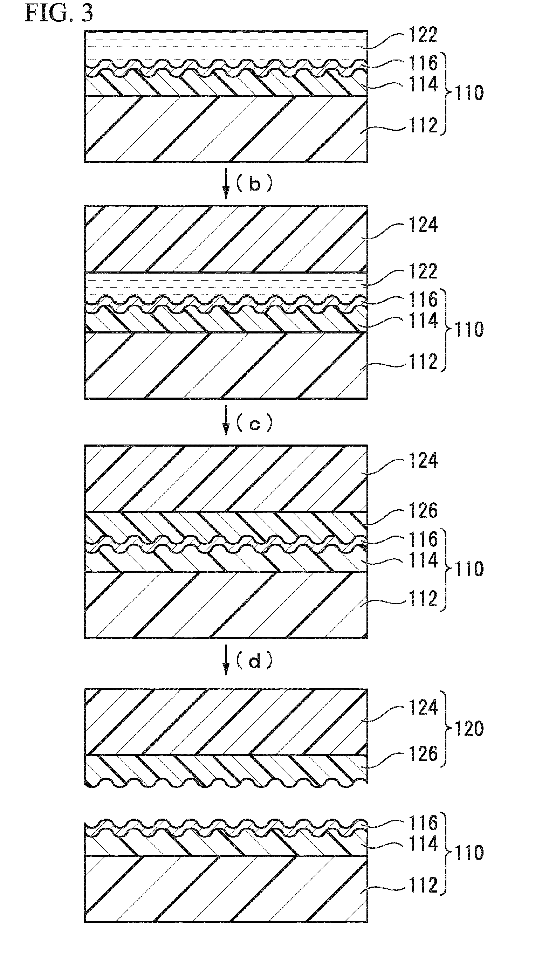

(a) A process of applying an active energy ray-curable resin composition 22 on a surface of the mold 10 on a fine uneven structure side as shown in FIG. 3, the surface being treated with a releasing agent as necessary.

(b) A process of overlapping an article main body 124 on the active energy ray-curable resin composition 22 to interpose the active energy ray-curable resin composition 122 between the mold 110 and the article main body 124 as shown in FIG. 3.

(c) A process of irradiating the active energy ray-curable resin composition 122 with active energy rays to cure the active energy ray-curable resin composition 122 and to form a cured resin layer 126 having a fine uneven structure as shown in FIG. 3.

(d) A process of releasing the mold 110 from the cured resin layer 126 on a surface of the article main body 124 to obtain an article 120 having the fine uneven structure in a surface as shown in FIG. 3.

(Active Energy Ray)

Preferable examples of a light source of the active energy rays include a high-pressure mercury lamp, a metal halide lamp, and the like.

In a case of using these, an energy amount of ultraviolet rays is preferably 100 to 10,000 mJ/cm$^2$.

(Article Main body)

Since irradiation of active energy rays is performed from an upper side of the article main body 124, as a material of the article main body 124, a highly transparent material is preferable. Examples of the material include acryl-based resin, polyethylene terephthalate, polycarbonate, triacetyl cellulose, glass, and the like.

With regard to a shape of the article main body 124, molded products having an arbitrary shape such as a film, a sheet, and a plate, and the like may be exemplified.

(Active Energy Ray-Curable Resin Composition)

The active energy ray-curable resin composition 122 includes a polymerizable compound and a photopolymerization initiator.

Examples of the polymerizable compound include monomers having a radically polymerizable bond and/or a cationically polymerizable bond in a molecule, oligomers, reactive polymers, and the like.

Examples of monomers having a radically polymerizable bond include monofunctional monomers and polyfunctional monomers.

Examples of the monofunctional monomers include (meth)acrylate derivatives (methyl (meth)acrylate, ethyl (meth)acrylate, propyl (meth)acrylate, n-butyl (meth)acrylate, i-butyl (meth)acrylate, s-butyl (meth)acrylate, t-butyl (meth)acrylate, 2-ethylhexyl (meth)acrylate, lauryl (meth)acrylate, alkyl (meth)acrylate, tridecyl (meth)acrylate, stearyl (meth)acrylate, cyclohexyl (meth)acrylate, benzyl (meth)acrylate, phenoxyethyl (meth)acrylate, isobornyl (meth)acrylate, glycidyl (meth)acrylate, tetrahydrofurfuryl (meth)acrylate, allyl (meth)acrylate, 2-hydroxyethyl (meth)acrylate, hydroxypropyl (meth)acrylate, 2-methoxyethyl (meth)acrylate, 2-ethoxyethyl (meth)acrylate, and the like); (meth)acrylic acid; (meth)acrylonitrile; styrene derivatives (styrene, $\alpha$-methyl styrene, and the like); (meth)acrylamide derivatives ((meth)acrylamide, N-dimethyl (meth)acrylamide, N-diethyl (meth)acrylamide, dimethylaminopropyl (meth)acrylamide, and the like); and the like. These compounds may be used alone or in combination of two or more kinds.

Examples of the polyfunctional monomers include difunctional monomers (ethylene glycol di(meth)acrylate, tripropylene glycol di(meth)acrylate, ethylene oxide isocyanurate-modified di(meth)acrylate, triethylene glycol di(meth)acrylate, diethylene glycol di(meth)acrylate, neopentyl glycol di(meth)acrylate, 1,6-hexanediol di(meth)acrylate, 1,5-pentanediol di(meth)acrylate, 1,3-butylene glycol di(meth)acrylate, polybutylene glycol di(meth)acrylate, 2,2-bis(4-(meth)acryloxypolyethoxyphenyl) propane, 2,2-bis (4-(meth)acryloxyethoxyphenyl)propane, 2,2-bis(4-(3-(meth)acryloxy-2-hydroxypropoxy)phenyl) propane, 1,2-bis(3-(meth)acryloxy-2-hydroxypropoxy)ethane, 1,4-bis(3-(meth)acryloxy-2-hydroxypropoxy)butane, dimethyloltricyclodecane di(meth)acrylate, bisphenol A ethylene oxide adduct di(meth)acrylate, bisphenol A propylene oxide adduct di(meth)acrylate, neopentyl glycol hydroxypivalate di(meth)acrylate, divinylbenzene, methylenebisacrylamide, and the like); trifunctional monomers (pentaerythritol tri(meth)acrylate, trimethylolpropane tri(meth)acrylate, trimethylolpropane ethylene oxide-modified tri(meth)acrylate, trimethylolpropane propylene oxide-modified triacrylate, trimethylolpropane ethylene oxide-modified triacrylate, ethylene oxide isocyanurate-modified tri(meth)acrylate, and the like); tetrafunctional or higher monomers (condensation reaction mixtures of succinic acid/trimethylolethane/acrylic acid, dipentaerythritol hexa(meth)acrylate, dipentaerythritol penta(meth)acrylate, ditrimethylolpropane tetraacrylate and tetramethylolmethane tetra(meth)acrylate, and the like); bifunctional or higher urethane acrylates; bifunctional or higher polyester acrylates; and the like. These compounds may be used alone or in combination of two or more kinds.

Examples of monomers having a cationically polymerizable bond include monomers having an epoxy group, an oxetanyl group, an oxazolyl group, a vinyloxy group, and the like, and monomers having an epoxy group are particularly preferable.

Examples of oligomers or reactive polymers include unsaturated polyesters (condensation products of unsaturated dicarboxylic acid and polyhydric alcohol, and the like); polyester (meth)acrylates; polyether (meth)acrylates; polyol (meth)acrylates; epoxy (meth)acrylates; urethane (meth)acrylates, cationically polymerizable epoxy compounds; and homopolymers or copolymers of the above-described monomers having a radically polymerizable bond on a side chain.

In a case of using a photocuring reaction, examples of the photopolymerization initiator include carbonyl compounds (benzoin, benzoin methyl ether, benzoin ethyl ether, benzoin isopropyl ether, benzoin isobutyl ether, benzil, benzophenone, p-methoxybenzophenone, 2,2-diethoxyacetophenone, $\alpha,\alpha$-dimethoxy-$\alpha$-phenylacetophenone, methyl phenylglyoxylate, ethyl phenylglyoxylate, 4,4'-bis(dimethylamino)benzophenone, 2-hydroxy-2-methyl-1-phenylpropan-1-one, and the like); sulfur compounds (tetramethylthiuram monosulfide, tetramethylthiuram disulfide, and the like); 2,4,6-trimethylbenzoyl diphenylphosphine oxide; benzoyl diethoxyphosphine oxide; and the like. These compounds may be used alone or in combination of two or more kinds.

In a case of using an electron ray curing reaction, examples of the polymerization initiator include benzophenone; 4,4-bis(diethylamino)benzophenone; 2,4,6-trimethylbenzophenone, methyl ortho-benzoylbenzoate; 4-phenylbenzophenone; t-butylanthraquinone; 2-ethyl anthraquinone; thioxanthones (2,4-diethylthioxanthone, isopropylthioxanthone, 2,4-dichlorothioxanthone, and the like); acetophenones (diethoxyacetophenone, 2-hydroxy-2-methyl-1-phenylpropan-1-one, benzyl dimethyl ketal, 1-hydroxycyclohexyl phenyl ketone, 2-methyl-2-morpholino(4-thiomethylphenyl)propan-1-one, 2-benzyl-2-dimethylamino-1-(4-morpholinophenyl)butanone, and the like); benzoin ethers (benzoin methyl ether, benzoin ethyl ether, benzoin isopropyl ether, benzoin isobutyl ether, and the like); acylphosphine oxides (2,4,6-trimethylbenzoyl diphenylphosphine oxide, bis(2,6-dimethoxybenzoyl)-2,4,4-trimethylpentylphosphine oxide, bis(2,4,6-trimethylbenzoyl)-phenylphosphine oxide, and the like); methylbenzoyl formate; 1,7-bisacridinylheptane; 9-phenylacridine; and the like. These compounds may be used alone or in combination of two or more kinds.

In a case of using a thermal curing reaction, examples of the thermal polymerization initiator include organic peroxides (methyl ethyl ketone peroxide, benzoyl peroxide, dicumyl peroxide, t-butyl hydroperoxide, cumene hydroperoxide, t-butyl peroxyoctoate, t-butyl peroxybenzoate, lauroyl peroxide, and the like); azo compounds (azobisisobutyronitrile and the like); redox polymerization initiators obtained by combining the above-described organic peroxide with an amine (N,N-dimethylaniline, N,N-dimethyl-p-toluidine, or the like); and the like.

An amount of the polymerization initiator is preferably within a range 0.1 to 10 parts by mass one the basis of 100 parts by mass of the polymerizable compound. When the amount of the polymerization initiator is less than 0.1 parts by mass, it is difficult for the polymerization to proceed. When the amount of the polymerization initiator exceeds 10 parts by mass, the cured film may be colored, or the mechanical strength may deteriorate.

The active energy ray-curable resin composition may also include additives such as unreactive polymers, active energy ray sol-gel reactive compositions, antistatic agents, and fluorine compounds for improving the anti-fouling properties, fine particles, and small amounts of solvents as necessary.

Examples of the unreactive polymers include acrylic resins, styrene-based resins, polyurethanes, cellulose-based resins, polyvinyl butyral, polyesters, thermoplastic elastomers, and the like.
Examples of the active energy ray sol-gel reactive compositions include alkoxysilane compounds, alkyl silicate compounds, and the like.

Examples of the alkoxysilane compounds include tetramethoxysilane, tetra-i-propoxysilane, tetra-n-propoxysilane, tetra-n-butoxysilane, tetra-sec-butoxysilane, tetra-t-butoxysilane, methyltriethoxysilane, methyltripropoxysilane, methyltributoxysilane, dimethyldimethoxysilane, dimethyldiethoxysilane, trimethylethoxysilane, trimethylmethoxysilane, trimethylpropoxysilane, trimethylbutoxysilane, and the like.

Examples of the alkyl silicate compounds include methyl silicate, ethyl silicate, isopropyl silicate, n-propyl silicate, n-butyl silicate, n-pentyl silicate, acetyl silicate, and the like.

(Article)

The article 120 is a laminated body including the article main body 124, and the cured resin layer 126 formed on the surface of the article main body 124.
The cured resin layer 126 is a film formed from a hardened material of the active energy ray-curable resin composition, and has a fine uneven structure converted from the wrinkle-like fine uneven structure in the surface of the mold 110 on a surface thereof.

Examples of a use of the article 120 include an optical film that performs diffraction or scattering of light, a transparent base material of a surface-emitting body, a protective plate for a solar cell, a transparent base material of a thin film solar cell, and the like.

In a case where the article related to the invention is a light extraction substrate for a surface-emitting body, the light extraction substrate for a surface-emitting body is a light extraction substrate having an uneven structure for a surface-emitting body in which surface roughness Ra of the uneven structure and a maximum value Ra' (max) and a minimum value Ra'(min) of line roughness Ra' satisfy the following Expression (1).

$$0.13 \leq (Ra'(max) - Ra'(min))/Ra \leq 0.82 \qquad (1)$$

Furthermore, it is preferable that the light extraction substrate for a surface-emitting body include a transparent base material and a layer having an uneven structure.

Furthermore, it is more preferable that in the light extraction substrate for a surface-emitting body, the uneven structure be obtained by transferring concavity and convexity of the mold described in (1) or (2).

It is still more preferable that in the extraction substrate for a surface-emitting body, the layer having the uneven structure include an undercoat layer formed from a hardened material of the following composition I or II for forming an undercoat layer, and a metal layer that is formed by depositing aluminum on the undercoat layer.

(composition I for forming an undercoat Layer) comprising,

45 to 95% by mass of urethane(meth)acrylate (A),

1 to 50% by mass of a compound (B) having a radically polymerizable double bond (provided that, the urethane(meth) acrylate (A) is excluded), and

0.1 to 15% by mass of a photopolymerization initiator (C).

(composition II for forming an undercoat layer) comprising,

25 to 90% by mass of urethane(meth)acrylate (A),

1 to 50% by mass of a compound (B) having a radically polymerizable double bond (provided that, the urethane(meth) acrylate (A) is excluded),

0.1 to 15% by mass of a photopolymerization initiator (C), and

1 to 60% by mass of fine particles (D).

In addition, it is preferable that the light extraction substrate for a surface-emitting body be buried with and is flattened by a film in which a difference in a refractive index with the light extraction substrate for a surface-emitting body is higher by 0.1 or more.

(Operational Effect)

In the method of manufacturing the article of the invention described above, since the mold having excellent adhesiveness at an interface between the undercoat layer and the metal thin film is used, when transferring the fine uneven structure of the mold, the undercoat layer and the metal thin film are not peeled. As a result, an article having a fine uneven structure in a surface may be stably manufactured.

<Surface-Emitting Body>

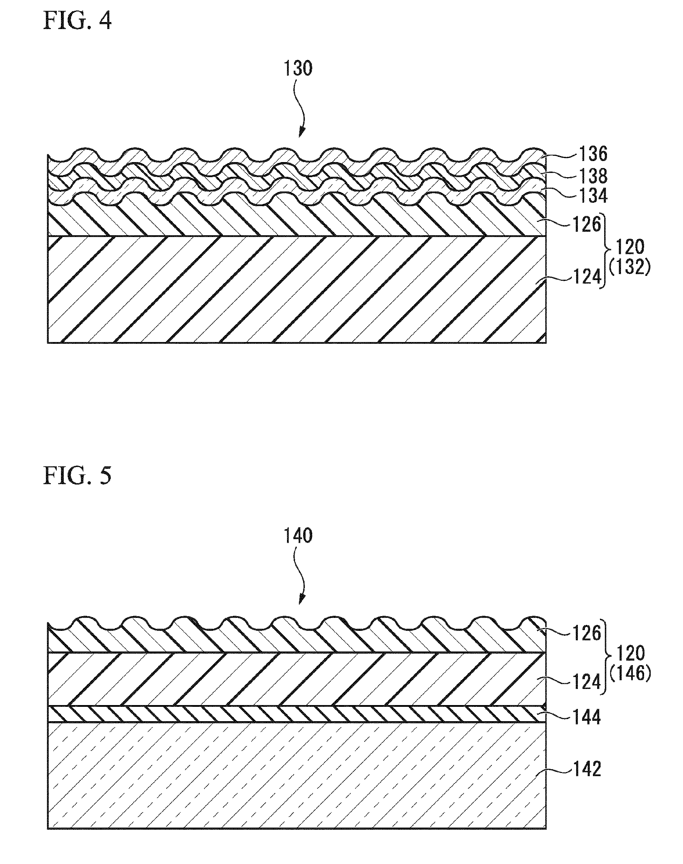

FIG. 4 shows a cross-sectional diagram illustrating an example of a surface-emitting body of the invention. A surface-emitting body 130 includes a transparent base material 132 that is constituted by the article 120 having the wrinkle-like fine uneven structure in a surface, a transparent electrode 134 that is provided to a surface of the transparent base material 132 on a fine uneven structure side, a rear surface electrode 136 that is provided to be spaced from the transparent electrode 134 and is constituted by a metal thin film, and a light-emitting layer 138 that is provided between the transparent electrode 134 and the rear surface electrode 136.

As the surface-emitting body related to the invention, a surface-emitting body, which includes the light extraction substrate for a surface-emitting body of the base material, the transparent electrode that is formed on the surface of the light extraction substrate for a surface-emitting body, the rear surface electrode that is provided to be spaced from the transparent electrode and is constituted by the metal thin film, and the light-emitting layer that is provided between the transparent electrode and the rear surface electrode, is preferable.

With regard to the organic EL element of the invention, the invention may be used to an electroluminescence element of either a bottom emission type or a top emission type. The bottom emission type is an electroluminescence element of a type in which an element is prepared through lamination on a supporting substrate and light is extracted through the supporting substrate, and the top emission type is an electroluminescence element of a type in which an element is prepared from a supporting substrate and light is extracted from a side opposite to the supporting substrate.

(Transparent Substrate)

The transparent base material 132 is the article 120 that is obtained by the method of manufacturing an article according to the invention, and is a laminated body including the article main body 124, and the cured resin layer 126 that is formed on the surface of the article main body 124 and has the wrinkle-like fine uneven structure formed in the surface thereof.

From the viewpoint of sufficiently increasing light extraction efficiency, an average period of convexities (or concavities) in the fine uneven structure is preferably 10 to 10,000 nm, and more preferably 200 to 5,000 nm. From the viewpoint of sufficiently increasing light extraction efficiency of the surface-emitting body 130 provided with the transparent base material 132, an arithmetic average height (roughness) of the convexities (or concavities) in the fine uneven structure is preferably 10 to 1,000 nm, and more preferably 50 to 700 nm.

A difference between a refractive index of the article main body 124 and a refractive index of the cured resin layer 26 is preferably 0.2 or less, more preferably 0.1 or less, and still more preferably 0.05 or less. When the difference in the refractive index is 0.2 or less, reflection at the interface between the article main body 124 and the cured resin layer 126 is suppressed.

(First Electrode)

A first electrode 134 is formed on a surface of the wrinkle-like fine uneven structure of the cured resin layer 126, and thus has substantially the same wrinkle-like fine uneven structure as the wrinkle-like fine uneven structure of the cured resin layer 126.
The first electrode 134 may be either a positive electrode or a negative electrode. Commonly, the first electrode 134 is set as a positive electrode.
As a material of the first electrode 134, a metal oxide having conductivity, a metal capable of forming a metal thin film having a light-transmitting property, an organic polymer having conductivity, or the like are used.
Examples of the metal oxide having conductivity include indium oxide, zinc oxide, tin oxide, indium tin oxide (ITO), indium zinc oxide (IZO), and the like.
Examples of the metal capable of forming the metal thin film having a light-transmitting property include gold, platinum, silver, copper, aluminum, and the like.
Examples of the organic polymer having conductivity include polyaniline, a derivative thereof, polythiophene, PEDOT-PSS (poly(3,4-ethylenedioxythiophene):poly(styrenesulfonate)), a derivative thereof, and the like.
The first electrode 134 may be formed in a single layer or two or more layers.
From the viewpoint of compatibility between a light-transmitting property and conductivity, the thickness of the first electrode 134 is preferably 10 to 1,000 nm, and more preferably 50 to 500 nm.
The thickness of the first electrode 134 is obtained by an apparatus for measuring a step difference, surface roughness, and a fine shape.

(Second Electrode)

A second electrode 136 is formed on a surface of the wrinkle-like fine uneven structure of the light-emitting layer 138, and thus has substantially the same wrinkle-like fine uneven structure as the wrinkle-like fine uneven structure of the light-emitting layer 138.
The second electrode 136 may be either a negative electrode or a positive electrode. Commonly, the second electrode 136 is set as a negative electrode.
Examples of a material of the second electrode 136 include lithium, sodium, potassium, rubidium, cesium, beryllium, magnesium, calcium, strontium, barium, aluminum, scandium, vanadium, zinc, yttrium, indium, cerium, samarium, europium, terbium, ytterbium, and the like. In addition, examples of the material of the second electrode 136 further include alloys obtained by combining two or more of these, metal salts such as fluorides of these, alloys of one or more of these and one or more selected from a group consisting of gold, silver, platinum, copper, manganese, titanium, cobalt, nickel, tungsten, and tin, and the like. Specific examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy, and the like.
The second electrode 136 may be formed in a single layer or two or more layers.
From the viewpoints of conductivity and durability, the thickness of the second electrode 136 is preferably 5 to 1,000 nm, and more preferably 10 to 300 nm.
The thickness of the second electrode 136 is obtained by an apparatus for measuring a step difference, surface roughness, and a fine shape.
The first electrode 134 and the second electrode 136 may be configured to have transparency or reflectivity, respectively, and both of these may be configured to have transparency.

(Light-Emitting Layer)

The light-emitting layer 138 is formed on the surface of the wrinkle-like fine uneven structure of the first electrode 134, and thus has substantially the same wrinkle-like fine uneven structure as the wrinkle-like fine uneven structure of the first electrode 134.
In a case where the surface-emitting body 130 is an organic EL element, the light-emitting layer 138 contains a light-emitting material of an organic compound.
Examples of the light-emitting material of the organic compound include a material (such as CBP:IR(ppy)$_3$) obtained by doping a carbazole derivative (4,4'-N,N'-dicarbazole-diphenyl (CBP) or the like) that is a host compound of a phosphorescent compound with an iridium complex (tris(2-phenyl pyridine) iridium (Ir(ppy)$_3$)); metal complexes (tris(8-hydroxy-quinoline) aluminum (Alq$_3$)) of 8-hydroxyquinoline or a derivative thereof; and light-emitting materials that are known in the related art.

The light-emitting layer 138 may contain a hole transport material, an electron transport material, and the like in addition to the light-emitting material.

The light-emitting layer 138 may be formed in a single layer or two or more layers. For example, in a case of using the surface-emitting body 130 as white organic EL lighting equipment, the light-emitting layer 138 may have a laminated structure including a blue light-emitting layer, a green light-emitting layer, and a red light-emitting layer.

The thickness of the light-emitting layer 138 is preferably 1 to 100 nm, and more preferably 10 to 50 nm.

The thickness of the light-emitting layer 138 is obtained by an apparatus for measuring a step difference, surface roughness, and a fine shape.

(Method of Manufacturing Surface-Emitting Body)

For example, the surface-emitting body 130 is manufactured by a method including the following processes (α) to (γ).

(α) A process of depositing a material of the transparent electrode on a surface of the transparent base material 132 on a fine uneven structure side to form the first electrode 134.
(β) A process of further depositing a material of the light-emitting layer after the process (α) to form the light-emitting layer 138 on a surface of the transparent electrode 134.
(γ) A process of further depositing a metal after the process (β) to form the second electrode 136 constituted by a metal thin film on a surface of the light-emitting layer 38.

Process (α)

Examples of a deposition method include physical deposition methods such as a vacuum deposition method, a sputtering method, and an ion plating method. From the viewpoint of ease of forming the first electrode 134, the sputtering method is preferable.

An UV ozone treatment, a plasma treatment, a corona treatment, or the like may be performed with respect to the surface of the transparent base material 132 before the deposition to improve adhesiveness between the transparent base material 132 and the first electrode 134.

A heating treatment, a vacuum treatment, a heating and vacuum treatment, or the like may be performed with respect to the transparent base material 132 before the deposition so as to remove a dissolved gas and an unreacted monomer that are contained in the transparent base material 132.

Process (β)

Examples of a deposition method include physical deposition methods such as a vacuum deposition method, a sputtering method, and an ion plating method. In a case where the material of the light-emitting layer is an organic compound, the vacuum deposition method is preferable.

An UV ozone treatment, a plasma treatment, a corona treatment, an excimer lamp treatment, or the like may be performed with respect to the surface of the first electrode 134 before the deposition to improve adhesiveness between the first electrode 134 and the light-emitting layer 138.

In a case where a separate functional layer is provided between the light-emitting layer 138 and the first electrode 134 or the second electrode 136, the separate functional layer may be formed before or after forming the light-emitting layer 138 by the same method and conditions as the light-emitting layer 138.

Process (γ)

Examples of a deposition method include physical deposition methods such as a vacuum deposition method, a sputtering method, and an ion plating method, and the vacuum deposition method is preferable from the viewpoint of not causing damage to the organic layer that is a lower layer.

(Operational Effect)

In the surface-emitting body 130 described above, since the transparent base material 132 is the article 120 having the fine uneven structure (that is, the wrinkle-like fine uneven structure), which has the wide uneven period distribution and in which concavity and convexity extend in an irregular direction, on a surface, a deviation in an angle and a wavelength of light, which is effectively diffracted or scattered by the wrinkle-like fine uneven structure, is small.

Accordingly, light extraction efficiency is higher than that of a surface-emitting body in the related art, and a wide range may be uniformly irradiated.

(Other Embodiments)

The surface-emitting body of the invention is not limited to the surface-emitting body 130 of the illustrated example. For example, in the surface-emitting body 130, as a light-emitting material contained in the light-emitting layer, a light-emitting material of an organic compound is exemplified. However, in a case where the surface-emitting body is an inorganic EL element, a light-emitting material of an inorganic compound may be used as the light-emitting material.

In addition, a separate functional layer may be provided between the light-emitting layer and the transparent electrode or the rear surface electrode.

In a case where the surface-emitting body is an organic EL element, as the separate functional layer that is provided between the transparent electrode and the light-emitting layer, a hole injection layer and a hole transport layer may be exemplified in order from the transparent electrode side.

In a case where the surface-emitting body is an organic EL element, as the separate functional layer that is provided between the light-emitting layer and the rear surface electrode, a hole blocking layer, an electron transport layer, and an electron injection layer may be exemplified in order from the light-emitting layer side.

(Hole Injection Layer)

The hole injection layer is a layer comprising a hole injection material.

Example of the hole injection material include copper phthalocyanine (CuPc); vanadium oxide, an organic polymer having conductivity; and other hole injection materials that are known in the related art.

Transition metal-based oxides such as molybdenum oxide and vanadium oxide, copper phthalocyanine (CuPc), an organic polymer having conductivity, and other organic hole injection materials that are known in the related art may be exemplified.

In the case of the transition metal-based oxides, the thickness of the hole injection layer is preferably 2 to 20 nm, and more preferably 3 to 10 nm. In the case of the organic hole injection material, the thickness of the hole injection layer is preferably 1 to 100 nm, and more preferably 10 to 50 nm.

(Hole Transport Layer)

The hole transport layer is a layer comprising a hole transportable material.

Examples of the hole transportable material include triphenyl diamine (such as 4,4'-bis(m-tolyl phenyl amino) biphenyl (TPD)); and other hole transportable materials that are known in the related art.

The thickness of the hole injection layer is preferably 1 to 100 nm, and more preferably 10 to 50 nm.

(Hole-Blocking Layer)

The hole blocking layer is a layer comprising a hole blocking material.

Examples of the hole blocking material include 2,9-dimethyl-4, 7-diphenyl-1, 10-phenanthroline (BCP) and the like; and other hole blocking materials that are known in the related art.

The thickness of the hole injection layer is preferably 1 to 100 nm, and more preferably 5 to 50 nm.

(Electron Transport Layer)

The electron transport layer is a layer comprising an electron transportable material.

Examples of the electron transportable material include a metal complex (such as $Alq_3$) of 8-hydroxyquinoline or a derivative thereof, an oxadiazole derivative, and other electron transportable materials that are known in the related art.

The thickness of the electron transport layer is preferably 1 to 100 nm, and more preferably 10 to 50 nm.

(Electron Injection Layer)

The electron injection layer is a layer comprising an electron injection material.

Examples of the electron injection material include an alkali metal compound (such as lithium fluoride), an alkaline-earth metal compound (such as magnesium fluoride), a metal (such as strontium), and other electron injection materials that are known in the related art.

The thickness of the electron injection layer is preferably 0.1 to 50 nm, and more preferably 0.2 to 10 nm.

The thickness of the separate functional layer is obtained by an apparatus for measuring a step difference, surface roughness, and a fine shape.

<Protective Plate for Solar Cell>

FIG. 5 shows a cross-sectional diagram illustrating an example of a protective plate for a solar cell of the invention. The protective plate 140 for a solar cell includes a base material main body 142, and an optical film 46 that is constituted by the article 120 that is adhered to the base material main body 142 through an adhesive layer 144 and has the wrinkle-like fine uneven structure in a surface thereof.

It is preferable that the protective plate for a solar cell of the invention be constituted by the above-described light extraction substrate for a surface-emitting body.

(Base material main body)

The base material main body 142 is a light transmittable member. Examples of a material of the base material main body 142 include glass, an acrylic resin, polycarbonate, a styrene-based resin, polyester, a cellulose-based resin (such as triacetyl cellulose), polyolefin, alicyclic polyolefin, glass, and the like. The base material main body 142 may be formed from one kind of material, or may be constituted by a laminated body in which respective layers are formed from materials different from each other.

(Adhesive Layer)

Examples of an adhesive of the adhesive layer 144 include a transparent adhesive that is known in the related art, a sticking agent, a double-sided adhesive tape, a sticking tape, and the like.

(Optical Film)

An optical film 146 is the article 120 that is obtained by the method of manufacturing an article according to the invention, and is a laminated body including the article main body 124, and the cured resin layer 126 that is formed on the surface of the article main body 124 and has the wrinkle-like fine uneven structure formed in the surface thereof.

From the viewpoint of effective diffraction or scattering, an average period of convexities (or concavities) in the fine uneven structure is preferably 100 to 10,000 nm, and more preferably 300 to 5,000 nm.

From the viewpoint of sufficiently increasing conversion efficiency of a solar cell, an arithmetic average height (roughness) of the convexities (or concavities) in the fine uneven structure is preferably 50 to 50,000 nm, and more preferably 100 to 2,500 nm.

A difference between a refractive index of the article main body 124 and a refractive index of the cured resin layer 26 is preferably 0.2 or less, more preferably 0.1 or less, and still more preferably 0.05 or less. When the difference in the refractive index is 0.2 or less, reflection at the interface between the article main body 124 and the cured resin layer 126 is suppressed.

(Method of Manufacturing Protective Plate for Solar Cell)

The protective plate 140 for a solar cell is manufactured by adhering the base material main body 142 and an optical film 146 (article 120) through the adhesive layer 144.

(Solar Cell)

The protective plate 140 for a solar cell may be used a cover glass that is provided to a solar cell on an incident light side.

As the solar cell, a pn-junction type solar cell, a dye-sensitization type solar cell, a thin film solar cell, and the like are known, and the protective plate 140 for a solar cell may be used in a solar cell of any type.

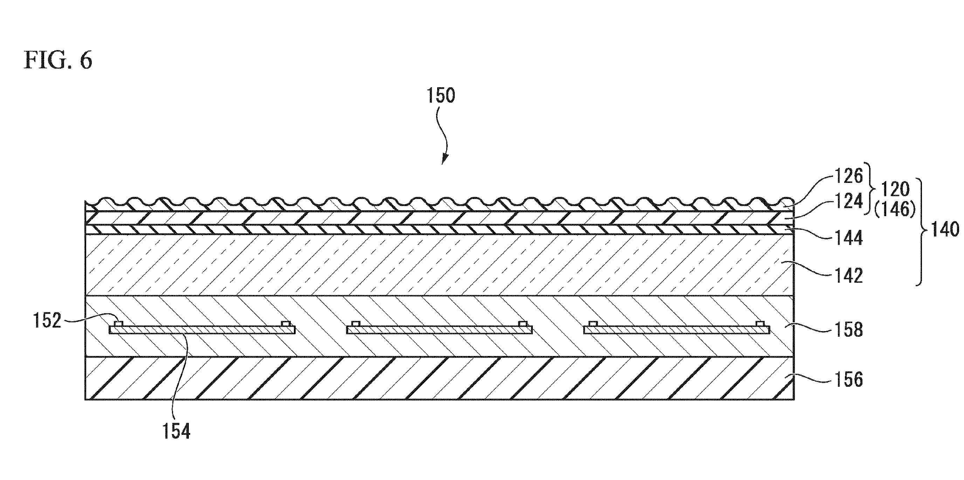

FIG. 6 shows a cross-sectional diagram illustrating an example of the pn-junction type solar cell. A solar cell 150 includes a plurality of solar cell elements 154 that are connected to each other through an interconnector 152, the protective plate 140 for a solar cell that is disposed on a light-receiving surface side of the solar cell elements 154 in such a manner that a surface on a fine uneven structure side becomes a light incidence side, a back seat 156 that is disposed on a side opposite to the light-receiving surface of the solar cell elements 154, a transparent resin layer 158 that adheres the protective plate 140 for a solar cell and the back seat 156 to each other and fixes the solar cell elements 154 therebetween.

Each of the solar cell elements 154 is a pn-junction type solar cell element having a structure in which a p-type semiconductor and an n-type semiconductor are adhered to each other. Examples of the pn-junction type solar cell element include a silicon-based solar cell element, a compound-based solar cell element, and the like.

Examples of a material of the back seat 156 include glass, an acrylic resin, polycarbonate, a styrene-based resin, polyester, a cellulose-based resin (such as triacetyl cellulose), polyolefin, alicyclic polyolefin, and the like.

Examples of a material of the transparent resin layer 158 include polyvinyl butyral, an ethylene-vinyl acetate copolymer, and the like.

(Operational Effect)

In the protective plate 140 for a solar cell described above, since the optical film 146 constituted by the article 120 having the fine uneven structure (that is, the wrinkle-like fine uneven structure) which has the wide uneven period distribution and in which concavity and convexity extend in an irregular direction in a surface is adhered to a light-incidence-side surface of the base material main body 142, a deviation in an angle and a wavelength of incident light, which is effectively diffracted or scattered by the wrinkle-like fine uneven structure, is small. Accordingly, light having a wide range of wavelength is incident to the solar cell element 154, but also light is obliquely incident to the solar cell element 154 due to diffraction or scattering at the protective plate 140 for a solar cell, and thus an optical path length in the solar cell element 154 becomes long. As a result, a solar cell 150 with improved conversion efficiency may be obtained.

(Other Embodiments)

In addition, the protective plate for a solar cell of the invention is not limited to the protective plate 140 for a solar cell of the illustrated example. For example, in a case where the article main body 124 of the article 120 is formed from glass, the article 120 itself may be referred to as a protective plate for a solar cell.

<Thin Film Solar Cell>

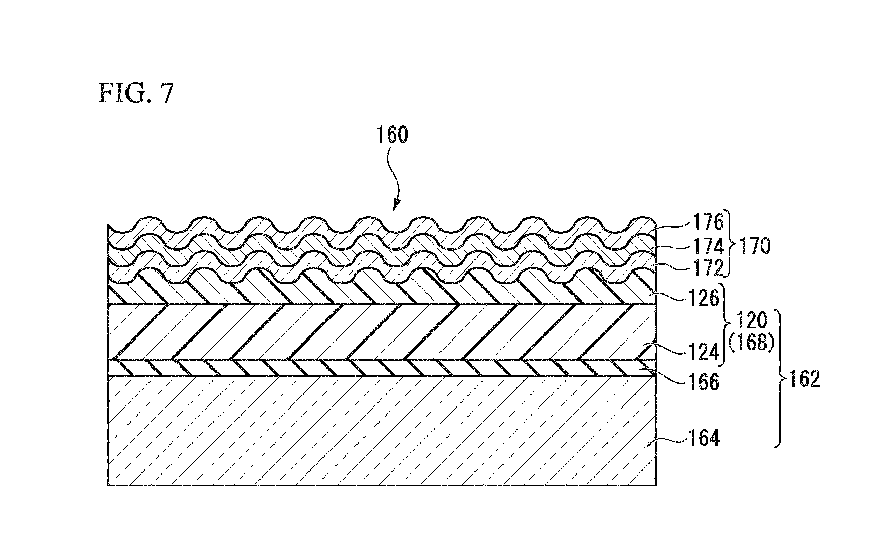

FIG. 7 shows a cross-sectional diagram illustrating an example of a thin film solar cell of the invention. A thin film solar cell 160 includes a transparent base material 162, and a thin film solar cell element 170 that is provided on a surface of the transparent base material 162.

As the thin film solar cell related to the invention, a thin film solar cell, which includes the light extraction substrate for a surface-emitting body, and a thin film solar cell element provided on a surface of the light extraction substrate for a surface-emitting body, and in which the thin film solar cell element is provided to the light extraction substrate for a surface-emitting body on a side at which the concavity and convexity are provided, is preferable.

(Transparent Base Material)

A transparent base material 162 includes a base main body 164, and an optical film 168 constituted by the article 120 that is adhered to the base material main body 164 through an adhesive layer 166 and has the wrinkle-like fine uneven structure in a surface thereof.

(Base material main body)

The base material main body 164 is a light-transmittable member. Examples of a material of the base material main body 164 include glass, an acrylic resin, polycarbonate, a styrene-based resin, polyester, a cellulose-based resin (such as triacetyl cellulose), polyolefin, alicyclic polyolefin, and the like. The base material main body 164 may be formed from one kind of material, or may be constituted by a laminated body in which respective layers are formed from materials different from each other.

(Adhesive Layer)

Examples of an adhesive of the adhesive layer 166 include a transparent adhesive that is known in the related art, a sticking agent, a double-sided adhesive tape, a sticking tape, and the like.

(Optical Film)

An optical film 168 is the article 120 that is obtained by the method of manufacturing an article according to the invention, and is a laminated body including the article main body 124, and the cured resin layer 126 that is formed on the surface of the article main body 124 and has the wrinkle-like fine uneven structure formed in the surface thereof.

From the viewpoint that a deviation in an angle and a wavelength of effectively diffracted or scattered light becomes small, an average period of convexities (or concavities) in the fine uneven structure is preferably 100 to 10,000 nm, and more preferably 300 to 5,000 nm.

From the viewpoint of sufficiently increasing conversion efficiency of a solar cell, an arithmetic average height (roughness) of the convexities (or concavities) in the fine uneven structure is preferably 50 to 50,000 nm, and more preferably 100 to 2,500 nm.

A difference between a refractive index of the article main body 124 and a refractive index of the cured resin layer 26 is preferably 0.2 or less, more preferably 0.1 or less, and still more preferably 0.05 or less. When the difference in the refractive index is 0.2 or less, reflection at the interface between the article main body 124 and the cured resin layer 126 is suppressed.

(Thin Film Solar Cell Element)

A thin film solar cell element 170 is formed on a surface of the wrinkle-like fine uneven structure of the cured resin layer 126 of the optical film 168, and thus has substantially the same wrinkle-like fine uneven structure as the wrinkle-like fine uneven structure of the cured resin layer 26.

The thin film solar cell element 170 includes a transparent electrode layer 72, a photoelectric conversion layer 174, a rear surface electrode layer 176 on a surface of the optical film 168 in this order.

Examples of a material of the transparent electrode layer 172 include indium oxide, zinc oxide, tin oxide, ITO, IZO, IGZO, and the like.

The photoelectric conversion layer 174 is a layer constituted by a thin film semiconductor. Examples of the thin film semiconductor include an amorphous silicon-based semiconductor, a fine crystalline silicon-based semiconductor, a compound semiconductor (such as a chalcopyrite-based semiconductor and a CdTe-based semiconductor), an organic-based semiconductor, and the like.

Examples of a material of the rear surface electrode layer 176 include a metal thin film (such as gold, platinum, silver, copper, and aluminum), a metal oxide having conductivity (such as indium oxide, zinc oxide, tin oxide, ITO, and IZO).

(Operational Effect)

In the thin film solar cell 160 described above, the thin film solar cell element 170 is formed on a surface of the optical film 146 constituted by the article 120 having the fine uneven structure (that is, the wrinkle-like fine uneven structure) which has the wide uneven period distribution and in which concavity and convexity extend in an irregular direction in a surface, effective diffraction or scattering occur by the wrinkle-like fine uneven structure. Accordingly, light having a wide range of wavelength is incident to the thin film solar cell element 170, but also light is obliquely incident to the thin film solar cell element 170 due to diffraction or scattering at the optical film 146, and thus an optical path length in the thin film solar cell element 170 becomes long. As a result, conversion efficiency of the thin film solar cell 160 is improved.

(Other Embodiments)

Furthermore, the thin film solar cell of the invention is not limited to the thin film solar cell 160 of the illustrated example. For example, in a case where the article main body 124 of the article 120 is formed from glass, the base material main body 164 may not be provided.

In addition, a protective resin layer may be provided on a surface of the thin film solar cell element 170, or a back seat may be provided on a surface of the resin layer.

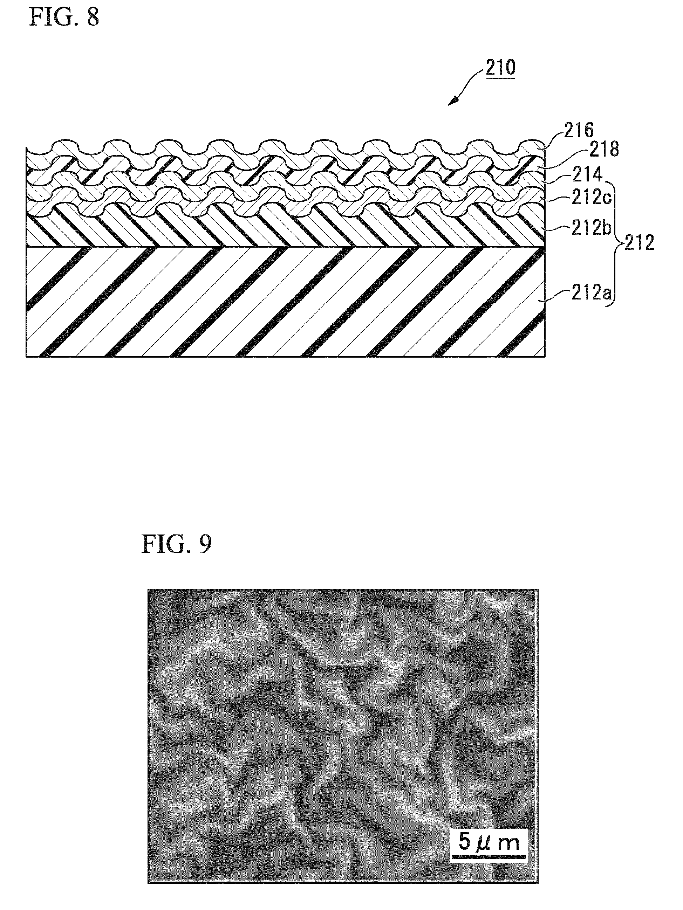

FIG. 8 shows a cross-sectional diagram illustrating an example of the surface-emitting body of the invention. This surface-emitting body 210 includes a transparent base material 212 having an uneven structure in a surface, a transparent electrode 214 that is provided to the transparent base material 12 on a surface side at which the uneven structure is provided, a rear surface electrode 216 that is provided to be spaced from the transparent electrode 214 and is constituted by a metal thin film, and a light-emitting layer 218 that is provided between the transparent electrode 214 and the rear surface electrode 216.

<Transparent Base Material>

The transparent base material 212 is a laminated body including a transparent supporting body 212a, an undercoat layer 212b formed on a surface of a transparent supporting body 212a, and a metal layer 212c formed on the undercoat layer 212b. The transparent base material 212 has an uneven structure in a surface thereof.

The transparent base material 212 includes a metal layer 212c that is formed by depositing aluminum on a surface of the undercoat layer 212b that is formed on a surface of the transparent supporting body 212a and is formed from a hardened material of a composition for forming an undercoat layer to be described later.

When forming the metal layer 212c on the surface of the undercoat layer 212b, aluminum is deposited on the surface of the undercoat layer 212b in a state in which the surface of the undercoat layer 212b is expanded due to heat during the deposition. In addition, when being cooled after completion of the deposition, the expanded undercoat layer 213 is shrunk so as to return to a state before the deposition. Since the coefficient of thermal expansion is greatly different between a metal and a resin, the wrinkle-like fine uneven structure is formed in a surface of the undercoat layer 212b due to a difference in a shrinkage rate between the undercoat layer 212b and the metal layer 212c during cooling (buckling phenomenon). At this time, since the metal layer 212c also conforms to the deformation of the surface of the undercoat layer 212b, a wrinkle-like fine uneven structure, which conforms to the wrinkle-like fine uneven structure in the surface of the undercoat layer 212b, is formed in the metal layer 212c.

Accordingly, in the transparent base material 212, as shown in an atomic force microscope image of FIG. 9, the wrinkle-like fine uneven structure is formed in the surface of the undercoat layer 212b and in the metal layer 212c due to a buckling phenomenon.

(Transparent Supporting Body)

Examples of a type of the transparent supporting body 212a include a film, a sheet, a plate, and the like.

As a material of the transparent supporting body 212a, a highly transparent material is preferable. Examples of this material include polyester (such as polyethylene terephthalate and polybutylene terephthalate), an acrylic resin (such as polymethylmethacrylate), polycarbonate, polyvinyl chloride, styrene-based resin (ABS resin), a cellulose-based resin (such as triacetyl cellulose), glass, and the like.

(Undercoat Layer)

The undercoat layer 212 is formed from a hardened material of a composition for forming an undercoat layer (hereinafter, may be simply referred to as "composition").

The composition for forming an undercoat layer includes urethane (meth)acrylate (A), a compound (B) having one or more radically polymerizable double bonds in a molecule (provided that, the urethane(meth)acrylate (A) is excluded); and a photopolymerization initiator (C).

The thickness of the undercoat layer 212b formed from the hardened material of the composition for forming an undercoat layer is preferably 0.5 $\mu$m or more, and more preferably 1 $\mu$m or more. When the thickness of the undercoat layer 212b is 0.5 $\mu$m or more, a sufficient buckling structure may be exhibited.

Although not particularly limited, the upper limit of the thickness of the undercoat layer 212b is preferably 100 $\mu$m or less, and more preferably 40 $\mu$m or less.

(Metal Layer)

The metal layer 212c is a layer formed by depositing aluminum on the undercoat layer 212b, and has a buckling structure (uneven structure). The buckling structure of the metal layer 212c is reflected to a surface shape of the transparent base material 212.

The thickness of the metal layer 212c is preferably 1 nm or more, and more preferably 20 nm or more. When the thickness of the metal layer 212c is 1 nm or more, a sufficient buckling structure may be exhibited.

Although not particularly limited, the upper limit of the thickness of the metal layer 212c is preferably 1,000 nm or less, and more preferably 100 nm or less.

(Uneven Structure)

The wrinkle-like fine uneven structure, which is formed in the surface of the undercoat layer 212b and in the metal layer 212c, has a wide uneven period distribution and concavity and convexity thereof extend in an irregular direction.

From the viewpoint of sufficiently increasing light extraction efficiency of the surface-emitting body 210 provided with the transparent base material 212, an average period of the convexities (or concavities) in the uneven structure is preferably 210 to 1,000 nm, and more preferably 200 to 500 nm.

The average period of the convexities (or concavities) may be obtained from an image of Fourier transformation of an image measured by the atomic force microscope or scanning electron microscope.

From the viewpoint of sufficiently increasing light extraction efficiency of the surface-emitting body 210 provided with the transparent base material 212, arithmetic average roughness of the convexities (or convexities) in the uneven structure is preferably 10 to 1,000 nm, and more preferably 50 to 700 nm.

The arithmetic average roughness (Rz) of the convexities (or concavities) is calculated according to the JIS standard from a numerical value measured by the atomic force microscope.

<Transparent Electrode>

The transparent electrode 214 is formed on the surface of the wrinkle-like fine uneven structure of the transparent base material 212, and thus has substantially the same wrinkle-like fine uneven structure as the uneven structure of the transparent base material 212.

The transparent electrode 214 may be either a positive electrode or a negative electrode. Commonly, the transparent electrode 214 is set as a positive electrode.

As a material of the transparent electrode 214, a metal oxide having conductivity, a metal capable of forming a metal thin film having a light-transmitting property, an organic polymer having conductivity, or the like are used.

Examples of the metal oxide having conductivity include indium oxide, zinc oxide, tin oxide, indium tin oxide (ITO), indium zinc oxide (IZO), and the like.

Examples of the metal capable of forming the metal thin film having a light-transmitting property include gold, platinum, silver, copper, aluminum, and the like.

Examples of the organic polymer having conductivity include polyaniline, a derivative thereof, polythiophene, PEDOT-PSS (poly(3,4-ethylenedioxythiophene):poly(styrenesulfonate)), a derivative thereof, and the like.

The transparent electrode 214 may be formed in a single layer or two or more layers.

From the viewpoint of compatibility between a light-transmitting property and conductivity, the thickness of the transparent electrode 214 is preferably 10 to 1,000 nm, and more preferably 50 to 500 nm.

In a case of a top emission type surface-emitting body, a reflective metal film may be provided between the transparent electrode 214 and the transparent base material 212.

As the metal film that is used, a metal such as silver, gold, and aluminum capable of effectively reflecting a wavelength of visible light may be used.

The thickness of the transparent electrode 214 is obtained by an apparatus for measuring a step difference, surface roughness, and a fine shape.

<Rear Surface Electrode>

The rear surface electrode 216 is formed on a surface of the wrinkle-like fine uneven structure of the light-emitting layer 218 to be described later, and thus has substantially the same wrinkle-like fine uneven structure as the uneven structure of the light-emitting layer 218.

The rear surface electrode 216 may be either a negative electrode or a positive electrode. Commonly, the rear surface electrode 216 is set as a negative electrode.

Examples of a material of the rear surface electrode 216 include lithium, sodium, potassium, rubidium, cesium, beryllium, magnesium, calcium, strontium, barium, aluminum, scandium, vanadium, zinc, yttrium, indium, cerium, samarium, europium, terbium, ytterbium, and the like. In addition, examples of the material of the second electrode 136 further include alloys obtained by combining two or more of these, metal salts such as fluorides of these, alloys of one or more of these and one or more selected from a group consisting of gold, silver, platinum, copper, manganese, titanium, cobalt, nickel, tungsten, and tin, and the like. Specific examples of the alloys include a magnesium-silver alloy, a magnesium-indium alloy, a magnesium-aluminum alloy, a indium-silver alloy, a lithium-aluminum alloy, a lithium-magnesium alloy, a lithium-indium alloy, a calcium-aluminum alloy, and the like.

The rear surface electrode 216 may be formed in a single layer or two or more layers.

In a case of a bottom emission type surface-emitting body, it is preferable that the rear surface electrode 216 be a reflective metal film.

In a case of a top emission type or double-sided transmission type surface emitting body, since emitted light is emitted to the outside through the rear surface electrode 216, it is preferable that the rear surface electrode 216 be a transmittable film or a translucent film.

<Light-Emitting Layer>

The light-emitting layer 218 is formed on the surface of the wrinkle-like fine uneven structure of the transparent electrode 214, and thus has substantially the same wrinkle-like fine uneven structure as the uneven structure of the transparent electrode 214.

In a case where the surface-emitting body 210 of the invention is an organic EL element, the light-emitting layer 218 contains a light-emitting material of an organic compound.

Examples of the light-emitting material of the organic compound include a material (such as CBP:IR(ppy)$_3$) obtained by doping a carbazole derivative (4,4'-N,N'-dicarbazole-diphenyl (CBP) or the like) that is a host compound of a phosphorescent compound with an iridium complex (tris(2-phenyl pyridine) iridium (Ir(ppy)$_3$)); metal complexes (tris(8-hydroxyquinoline) aluminum (Alq$_3$)) of 8-hydroxyquinoline or a derivative thereof; and other light-emitting materials that are known in the related art.

The light-emitting layer 18 may contain a hole transport material, an electron transport material, and the like in addition to the light-emitting material.

The light-emitting layer 218 may be formed in a single layer or two or more layers. For example, in a case of using the surface-emitting body 210 of the invention as white organic EL lighting equipment, the light-emitting layer 218 may have a laminated structure including a blue light-emitting layer, a green light-emitting layer, and a red light-emitting layer.

The thickness of the light-emitting layer 218 is preferably 10 nm to 3 μm, and more preferably 20 nm to 1 μm.

The thickness of the light-emitting layer 218 is obtained by an apparatus for measuring a step difference, surface roughness, and a fine shape.

(Method of Manufacturing Surface-Emitting Body)

The surface-emitting body 210 of the invention may be manufactured by a method including the following processes (I) to (IV).

(I) A process of preparing the transparent base material 212 having the uneven structure in a surface.
(II) A process of depositing a material of the transparent electrode on a surface of the transparent base material 12 on a side at which an uneven structure is provided to form the transparent electrode 214.
(III) A process of further depositing a material of the light-emitting layer after the process (II) to form the light-emitting layer 218 on the transparent electrode 214.
(IV) A process of further depositing a metal after the process (III) to form the rear surface electrode 216 constituted by a metal thin film on a surface of the light-emitting layer 218.

Process (I)

For example, the transparent base material 212 may be manufactured as described below.

First, a composition for forming an undercoat layer is applied onto the transparent supporting body 212a, this composition is irradiated with active energy rays and is cured, whereby the undercoat layer 212b formed from a hardened material of the composition is formed on the transparent supporting body 12a.

As a method of applying the composition, a method such as a bar coating method, a brush coating method, a spray coating method, a dip coating method, a spin coating method, and a flow coating method is used. Among these, from the viewpoints of application workability, flatness of a coated film, and homogeneity, the bar coating method is preferable.

Examples of the active energy rays include ultraviolet rays, electron rays, and the like. In a case of using a high-pressure mercury lamp, a condition in which an energy amount of ultraviolet rays that are irradiated is 500 to 4,000 mJ/cm$^2$ is preferable.

In addition, in a case where the composition for forming an undercoat layer contains an organic solvent, the organic solvent is volatilized before the composition is cured. It is preferable that the organic solvent be volatilized using an IR heater or a hot blast heater under conditions of 40 to 130°C and 1 to 20 minutes, and conditions of 60 to 130°C and 3 to 20 minutes are more preferable.

Next, aluminum is deposited on the undercoat layer 212b to form the metal layer 212c.

Examples of a deposition method include physical deposition methods such as a vacuum deposition method, a sputtering method, and an ion plating method, and the vacuum deposition method is preferable from the viewpoint that the buckling phenomenon easily occurs.

In the process, aluminum or an alloy thereof is deposited on the surface of the undercoat layer 212b in a state in which the surface of the undercoat layer 212b is expanded due to heat during the deposition.

Next, the undercoat layer 212b and the metal layer 212c are cooled to form the wrinkle-like fine uneven structure. Commonly, the cooling is performed in the air and at room temperature.

When the undercoat layer 212b and the metal layer 212c are cooled, shrinkage occurs in the surface of the undercoat layer 212b. On the other hand, since shrinkage of the metal layer 212c occurs less, and thus the wrinkle-like fine uneven structure is formed in the surface of the undercoat layer 212b due to a difference in a shrinkage rate between the undercoat layer 212b and the metal layer 212c (buckling phenomenon). At this time, the metal layer 212c also conforms to the deformation of the surface of the undercoat layer 212b, and thus a wrinkle-like fine uneven structure, which conforms to the uneven structure in the surface of the undercoat layer 212b, is also formed in the metal layer 212c.

In addition, as necessary, a process of transferring the uneven structure to an undercoat layer 212b on a surface of a separate transparent supporting body 212a by using a laminated body in which the wrinkle-like fine uneven structure is formed in the surface of the undercoat layer 212b and in the metal layer 212c as a mold, and a process of depositing aluminum on the undercoat layer 2212b, to which the uneven structure is transferred, of the separate transparent supporting body 212a may be repetitively performed. In this manner, when the transferring and the deposition are repeated, the transparent base material 210, which has an uneven structure with a high aspect ratio in a surface thereof, may be obtained.

Process (II)

Examples of a deposition method include physical deposition methods such as a vacuum deposition method, a sputtering method, and an ion plating method, and the sputtering method is preferable from the viewpoint of formation ease of the transparent electrode 214.

An UV ozone treatment, a plasma treatment, a corona treatment, or the like may be performed with respect to the surface of the transparent base material 212 before the deposition to improve adhesiveness between the transparent base material 212 and the transparent electrode 214.

A heating treatment, a vacuum treatment, a heating and vacuum treatment, or the like may be performed with respect to the transparent base material 212 before the deposition so as to remove a dissolved gas and an unreacted monomer that are contained in the transparent base material 212.

Process (III)

Examples of a deposition method include physical deposition methods such as a vacuum deposition method, a sputtering method, and an ion plating method. In a case where the material of the light-emitting layer is an organic compound, the vacuum deposition method is preferable.

An UV ozone treatment, a plasma treatment, a corona treatment, an excimer lamp treatment, or the like may be performed with respect to the surface of the transparent electrode 214 before the deposition to improve adhesiveness between the transparent electrode 214 and the light-emitting layer 218.

In a case where a separate functional layer to be described later is provided between the light-emitting layer 218 and the transparent electrode 214 or the rear surface electrode 216, the separate functional layer may be formed before or after forming the light-emitting layer 218 by the same method and conditions as the light-emitting layer 218.

Process (IV)

Examples of a deposition method include physical deposition methods such as a vacuum deposition method, a sputtering method, and an ion plating method, and the vacuum deposition method is preferable from the viewpoint of not causing damage to the organic layer that is a lower layer.

<Operational Effect>

In the surface-emitting body 210 described above, a hole supplied from the transparent electrode 214 and an electron supplied from the rear surface electrode 216 are coupled at the light-emitting layer 218, and thus the light-emitting layer 218 emits light. Light emitted from the light-emitting layer 218 transmits through the transparent electrode 214 and the transparent substrate 212, and is extracted from a radiation plane (a surface of the transparent substrate 212). In addition, a part of the light emitted from the light-emitting layer 218 is reflected by the metal thin film of the rear surface electrode 216, and then transmits through the light-emitting layer 218, the transparent electrode 214, and the transparent substrate 212, and is extracted from the radiation plane.

In addition, the surface-emitting body 210 is provided with the transparent base material 212 having an uneven structure in a surface thereof. In this transparent base material 212, the undercoat layer 212b is formed from a hardened material of a specific composition for forming an undercoat layer, and thus when depositing aluminum on a surface of the undercoat layer 212b, there is a tendency for the undercoat layer 212b to be expanded due to heat during deposition, and there is tendency for the undercoat layer 212b to be shrunk during cooling after the deposition. Furthermore, a difference in a shrinkage rate between the undercoat layer 212b and the metal layer 212c increases. Accordingly, the wrinkle-like fine uneven structure is formed in the surface of the undercoat layer 212b and in the metal layer 212c due to the buckling phenomenon. This uneven structure is a wrinkle-like fine uneven structure which has a wide uneven period distribution and in which concavity and convexity extend in an irregular direction.

Therefore, in the surface-emitting body 210 of the invention, a deviation in an angle and a wavelength of light, which is effectively diffracted or scattered by the wrinkle-like fine uneven structure of the transparent base material 212, is small. Accordingly, a wide range may be uniformly irradiated compared to the surface-emitting body of the related art.

<Other Embodiments>

The surface-emitting body of the invention is not limited to the surface-emitting body 210 of the illustrated example. For example, in the surface-emitting body 210, as a light-emitting material contained in the light-emitting layer, a light-emitting material of an organic compound is exemplified. However, in a case where the surface-emitting body is an inorganic EL element, a light-emitting material of an inorganic compound may be used as the light-emitting material.

In addition, a separate functional layer may be provided between the light-emitting layer and the transparent electrode or the rear surface electrode.

In a case where the surface-emitting body is an organic EL element, as the separate functional layer that is provided between the transparent electrode and the light-emitting layer, a hole injection layer and a hole transport layer may be exemplified in order from the transparent electrode side.

In a case where the surface-emitting body is an organic EL element, as the separate functional layer that is provided between the light-emitting layer and the rear surface electrode, a hole blocking layer, an electron transport layer, and an electron injection layer may be exemplified in order from the light-emitting layer side.

(Hole Injection Layer)

The hole injection layer is a layer comprising a hole injection material.

Examples of a material of the hole injection material include copper phthalocyanine (CuPc), vanadium oxide, an organic polymer having conductivity, transition metal-based oxides such as molybdenum oxide and vanadium oxide, copper phthalocyanine (CuPc), an organic polymer having conductivity, and other organic hole injection materials that are known in the related art.

In the case of the transition metal-based oxides, the thickness of the hole injection layer is preferably 2 to 20 nm, and more preferably 3 to 10 nm. In the case of the organic hole injection material, the thickness of the hole injection layer is preferably 1 to 100 nm, and more preferably 10 to 50 nm.

(Hole Transport Layer)

The hole transport layer is a layer comprising a hole transportable material.

Examples of the hole transportable material include triphenyl diamine (such as 4,4'-bis(m-tolyl phenyl amino) biphenyl (TPD)); and other hole transportable materials that are known in the related art.

The thickness of the hole injection layer is preferably 1 to 100 nm, and more preferably 10 to 50 nm.

(Hole-Blocking Layer)

The hole blocking layer is a layer comprising a hole blocking material.

Examples of the hole blocking material include 2,9-dimethyl-4, 7-diphenyl-1, 10-phenanthroline (BCP) and the like; and other hole blocking materials that are known in the related art.

The thickness of the hole injection layer is preferably 1 to 100 nm, and more preferably 5 to 50 nm.

(Electron Transport Layer)

The electron transport layer is a layer comprising an electron transportable material.

Examples of the electron transportable material include a metal complex (such as $Alq_3$) of 8-hydroxyquinoline or a derivative thereof, an oxadiazole derivative, and other electron transportable materials that are known in the related art.

The thickness of the electron transport layer is preferably 1 to 100 nm, and more preferably 10 to 50 nm.

(Electron Injection Layer)

The electron injection layer is a layer comprising an electron injection material.

Examples of the electron injection material include an alkali metal compound (such as lithium fluoride), an alkaline-earth metal compound (such as magnesium fluoride), a metal (such as strontium), and other electron injection materials that are known in the related art.

The thickness of the electron injection layer is preferably 0.1 to 50 nm, and more preferably 0.2 to 10 nm.

The thickness of the above-described separate functional layer is obtained by an apparatus for measuring a step difference, surface roughness, and a fine shape.

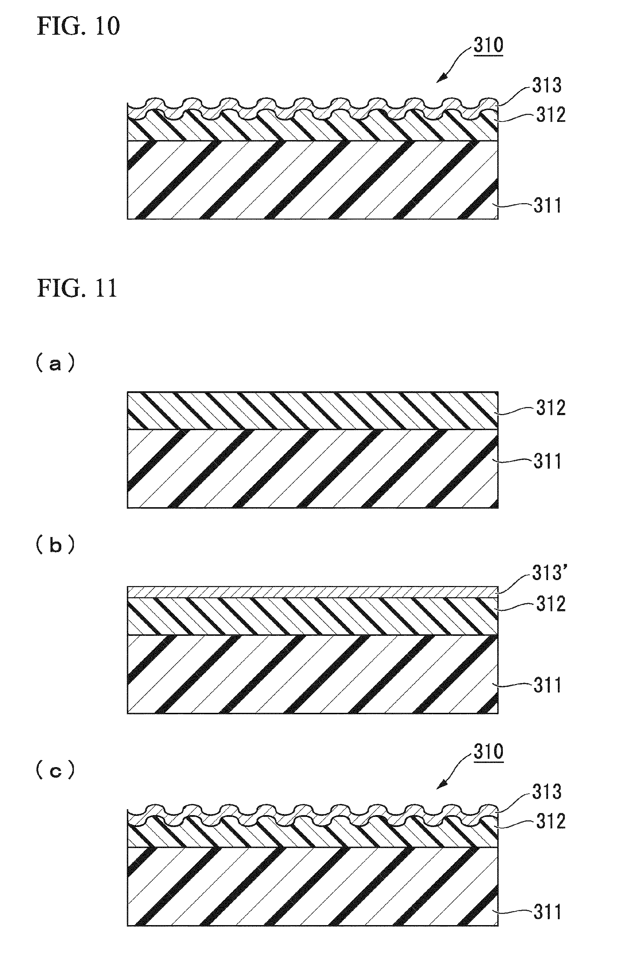

FIG. 10 shows a cross-sectional diagram illustrating an example of the laminated body of the invention.
The laminated body 310 includes a base material 311, an undercoat layer 312 that is formed on a surface of the base material 311, and a metal layer 313 that is formed on the undercoat layer 312. An uneven structure is formed in the surface of the laminated body 310.

<Base Material>

Examples of a type of the base material 311 include a film, a sheet, a plate, and the like.
Examples of a material of the base material 311 include inorganic materials such as glass and a metal; organic materials including polyolefin resins such as polypropylene and polyethylene, polyester resins such as a PET resin and a PBT resin, and polyurethane resins in addition to an ABS resin, an AES resin, a polycarbonate resin, and an acrylic resin; and the like. Particularly, the ABS resin, the polycarbonate resin, the acrylic resin, and the like are useful.

<Undercoat Layer>

The undercoat layer 312 is formed from a hardened material of a composition for forming an undercoat layer (hereinafter, may be simply referred to as "composition").
The composition for forming an undercoat layer includes urethane (meth)acrylate (A), a compound (B) having one or more radically polymerizable double bonds in a molecule (provided that, the urethane(meth)acrylate (A) is excluded); a photopolymerization initiator (C), and fine particles (D).

(Fine Particles (D))

In the fine particles (D) (hereinafter, simply referred to as "(D) component"), an average particle size is preferably 0.5 to 20 $\mu$m, and more preferably 1 to 10 $\mu$m. When the average particle size is 0.5 $\mu$m or more, since a surface area of each of the fine particles is small, aggregation is weak, and thus it is easy to handle the fine particles. On the other hand, when the average particle size is 20 $\mu$m or less, since the particle size is equal to or less than the film thickness of the undercoat layer 312, it is easy to form the undercoat layer 312 having a uniform film thickness.

Here, when the (D) component has a spherical shape, the particle size of the (D) component is a diameter thereof, and when the (D) component does not have the spherical shape, the particle size is a diameter when converting the volume thereof to a spherical shape. The average particle size of the (D) component is a number average particle size that is measured by a light-scattering method. In addition, in a case where the particle size of the (D) component is small and exceeds a measurement threshold according to the light-scattering method, the particle size is measured from an electron microscope photograph by an image analysis.

A shape of the (D) component is preferably a spherical shape from the viewpoint that it is easy to control the particle size of the fine particles.

Examples of the (D) component include inorganic fine particles such as silica, titanium oxide, zinc oxide, zirconia, and alumina; organic fine particles such as a silicone resin, a polystyrene resin, and a polyethylene resin; and the like. These may be used alone or in combination of two or more kinds.

As the (D) component, a commercially available product may be used. For example, tospearl series manufactured by Momentive Performance Materials Inc., functional fine particles chemisno manufactured by Soken Chemical & Engineering Co., Ltd., monodispersion silica particles manufactured by NISSAN CHEMICAL INDUSTRIES, LTD., and the like are suitable.

The content of the (D) component is preferably 1% by mass or more on the basis of 100% by mass of the composition for forming an undercoat layer, and more preferably 5% by mass or more. In addition, the content of the (D) component is preferably 60% by mass or less, and more preferably 40% by mass or less. When the content of the (D) component is 1% by mass or more, there is a tendency for the buckling structure to be easily controlled.

In addition, the larger the content of the (D) component, the further an effect of controlling the buckling structure is easily obtained. However, on the other hand, unevenness during application of the composition for forming an undercoat layer to the base material 11 further increases, and thus there is a tendency that it is difficult for the undercoat layer 312 to be uniformly formed. When the content of the (D) component is 60% by mass or less, there is a tendency for the undercoat layer 312 to be uniformly formed.

(Other Components)

The composition for forming an undercoat layer may contain photosensitizer such as 4-dimethylaminobenzoic acid methyl, 4-dimethylaminobenzoic acid ethyl, 4-dimethylaminobenzoic acid amyl, and 4-dimethylamino acetophenone that are known in the related art within a range not deteriorating an effect of the invention as necessary.

In addition, the composition for forming an undercoat layer may contain an additive such as a leveling agent, a deforming agent, an anti-settling agent, a lubricant, an abrading agent, a rust prevention agent, an anti-static agent, a photostabilizer, an ultraviolet ray adsorbing agent, and a polymerization inhibitor.

Furthermore, a polymer such as an acrylic polymer and an alkyd resin may be contained within a range not deteriorating an effect of the invention so as to improve adhesiveness.

In addition, the composition for forming an undercoat layer may contain an organic solvent for adjustment to preferable viscosity as necessary.

Examples of the organic solvent include a ketone-based compounds such as acetone, methyl ethyl ketone, and cyclohexanone; ester-based compounds such as methyl acetate, ethyl acetate, butyl acetate, ethyl lactate, and methoxy ethyl acetate; alcohol-based compounds such as ethanol, isopropyl alcohol, and butanol; ether-based compounds such as diethyl ether, ethylene glycol dimethyl ether, propylene glycol monomethyl ether, diethylene glycol monoethyl ether, diethylene glycol monobutyl ether, and dioxane; aromatic compounds such as toluene and xylene; aliphatic compounds such as pentane, hexane, and petroleum naphtha; and the like.

When a total of components other than the organic solvent in components contained in the composition for forming an undercoat layer is set to 100 parts by mass, the content of the organic solvent is preferably 100 to 500 parts by mass.

The thickness of the undercoat layer 312 formed from the hardened material of the composition for forming an undercoat layer is preferably 0.5 $\mu$m or more, and more preferably 1 $\mu$m or more. When the thickness of the undercoat layer 12 is 0.5 $\mu$m or more, a sufficient buckling structure may be exhibited.

Although not particularly limited, the upper limit of the thickness of the undercoat layer 312 is preferably 100 $\mu$m or less, and more preferably 40 $\mu$m or less.

As the composition for forming an undercoat layer, the following (composition I for forming an undercoat layer) or (composition II for forming an undercoat layer) is preferable.

(Composition I for forming an undercoat layer) comprising,

45 to 95% by mass of urethane(meth)acrylate (A),

1 to 50% by mass of a compound (B) having a radically polymerizable double bond (provided that, the urethane(meth) acrylate (A) is excluded), and

0.1 to 15% by mass of a photopolymerization initiator (C).

(Composition II for forming an undercoat layer) comprising,

25 to 90% by mass of urethane(meth)acrylate (A),

1 to 50% by mass of a compound (B) having a radically polymerizable double bond (provided that, the urethane(meth) acrylate (A) is excluded), and

0.1 to 15% by mass of a photopolymerization initiator (C), and

1 to 60% by mass of fine particles (D).

<Metal Layer>

The metal layer 313 is a layer which is formed by depositing aluminum on the undercoat layer 312, and in which a buckling structure (uneven structure) is formed. The buckling structure of the metal layer 313 is reflected to a surface shape of the laminated body 310.

The thickness of the metal layer 313 is preferably 1 to 1,000 nm, and more preferably 20 to 100 nm.

When the thickness of the metal layer 313 is 1 nm or more, a sufficient buckling structure may be exhibited. On the other hand, when the thickness of the metal layer 313 is 1,000 nm or less, it is possible to suppress the buckling structure from being enlarged too much, and thus it is possible to sufficiently express the iris color.

<Other layers>

In the laminated body 310 of the invention, a composition for forming an overcoat layer of a heat-curing type or an ultraviolet ray-curing type may be applied to the metal layer 313 to form an overcoat layer so as to prevent the metal layer 313 from being corroded, or the metal layer 313 may be treated with a plasma polymerized film or the like. However, in a case of forming the overcoat layer, the plasma polymerized film, or the like on a surface of the metal layer 313, a surface of the laminated body 310 on a side opposite to the base material is allowed to maintain an uneven structure that is reflected from the buckling structure of the metal layer 313.

<Method of Manufacturing Laminated Body>

For example, the laminated body of the invention may be manufactured as described below.

First, as shown in FIG. 11(a), the composition for forming an undercoat layer is applied onto the base material 311, this composition is irradiated with active energy rays and is cured, whereby the undercoat layer 312 formed from a hardened material of the composition is formed on the base material 311.

As a method of applying the composition, a method such as a bar coating method, a brush coating method, a spray coating method, a dip coating method, a spin coating method, and a flow coating method is used. Among these, from the viewpoints of application workability, flatness of a coated film, and homogeneity, the bar coating method is preferable.

Examples of the active energy rays include ultraviolet rays, electron rays, and the like. In a case of using a high-pressure mercury lamp, a condition in which an energy amount of ultraviolet rays that are irradiated is 500 to 4,000 mJ/cm$^2$ is preferable.

In addition, in a case where the composition for forming an undercoat layer contains an organic solvent, the organic solvent is volatilized before the composition is cured. It is preferable that the organic solvent be volatilized using an IR heater or a hot blast heater under conditions of 40 to 130°C and 1 to 20 minutes, and conditions of 60 to 130°C and 3 to 20 minutes are more preferable.

Next, as shown in FIG. 11(b), aluminum 313' is deposited on the undercoat layer 312. Then, as shown in FIG. 11(c), the laminated body 310 in which the metal layer 313 having the buckling structure is formed on the undercoat layer 312 and which has the uneven structure on a surface may be obtained. The reason the metal layer 313 has the buckling structure is considered to be as described below.

That is, a surface of the undercoat layer 313 is expanded due to heat during the deposition of aluminum, and when being cooled after completion of the deposition, the expanded undercoat layer 313 is shrunk so as to return to a state before the deposition. Since coefficient of thermal expansion is greatly different between a metal and a resin, "wrinkle" is formed due to a difference in a shrinkage rate during cooling, and thus the metal layer 313 has the buckling structure. In addition, a surface of the undercoat layer 312, that is, an interface with the metal layer 313 has an uneven shape that is reflected from the buckling structure of the metal layer 313.

The laminated body of the invention has the uneven structure, which is reflected from the buckling structure of the metal layer, on a surface, and thus expresses the iris color. The buckling structure of the metal layer is controlled by fine particles contained in the composition for forming an undercoat layer, and thus the buckling structure becomes a fine structure. Accordingly, the laminated body of the invention may express the iris color in a relative clear manner. With regard to the uneven period of the uneven structure of the laminated body, that is, the uneven period of the buckling structure of the metal layer, a period, in which a peak shown when Fourier-converting an image captured by an atomic force microscope or an electron microscope is 200 to 500 nm, is preferable. This peak value is an index indicating fineness of the buckling structure. The smaller the peak value is, the finer the buckling structure is.

As described above, according to the invention, since the metal layer is formed by depositing aluminum on the undercoat layer that is formed from a composition obtained by mixing fine particles to a specific resin, the buckling structure of the metal layer may be controlled. As a result, since the metal layer having the buckling structure that is finer compared to the related art is formed, the laminated body of the invention may express the iris color in a relatively clear manner.

The laminated body of the invention may be used, for example, as a mold for manufacturing an organic EL element or a base material of the organic EL element.

In a case of using the laminated body as the mold, first, a curable resin is applied to the laminated body on a surface side at which an uneven structure is provided, and a supporting body such as a film is disposed on the curable resin. Then, the curable resin is cured by photoirradiation or heat treatment to form a cured resin layer, to which an uneven structure of the laminated body is transferred, on a surface of the supporting body. The supporting body, on which the cured resin layer is formed on a surface thereof, is peeled from the laminated body. Then, a conductive underlying layer (for example, a transparent electrode, or the like), a light-emitting layer, and a transparent electrode are sequentially formed on the cured resin layer of the supporting body to obtain an organic EL element.

In the organic EL element that is manufactured by using the laminated body as a mold of the invention, a fine buckling structure of a metal layer provided to the laminated body is transferred as an uneven structure of the laminated body. Accordingly, a diffraction and scattering structure is formed inside the organic EL element, and thus light extraction efficiency increases.

In a case of using the laminated body of the invention as the base material of the organic EL element, a conductive underlying layer, a light-emitting layer, and a transparent electrode are sequentially formed on a surface of the laminated body on a side at which an uneven structure is provided to obtain the organic EL element.

In the organic EL element including the laminated body of the invention, a diffraction and scattering structure derived from the uneven structure of the laminated body is formed inside thereof, and thus light extraction efficiency increases.

The laminated body of the invention may be also used, for example, as a mold for manufacturing a thin film solar cell or a base member of the thin film solar cell.

In a case of using the laminated body as the mold, similarly to the above-described mold for manufacturing the organic EL element, a cured resin layer, to which an uneven structure is transferred, is formed on a surface of a supporting body. Next, a conductive underlying layer (for example, a transparent electrode, or the like), a photoelectric conversion layer, and a transparent electrode are sequentially formed on the cured resin layer of the supporting body to obtain a thin film solar cell.

In the thin film solar cell manufactured by using the laminated body of the invention as the mold, a fine buckling structure of a metal layer provided to the laminated body is transferred to as an uneven structure of the laminated body. Accordingly, a diffraction and scattering structure is formed inside the thin film solar cell, and due to an effect of this structure, an optical path length passing through the inside of the thin film solar cell becomes long, and thus power generation efficiency increases. In addition, a photoelectric conversion region of the thin film solar cell per unit area increases, and thus the power generation efficiency increases.

In a case of using the laminated body as the base material of the thin film solar cell, a conductive underlying layer, a photoelectric conversion layer, and a transparent electrode are sequentially formed on a surface of the laminated body on a side at which an uneven structure is provided to obtain the thin film solar cell.

In the thin film solar cell including the laminated body of the invention, a diffraction and scattering structure derived from the uneven structure of the laminated body is formed inside thereof. Due to this effect, an optical path length passing through the inside of the thin film solar cell becomes long, and thus power generation efficiency increases. In addition, a photoelectric conversion region of the thin film solar cell per unit area increases, and thus the power generation efficiency increases.

(Device A)

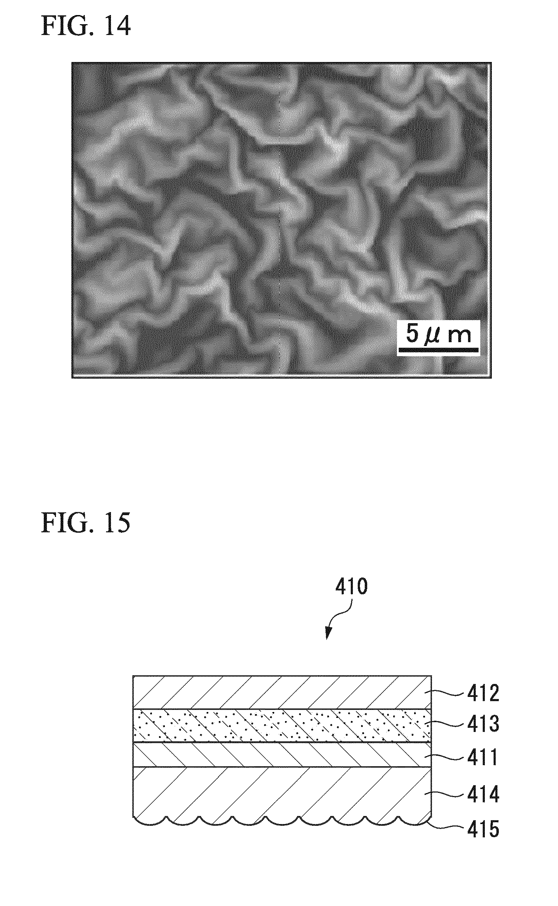

FIG. 15 illustrates a configuration of a device (organic EL element) 410 related to this embodiment. In this device A, a first electrode 411, an organic semiconductor layer 413, and a second electrode 412 are laminated in this order on a substrate 414. Furthermore, the substrate 414 is provided with a light extraction film 415, which has a fine concave-convex structure, on a light extraction side. The device A is a bottom emission type in which light generated in the organic semiconductor layer 413 is emitted from the side of the substrate 414. The first electrode 411 of the device A has a transmitting property, and as a material thereof, for example, indium-tin oxide (ITO), indium-zinc oxide (IZO), or the like is used. As a material of the second electrode 412 of the device A, for example, aluminum, silver, gold, or the like that has reflectivity is used. The organic semiconductor layer 413 may include a hole injection layer, a hole introduction layer, an electron transport layer, and an electron injection layer in addition to the light-emitting layer.

(Device B)

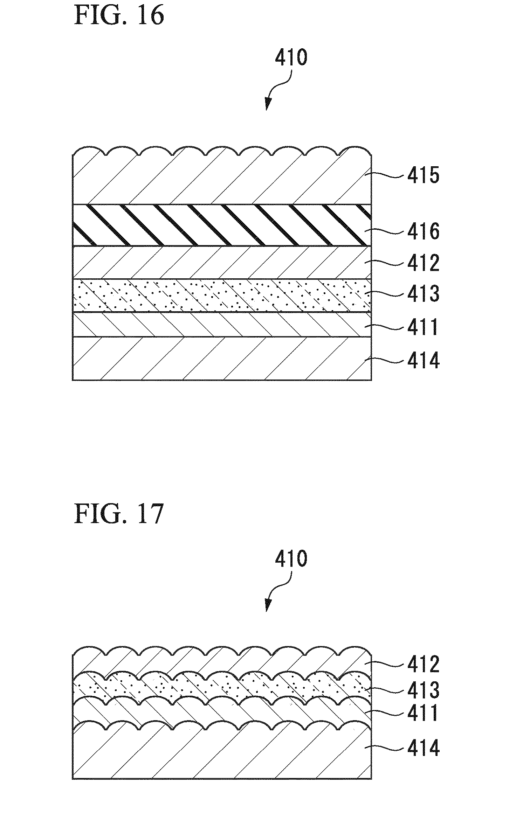

FIG. 16 illustrates another configuration of the device (organic EL element) 410 related to this embodiment. In this device B, the first electrode 411, the organic semiconductor layer 413, the second electrode 412, a sealing layer 416, and a light extraction film 415 are laminated in this order on the substrate 414. A reflective metal film, for example, aluminum, silver, gold, or the like is used for the first electrode of the device B, and the first electrode is formed on the metal film using indium-tin oxide (ITO), indium-zinc oxide (IZO), or the like. The second electrode of the device B has a transmitting property, and is formed on a thin negative electrode using, for example, indium-tin oxide (ITO), indium-zinc oxide (IZO), or the like. The sealing layer 416 is formed on the second electrode 412 using an inorganic sealing film and a resin sealant. The device B is a top emission type in which light generated in the organic semiconductor layer 413 is emitted from a side opposite to a substrate 414 side.

(Device C)

FIG. 17 illustrates still another configuration of the device (organic EL element) 410 related to this embodiment. In this device C, the first electrode 411, the organic semiconductor layer 413, and the second electrode 412 are laminated in this order on the substrate 414. As the first electrode of the device C, the same member as the device A is used. The substrate 414 of the device C is a light extraction substrate having a fine uneven structure on a substrate. As the second electrode of the device C, the same member as the device A is used. The device C is the bottom emission type in which light generated in the organic semiconductor layer 413 is emitted from the side of the substrate 414.

(Device D)

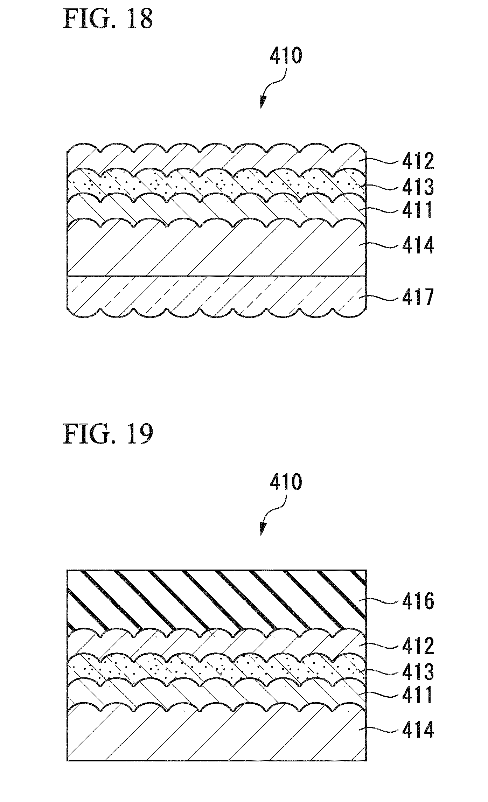

FIG. 18 illustrates still another configuration of the device (organic EL element) 410 related to this embodiment. In this device D, the substrate 414, the first electrode 411, the organic semiconductor layer 413, and the second electrode 412 are laminated in this order on an externally-attached member 417 for light extraction. The device D is a device that is provided with the externally-attached member 417 for extraction on a substrate side 414 of the device C. As the externally-attached member 417 for extraction of the device D, an optical film such as a prism-shaped film, a microlens-shaped film, and a diffusion film that contains scattering particles is generally attached. The device D is the bottom emission type in which the light generated in the organic semiconductor layer 413 is emitted from the side of the substrate 414.

(Device E)

FIG. 19 illustrates still another configuration of the device (organic EL element) 410 related to this embodiment. In this device E, the first electrode 411, the organic semiconductor layer 413, the second electrode 412, and the sealing layer 416 are laminated in this order on the substrate 414. The substrate 414 of the device E has a fine uneven structure on a substrate. As the first electrode 411, the second electrode 412, and the sealing layer 416 of the device E, the same members as the device B are used. The device E is the top emission type in which the light generated in the organic semiconductor layer 413 is emitted from a side opposite to a substrate 414 side.

(Device F)

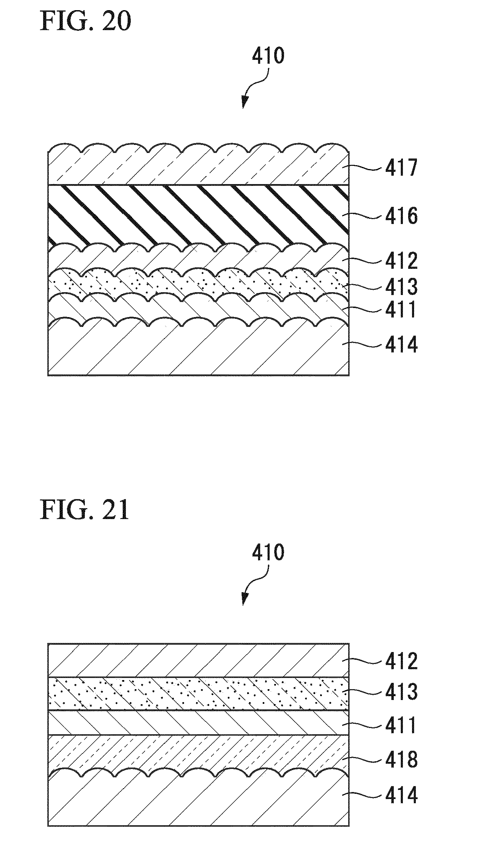

FIG. 20 illustrates still another configuration of the device (organic EL element) 410 related to this embodiment. In this device F, the first electrode 411, the organic semiconductor layer 413, the second electrode 412, the sealing layer 416, and the externally-attached member 417 for light extraction are laminated in this order on the substrate 414. As the substrate 414, the first electrode 411, the second electrode 412, and the sealing layer 416 of the device E, the same members as the device E are used. In addition, as the externally-attached member 417 for light extraction of the device F, the same member as the device D is used. The device F is the top emission type in which the light generated in the organic semiconductor layer 413 is emitted from a side opposite to a substrate 414 side.

(Device G)

FIG. 21 illustrates still another configuration of the device (organic EL element) 410 related to this embodiment. In this device G, the first electrode 411, a highly-refractive film 418, the organic semiconductor layer 413, and the second electrode 412 are laminated in this order on the substrate 414. As the substrate 414, the first electrode 411, the organic semiconductor layer 413, and the second electrode 412 of the device G, the same members as the device C are used. The device G is the bottom emission type in which the light generated in the organic semiconductor layer 413 is emitted from the side of the substrate 414.

(Device H)

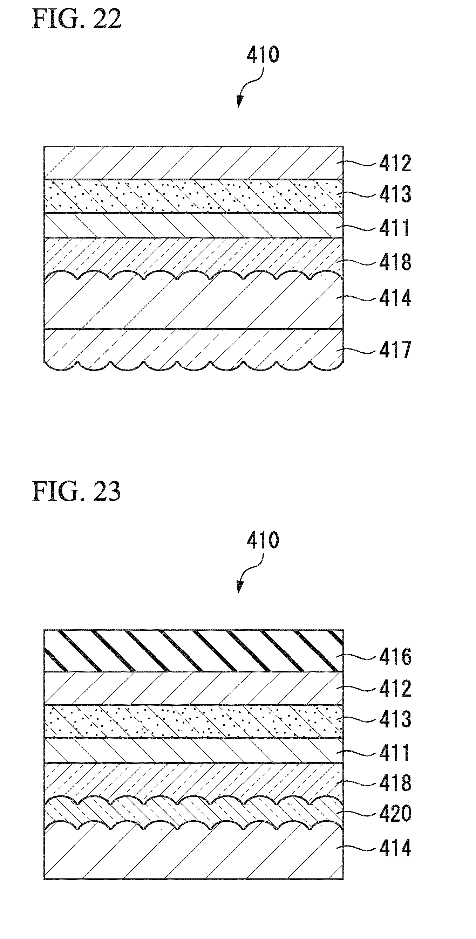

FIG. 22 illustrates still another configuration of the device (organic EL element) 410 related to this embodiment. In this device H, the substrate 414, the first electrode 411, the highly-refractive film 418, the organic semiconductor layer 413, and the second electrode 412 are laminated in this order on the externally-attached member 417 for light extraction. As the substrate 414, the first electrode 411, the organic semiconductor layer 413, and the second electrode 412 of the device H, the same members as the device C are used. The device G is the bottom emission type in which the light generated in the organic semiconductor layer 413 is emitted from the side of the substrate 414.

(Device I)

FIG. 23 illustrates still another configuration of the device (organic EL element) 410 related to this embodiment. In this device I, a reflective film 420, the highly-refractive film 418, the first electrode 411, the organic semiconductor layer 413, the second electrode 412, and the sealing layer 416 are laminated in this order on the substrate 414. As the substrate 414, the first electrode 411, the organic semiconductor layer 413, the second electrode 412, and the sealing layer 416 of the device I, the same members as the device E are used. In addition, as the highly-refractive film 418 of the device I, the same member as the device H is used. The device I is the top emission type in which the light generated in the organic semiconductor layer 413 is emitted from a side opposite to a substrate 414 side.

(Device J)

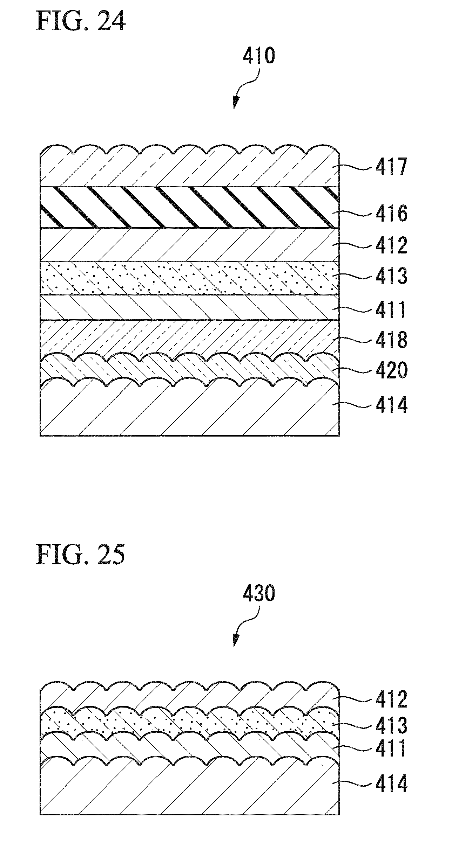

FIG. 24 illustrates still another configuration of the device (organic EL element) 410 related to this embodiment. In this device J, the reflective film 420, the highly-refractive film 418, the first electrode 411, the organic semiconductor layer 413, the second electrode 412, the sealing layer 416, and the externally-attached member 417 for light extraction are laminated in this order on the substrate 414. As the substrate 414, the first electrode 411, the organic semiconductor layer 413, the second electrode 412, and the sealing layer 416 of the device J, the same members as the device E are used. In addition, as the highly-refractive film 418 of the device J, the same member as the device H is used. As the externally-attached member 417 for light extraction of the device J, the same member as the device D is used.

(Device K)

FIG. 25 illustrates a configuration of a device (thin film solar cell) 430 related to this embodiment. In this device K, the first electrode 411, a photoelectric conversion layer 419, and the second electrode 412 are laminated in this order on the substrate 414.

The device K has high diffuse reflectance due to the fine uneven structure, and thus is capable of scattering and reflecting solar light, which is not adsorbed by the photoelectric conversion layer and transmits therethrough, and returning the solar light to a power generation layer. Accordingly, a light-trapping effect is high, and thus an improvement in power generation efficiency may be expected.

Any one of the devices A to K may be used, but particularly, devices such as devices D, F, H, and J that use the externally-attached member for extraction are preferable.

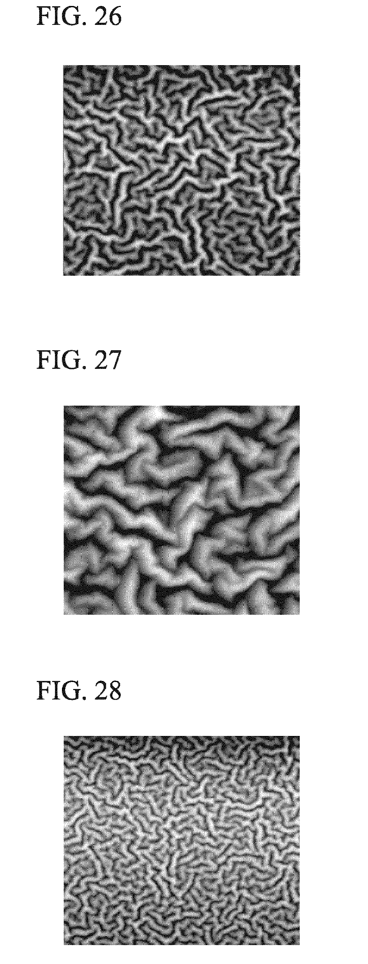

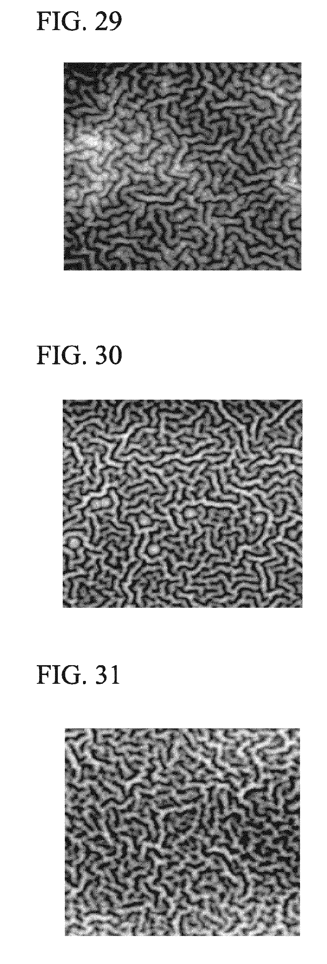

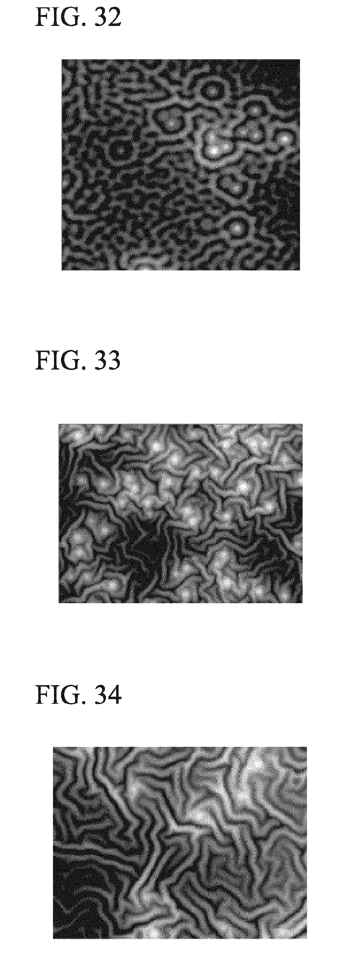

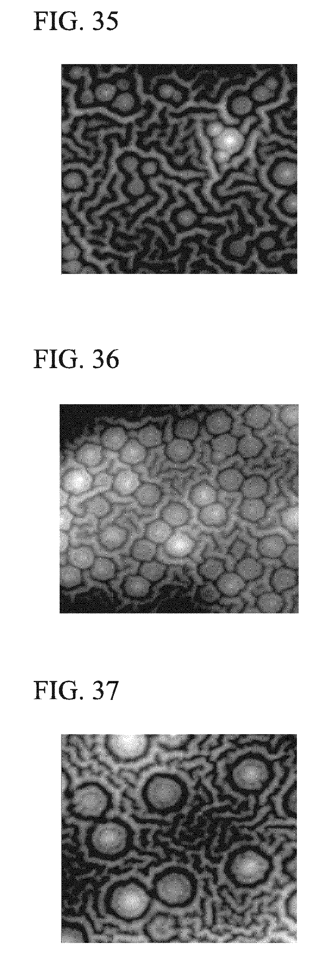

FIGS 26 to 37 show atomic force microscope image of the molds obtained by Examples 1 to 12, respectively, and have the fine uneven structure in a surface thereof. All of the molds satisfy Expression (1),

$$0.13 \leq (Ra'(max) - Ra'(min))/Ra \leq 0.82 \qquad (1)$$

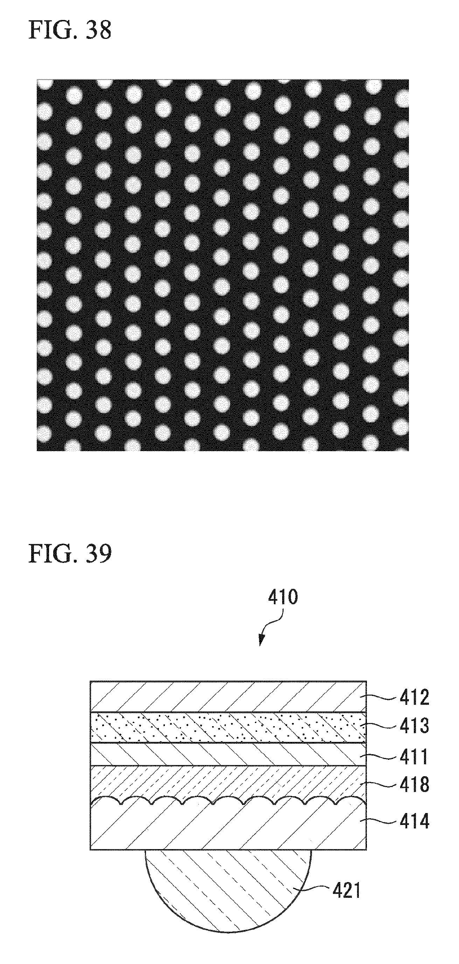

FIG. 38 shows an atomic force microscope image of a mold that is obtained in Comparative Example 4.

(Device X)

FIG. 39 illustrates an organic EL element in which a hemispherical lens is brought into optically close contact with a light extraction surface that is a rear surface of a device forming surface of the device G in such a manner that a flat-surface side of the hemispherical lens come into contact with matching oil. As the substrate 414, the first electrode 411, the highly-refractive film 418, the organic semiconductor layer 413, and the second electrode 412 of the device X, the same members as the device G are used.

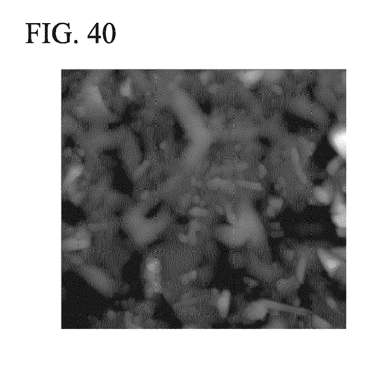

FIG. 40 shows an atomic force microscope image of a mold that is obtained in Comparative Example 3.

Examples

(AFM Measurement)

A measurement range of an object, which was manufactured in a size of 5 cm square, was equally divided into nine parts. With respect to measurement points of three arbitrary points for each divided range, that is, a total of 27 points, a range of 50 $\mu$m square and a range of 200 $\mu$m square were measured by an atomic force microscope (VN-8010, manufactured by KEYENCE CORPORATION; cantilever DFM/SS-Mode).

(Surface Roughness Measurement)

With regard to the 27 points measured within a range of 50 $\mu$m square, the entire range of the 50 $\mu$m square range is set to an analysis range, arithmetic average roughness and 10-point average height are measured according to surface roughness measurement of JIS B0601-1994, and arithmetic average surface roughness Ra and 10-point average height Rz that are average values of 27 points are calculated.

(Line Roughness)

With regard to 27 points measured within a range of 200 $\mu$m square, according to line roughness measurement of JIS B0601-1994, a measurement line having a width of 150 $\mu$m, and a measurement line having a width of 150 $\mu$m and rotated from the line by 15° with the central point set as a rotation center are drawn. This measurement line having a width of 150 $\mu$m is set to a reference and is rotated by 15° with the center thereof set as a rotation center. Similarly to the measurement line of the reference, a measurement line of 150 $\mu$m is drawn for each rotation angle. Then, a total of 12 measurement lines are measured.

A maximum value and a minimum value of arithmetic average line roughness in the total 12 measurement lines are calculated, and an average value of an uneven average distance in the total 12 measurement lines is set to Sm. This measurement is performed with respect to a total 27 measurement points of 200 $\mu$m square in a similar manner to calculate an average value Ra' (max) of maximum arithmetic average line roughness, an average value Ra' (min) of minimum arithmetic average line roughness, and an average value Sm of the uneven average distance. From the surface roughness Ra, the maximum value Ra'(max) and the minimum value Ra' (min) of the line roughness Ra' calculated by the above-described method, operation is carried out using the following Expression (1).

(Ra' (max)-Ra' (min))/Ra (1)

Average particle size/concentration, the arithmetic average roughness Ra, the 10-point average height Rz, the average value Sm of the uneven average distance, the maximum value Ra'(max) and the minimum value Ra'(min) of the line roughness Ra', and a value of Expression (1) of Examples 1 to 12 and Comparative Examples 3 and 4 are shown in Table A1.
(Table A1)

| | Average particle size/concentration | Ra (nm) | Rz (nm) | Sm (μm) | Ra' (nm) | | (Ra'max-Ra'min)/Ra |
|---|---|---|---|---|---|---|---|
| Example 1 | | 64.0 | 390.0 | 3.6 | Ra'max | 73.7 | 0.46 |
| | | | | | Ra'min | 44.4 | |
| Example 2 | | 128.3 | 764.5 | 5.8 | Ra'max | 166.4 | 0.42 |
| | | | | | Ra'min | 112.6 | |
| Example 3 | 0.3 μm/34% | 46.7 | 358.0 | 2.4 | Ra'max | 49.3 | 0.13 |
| | | | | | Ra'min | 43.2 | |
| Example 4 | 0.8 μm/7.9% | 71.5 | 439.6 | 3.3 | Ra'max | 75.6 | 0.44 |
| | | | | | Ra'min | 43.9 | |
| Example 5 | 1.5 μm/1.7% | 48.6 | 318.2 | 3.0 | Ra'max | 56.6 | 0.40 |
| | | | | | Ra'min | 37.1 | |
| Example 6 | 2.5 μm/14.7% | 45.0 | 272.6 | 4.0 | Ra'max | 60.6 | 0.46 |
| | | | | | Ra'min | 39.9 | |
| Example 7 | 2.5 μm/34.1% | 56.8 | 392.9 | 4.4 | Ra'max | 69.2 | 0.45 |
| | | | | | Ra'min | 43.5 | |
| Example 8 | 2.5 μm/11.1% | 92.5 | 666.3 | 2.9 | Ra'max | 145.3 | 0.82 |
| | | | | | Ra'min | 69.4 | |
| Example 9 | 2.5 μm/33.3% | 47.8 | 397.2 | 1.6 | Ra'max | 74.1 | 0.72 |
| | | | | | Ra'min | 39.5 | |
| Example 10 | Polydispersion 3 μm/14.7% | 79.0 | 539.4 | 5.1 | Ra'max | 90.2 | 0.20 |
| | | | | | Ra'min | 74.5 | |
| Example 11 | 5 μm/14.7% | 147.6 | 722.9 | 5.2 | Ra'max | 171.7 | 0.60 |
| | | | | | Ra'min | 83.5 | |
| Example 12 | 10 μm/14.7% | 79.5 | 454.8 | 4.2 | Ra'max | 85.8 | 0.34 |
| | | | | | Ra'min | 58.6 | |
| Comparative Example 3 | | 166.5 | 1505.0 | 3.9 | Ra'max | 178.5 | 0.12 |
| | | | | | Ra'min | 158.2 | |
| Comparative Example 4 | | 341.6 | 983.9 | 5.9 | Ra'max | 399.7 | 1.16 |
| | | | | | Ra'min | 4.1 | |

A base resin, average particle/concentration, an undercoat liquid, a mold, and a configuration of substrate, which are used in Examples 1 to 12, are shown in Table A2.
(Table A2)

| | Base resin | Average particle size/concentration | Undercoat liquid | Mold | Substrate |
|---|---|---|---|---|---|
| Example 1 | | | a-1 | x-1 | X-1 |
| Example 2 | | | a-2 | x-2 | X-2 |
| Example 3 | a-1 | 0.3 μm/34% | b-1 | y-1 | Y-1 |
| Example 4 | a-1 | 0.8 μm/7.9% | b-2 | y-2 | Y-2 |
| Example 5 | a-1 | 1.5 μm/1.7% | b-3 | y-3 | Y-3 |
| Example 6 | a-1 | 2.5 μm/14.7% | b-4 | y-4 | Y-4 |
| Example 7 | a-1 | 2.5 μm/34.1% | b-5 | y-5 | Y-5 |
| Example 8 | a-2 | 2.5 μm/11.1% | b-6 | y-6 | Y-6 |
| Example 9 | a-2 | 2.5 μm/33.3% | b-7 | y-7 | Y-7 |
| Example 10 | a-1 | Distribution 3 μm/14.7% | b-8 | y-8 | Y-8 |

| | | | | | |
|---|---|---|---|---|---|
| Example 11 | a-1 | 5 μm/14.7% | b-9 | y-9 | Y-9 |
| Example 12 | a-1 | 10 μm/14.7% | b-10 | y-10 | Y-10 |

(Measurement of Diffuse Reflectance)

Diffuse reflectance at 550 nm and 1 μm was measured using a spectrophotometer (U-4100, φ60 integrating sphere system, manufactured by Hitachi High-Technologies Corporation) and 10° correction spacer for diffuse reflectance measurement.

(Preparation of Undercoat Liquid)

(Adjustment of Undercoat Liquid (a-1))

DIABEAM UM-8002 (manufactured by Mitsubishi Rayon Co., Ltd., urethane acrylate mixture, a solid content: 29% by mass) was used.

(Adjustment of Undercoat Liquid (a-2))

<Preparation of Urethane(meth)acrylate (A)>

(1) 1,606 g of adipic acid, 589 g of ethyleneglycol, and 152 g of propyleneglycol were prepared in 3L four-neck flask provided with a distillation column, and generated water was removed by evaporation while heating the resultant mixture at 200°C. A point of time at which an outflow of water disappeared and an acid value became 1.0 or less was set as an end point, and polyesterdiol was obtained.

(2) Separately, 174 g of tolylenediisocyanate and 0.3 g of dibutyltin dilaurate were prepared in a 3L four-mouth flask, and the resultant mixture was heated until an internal temperature of a water bath reached to 50°C.

(3) 1,950 g of the polyesterdiol that was synthesized in (1) was prepared in a thermally insulated dropping funnel (thermal insulation of 60°C). An internal temperature of the flask was maintained at 50°C while stirring the flask content that was adjusted in (2), polyesterdiol in the dropping funnel was added dropwise at a constant velocity for four hours, and then the resultant mixture was stirred for reaction at a constant temperature for two hours.

(4) Next, a temperature of the flask content was raised to 60°C, and the flask content was stirred at a constant temperature for one hour. Liquid in which 116 g of 2-hydroxyethyl acrylate, 0.3 g of 2,6-di-tertiarybutyl-4-methylphenol, and 0.3 g of hydroquinone monomethyl ether were uniformly mixed and dissolved was prepared in another dropping funnel. The liquid inside the dropping funnel was added dropwise at a constant velocity for two hours while maintaining an internal temperature of the flask at 75°C, and then respective components were allowed to react with each other at a constant temperature for four hours, whereby urethane acrylate (UA) having a number average molecular weight of 4,600 in terms of polystyrene by GPC measurement was prepared.

Each component was weighed in a stainless steel vessel according to a mixing composition shown in Table 1, and the respective components were stirred for approximately 30 minutes until the entirety of an extracted body became uniform, whereby a composition (a-2) for forming an undercoat layer was prepared.

(Adjustment of Undercoat Liquid (b-1))

3.75 g of MEK-ST-2040 (manufactured by NISSAN CHEMICAL INDUSTRIES, LTD., monodispersion particles having an average particle size of 300 nm, a solid content: 40% by mass, and a solvent: MEK) was weighed for 10 g of the undercoat liquid (a-1), and then the entirety of the resultant mixture was uniformly stirred, whereby a composition (b-1) for forming an undercoat layer was prepared.

(Adjustment of Undercoat Liquid (b-2))

Instead of MEK-ST-2040, the entirety of 0.25 g of MX-80-H3WT (manufactured by Soken Chemical Engineering Co., Ltd., monodispersion particles having an average particle size of 800 nm, and a powder) was uniformly stirred for five minutes by a homogenizer (VC-130, manufactured by SONIC & MATERIALS; output: 10W), whereby a composition (b-2) for forming an undercoat layer was prepared.

(Adjustment of Undercoat Liquid (b-3))

A composition (b-3) for forming an undercoat layer was prepared by the same method as (b-2) except that 0.05 g of MX-150 (manufactured by Soken Chemical Engineering Co., Ltd., monodispersion particles having an average particle size of 1.5 $\mu$m, and a powder) was used instead of MEK-ST-2040.

(Adjustment of Undercoat Liquid (b-4))

A composition (b-4) for forming an undercoat layer was prepared by the same method as (b-2) except that 0.50 g of tospearl (tospearl 130, manufactured by Momentive Performance Materials Inc., average particle size: 3.0 $\mu$m, true specific gravity (25°C): 1.32, bulk specific gravity: 0.36, and specific surface area: 20 $m^2$/g) was used instead of MEK-ST-2040.

(Adjustment of Undercoat Liquid (b-5))

A composition (b-5) for forming an undercoat layer was prepared by the same method as (b-4) except that 1.50 g of tospearl was used.

(Adjustment of Undercoat Liquid (b-6))

An undercoat liquid (b-6) was adjusted similarly to Table 1 (Table described in Japanese Patent Application No. 2010-220198) by using the undercoat liquid (a-2) and the tospearl.

(Adjustment of Undercoat Liquid (b-7))

An undercoat liquid (b-7) was adjusted similarly to Table 1 (Table described in Japanese Patent Application No. 2010-220198) by using the undercoat liquid (a-2) and the tospearl.

(Adjustment of Undercoat Liquid (b-8))

A composition (b-8) for forming an undercoat layer was prepared by the same method as (b-2) except that 0.50 g of KMR-3 TA (manufactured by Soken Chemical Engineering Co., Ltd., polydispersion particles having an average particle size of 3.0 $\mu$m) was used instead of MEK-ST-2040.

(Adjustment of Undercoat Liquid (b-9))

A composition (b-9) for forming an undercoat layer was prepared by the same method as (b-2) except that 0.50 g of MX-500H (manufactured by Soken Chemical Engineering Co., Ltd., monodispersion particles having an average particle size of 5.0 $\mu$m, a powder) was used instead of MEK-ST-2040.

(Adjustment of Undercoat Liquid (b-10))

A composition (b-10) for forming an undercoat layer was prepared by the same method as (b-2) except that 0.50 g of MX-1000 (manufactured by Soken Chemical Engineering Co., Ltd., monodispersion particles having an average particle size of 10.0 $\mu$m) was used instead of MEK-ST-2040.

(Active Energy Ray-Curable Resin Composition (A-1))

45 parts by mass of 1,6-hexanediol acrylate (hereinafter, referred to as "C6DA"), 45 parts by mass of a condensation product of trimethylolethane/acrylic acid/succinic acid(2/4/1) (hereinafter, referred to as "TAS"), and 10 parts by mass of silicone(di)(meth)acrylate (X-22-1602, manufactured by Shin-Etsu Chemical Co., Ltd) were mixed, and the resultant mixture was stirred until 3 parts by mass of benzoilethyl ether (hereinafter, referred to as "BEE") was dissolved, whereby active energy ray-curable resin composition (A-1) was obtained.

(Active Energy Ray-Curable Resin Composition (A-2))

50 parts by mass of C6DA, 50 parts by mass of TAS, and 3 parts by mass of BEE were stirred until these components were dissolved, whereby an active energy ray-curable resin composition (A-2) was obtained.

(Active Energy Ray-Curable Resin (A-3) for Optical Sheet)

This resin was prepared by a method described in Japanese Patent Application No. 2010-138529 as (manufacturing example).
117.6 g (0.7 moles) of hexamethylene diisocyanate, 151.2 g (0.3 moles) of isocyanurate-type hexamethylene diisocyanate trimer, 128.7 g (0.99 moles) of 2-hydroxypropyl acrylate, 693 g (1.54 moles) of pentaerythritol triacrylate, 100 ppm of dilauryl acid di-n-butyl tin, and 0.55 g of hydroquinone monomethyl ether were prepared in a glass flask, these components were allowed to react with each other under a condition of 70 to 80°C until a concentration of remaining isocyanate became 0.1% or less, whereby an urethane acylate compound was obtained.
35 parts by mass of the urethane acrylate compound, 25 parts by mass of PBOM, 40 parts by mass of New Frontier BPEM-10 (manufactured by DAI-ICHI KOGYO SEIYAKU CO., LTD.), 1.2 parts by mass of 1-hydroxy cyclohexylphenylketone (IRGACURE 184, manufactured by TOYOTSU CHEMIPLAS CORPORATION), whereby active energy ray-curable resin composition (A-3) was obtained.

(Hemispherical Lens)

Spherical glass (3 mm$\phi$, BK-7, manufactured by SIGMA KOKI Co., LTD.) was processed to a hemisphere, a flat surface was cut from the center by 0.7 mm, and the cut surface was subjected to a mirror surface treatment, whereby a spherical lens was obtained.

(Microlens Array Sheet)

This sheet was prepared by a method described in Example 3 of Japanese Patent Application No. 2010-138529. A mold member having a microlens shape was prepared by an etching method described in PCT International Publication No. WO2008/069324. The mold member that was obtained had a shape in which hemispherical concave portions were arranged.
An active energy ray-curable resin composition was uniformly applied to a surface of the mold member, and the composition was covered with a polyethyleneterephthalate (hereinafter, referred to as "PET") film (cosmoshine A4300, manufactured by TOYOBO CO., LTD.) having a thickness of 188 $\mu$m, and then the active energy ray-curable resin composition was uniformly expanded with a hand roll. Irradiation of ultraviolet rays (integrated amount of light: 1,000 mJ/cm$^2$) was performed from an upper side of the PET film to cure the active energy ray-curable resin composition that was expanded between the mold member and the PET film. The PET film and a hardened material were peeled from the mold member, whereby a microlens sheet having a shape, which was inverted from a convex shape of the mold member, on a surface of the PET film was obtained. From observation using SEM (SE-4300SE/N, manufactured by Hitachi High-Technologies Corporation), it was confirmed that hemispherical convex portions having a diameter of 50 μm were regularly arranged.

(Light-Emission Measurement A)

A light extraction surface side of an organic EL element having a light-emitting area of 2 mm square was attached to a sample opening portion of an integrating sphere (manufactured by Labsphere, Inc., 8 inches) across a pin-hole having a diameter of 10 mm, and then optical properties of the organic EL element (E-1) were measured by an LED total luminous flux and efficiency measuring apparatus (C9920-22 system, PMA-12, manufactured by Hamamatsu Photonics K.K.). A current of 1 mA/cm$^2$ was allowed to flow through the organic EL element (E-1), and measurement of luminance was performed. When a luminance value of Comparative Example 1 that was a bottom emission type element or Comparative Example 2 that was a top emission type element was set to 100%, a progress rate in luminance of each type of element was calculated from measured luminance.

Bottom emission type: devices C, D, H, G, H, X, and Comparative Example 1

Top emission type: devices E, I, and comparative example 2

In addition, a variation in color was evaluated when observation was carried out in a normal line direction corresponding to an immediately above side of a light-emitting surface of an organic EL element having a light-emitting area of 2 mm square, and when observation was carried out in an oblique direction from the light-emitting surface that was deviated from the normal line by 60° with the normal line set to 0°. At this time, a degree of variation in a color was evaluated.

AA: Color variation does not occur
A: Color variation slightly occurs
B: Color variation occurs
C: Color separation occurs

(Light-Emission Measurement B)

Matching oil having a refractive index of 1.50 was applied to organic EL lighting equipment (Lumiblade Engineering Kit, manufactured by Philips Corporation; 30.5 mmx38 mm) on a light-emitting surface side, and a PET film side of a copy mold was brought into optically close contact with the matching oil. The copy mold-attached organic EL lighting equipment was attached to a sample opening portion of an integrating sphere (manufactured by Labsphere, Inc., 8 inches) across a pin-hole having a diameter of 10 mm. A luminous flux having a diameter of 10 mmφ when allowing a current of 23.2 mA to the organic EL lighting equipment was measured using a spectroscope (PMA-12, manufactured by Hamamatsu Photonics K.K.). In a case where a value of luminous flux when the copy mold was not attached was set to 100%, a progress rate was obtained by measurement of luminous flux.

(Example 1)

(Preparation of Mold (x-1))

The composition (a-1) for forming an undercoat layer was coated on an acrylic plate (L plate, manufactured by Mitsubishi Rayon Co., Ltd.; 3 mmt) having dimensions of 10 cm (length) x 10 cm (width) using a bar coater to have a thickness of approximately 15 μm after being cured. Next, the composition was heated at 60°C for three minutes to vaporize an organic solvent. Then, the composition was irradiated with ultraviolet rays, in which when measured by ultraviolet ray actinometer (ORC-UV-351, manufactured by ORC MANUFACTURING CO., LTD.), an integrated amount of light having a wavelength of 340 to 380 nm became energy of 1,000 mJ/cm$^2$, in the air using a high-pressure mercury lamp to form an undercoat layer on the acrylic plate.
Next, aluminum (manufactured by ULVAC TECHNO, Ltd., a batch-type vacuum deposition apparatus) was deposited on the undercoat layer according to a vacuum deposition method to form a metal layer having a thickness of 70 nm, whereby a mold (x-1) was obtained.
Diffuse reflectance of the mold (x-1) was measured, and it could be confirmed that satisfactory diffuse reflectance such as 94% at 550 nm and 81% at 1,000 nm was obtained. This implies that the aluminum film formed on the undercoat layer exhibits satisfactory diffuse reflectance, and thus a structure that is obtained may be used as a structure that is very suitable for a thin film solar cell.

(Preparation of Copy Mold (x'-1))

The active energy ray-curable resin composition (A-1) was supplied dropwise to a surface of the mold (x-1), and the composition was covered with a PET film (HK-31, manufactured by HYNT), and then the active energy ray-curable resin composition (A-1) was expanded with a hand roll. Irradiation of ultraviolet rays (an integrated amount of light: 1,000 mJ/cm$^2$) was performed from an upper side of the PET film to cure the active energy ray-curable resin composition (A-1). The PET film and an uneven resin layer were peeled from the mold (x-1), whereby the copy mold (x'-1) was obtained.

(Measurement of Device A)

Results of performing the light-emission measurement B using the copy mold (x'-1) are shown in Table A3.

(Preparation of Substrate (X-1))

The active energy ray-curable resin composition (A-2) was supplied dropwise to a surface of glass plate (Eagle XG, manufactured by Corning Incorporated, 5 cm square), and the composition was covered with the copy mold (x'-1), and then the active energy ray-curable resin composition (A-2) was expanded with a hand roll. Irradiation of ultraviolet rays (integrated amount of light: 1,000 mJ/cm$^2$) was performed from an upper side of the copy mold (x'-1) to cure the active energy ray-curable resin composition (A-2). The copy mold (X'-1) was peeled from the glass plate and an uneven resin layer, whereby the substrate (X-1) was obtained. Surface roughness of the substrate (X-1) was measured. AFM measurement results are shown in Table 2.

(Preparation of Substrate (X'-1))

A highly refractive zirconium liquid (ZRT15WT%-E28, manufactured by CIK NanoTek CO., LTD.) was applied to a surface of the substrate (X-1) using a spin coater, and the substrate was left as is at room temperature for 15 minutes, baking on a hot plate was performed at 200°C for one hour, and thus a highly-refractive film of approximately 1 μm was formed to have surface Ra of 10 nm or less, whereby the substrate (X'-1) was obtained.

(Evaluation of Device C)

The substrate (X-1) was cut to have dimensions of 25 mm square, was boiling washed with isopropyl alcohol, and then the substrate (X-1) was dried in a vacuum drying apparatus at 100°C for a whole day and night.
Then, the substrate (X-1) was set in a chamber of a sputtering apparatus, and ITO was deposited across a mask having a line-pattern hole to form an ITO transparent electrode having a thickness of 200 nm.
After UV ozone treatment, a transparent base material, in which the transparent electrode was formed, for a surface-emitting body was set in a chamber of a vacuum deposition apparatus. Under conditions of a pressure inside a metal chamber of 10-4 Pa and a deposition rate of 0.5 to 2.0 Å/sec, CuPc (20 nm) of the hole injection layer, TPD (40 nm) of the hole transport layer, CBP:Ir(ppy)$_3$ (20 nm) of the light-emitting layer, BCP (10 nm) of the hole blocking layer, and Alq$_3$ (30 nm) of the electron transport layer were sequentially deposited on the transparent electrode. Then, a light-emitting layer and a separate functional layer were selectively formed on the transparent electrode.
Furthermore, under a condition of a deposition rate of 0.059 Å/sec, lithium fluoride (0.5 nm) of the electron injection layer under conditions of the pressure inside a metal deposition chamber of 10-4 Pa and a deposition rate of 0.25 Å/sec, and aluminum (100 nm) of a rear surface electrode under a condition of a deposition rate of 0.5 to 4.0 Å/sec were sequentially deposited, whereby a light-emitting portion of 2 mm square was formed.
Excavated glass of 20 mm square was used, and sealing was performed using an epoxy-based sealant (manufactured by Nagase ChemteX Corporation) in such a manner that the light-emitting portion of 2 mm square was located within the excavated glass, and the outer periphery was cured by UV irradiation, whereby the organic EL element (E-1) was obtained.
Results of performing the light-emission measurement A of the organic EL element (E-1) are shown in Table A3.

(Evaluation of Device D)

Results of performing the light-emission measurement A of an organic EL element (F-1), in which a microlens sheet cut into 3 cm square was brought into optically close contact with a light extraction surface that was a rear surface of a device forming surface of the organic EL element (E-1) in such a manner that a PET film side came into contact with matching oil, are shown in Table A3.

(Evaluation of Device H)

An organic EL element (F-2) was obtained in the same manner as the device D except that the substrate (X'-1) was used instead of the substrate (X-1). Results of performing the light-emission measurement A of the organic EL element (F-2) are shown in Table A3.

(Evaluation of Device X)

Results of performing the light-emission measurement A of an organic EL element, in which a hemispherical lens was brought into optically close contact with a light extraction surface that was a rear surface of a device forming surface of the organic EL element (F-2) in such a manner that a flat surface side of the hemispherical lens came into contact with matching oil, are shown in Table A3.

(Evaluation of Device E)

The substrate (X-1) was cut to have dimensions of 25 mm square, was boiling washed with isopropyl alcohol, and then the substrate (X-1) was dried in a vacuum drying apparatus at 100°C for a whole day and night.
Then, the substrate (X-1) was set in a chamber of a metal depositing apparatus, and silver was deposited across a mask having a line-pattern hole under conditions of a pressure inside a metal depositing chamber of 10-4 pa and a deposition rate of 1.0 to 3.0 Å/sec, whereby 100 nm of silver was deposited. In a state in which the mask having the line-pattern hole was attached, the substrate (X-1) was set in a chamber of a sputtering apparatus to form an ITO transparent electrode having a thickness of 200 nm.
After UV ozone treatment, a transparent base material, in which the transparent electrode was formed, for a surface-emitting body was set in a chamber of a vacuum deposition apparatus. Under conditions of a pressure inside a metal deposition chamber of 10-4 Pa and a deposition rate of 0.5 to 2.0 Å/sec, CuPc (20 nm) of the hole injection layer, TPD (40 nm) of the hole transport layer, CBP:Ir(ppy)$_3$ (20 nm) of the light-emitting layer, BCP (10 nm) of the hole blocking layer, and Alq$_3$ (30 nm) of the electron transport layer were sequentially deposited on the transparent electrode. Then, a light-emitting layer and a separate functional layer were selectively formed on the transparent electrode.
Furthermore, under a condition of a deposition rate of 0.059 Å/sec, lithium fluoride (0.5 nm) of the electron injection layer under conditions of the pressure inside a metal deposition chamber of 10-4 Pa and a deposition rate of 0.25 Å/sec, and silver (20 nm) of a rear surface electrode under a condition of a deposition rate of 0.5 to 4.0 Å/sec were sequentially deposited, whereby a light-emitting portion of 2 mm square was formed.
Sealing glass through which a light-emitting portion of 2 mm square could be seen was used, sealing was performed with an epoxy-based sealant (manufactured by Nagase ChemteX Corporation) in such a manner that the resin spread across the entire surface in order for the light-emitting portion of 2 mm square to be located within the glass, and the sealant was cured by UV irradiation, whereby the organic EL element (E-3) was obtained.
A sealing glass side of the organic EL element (E-3) was set as a light extraction surface, and results of the light-emission measurement A compared with Comparative Example 2 are shown in Table A3.

(Evaluation of Device I)

A device organic EL element (F-3) was obtained in the same manner as the device E of Example 1 except that the substrate (X'-1) was used instead of the substrate (X-1). A sealing glass side of the organic EL element (F-3) was set as a light extraction surface, and results of the light-emission measurement A compared with Comparative Example 2 are shown in Table A3.

(Example 2)

(Preparation of Mold (x-2)

Molds (x-2) and (x'-2) were obtained in the same manner as Example 1 except that a rectangular test film that was molded from a PET resin and had a length of 10 cm, a width of 10 cm, and a thickness of 188 μm was used instead of the acrylic plate, and the composition (a-2) was used instead of the composition (a-1) for forming an undercoat layer. Diffuse reflectance of the mold (x-2) was measured, and it could be confirmed that satisfactory diffuse reflectance such as 95% at 550 nm and 97% at 1,000 nm was obtained. This implies that the aluminum film formed on the undercoat layer exhibits satisfactory diffuse reflectance, and thus a structure may be used as a structure that is very suitable for a thin film solar cell.

(Measurement of Device A)

Results of performing the light-emission measurement B using the copy mold (x'-2) are shown in Table A3.

(Preparation of Substrate (X-2))

The active energy ray-curable resin composition (A-2) was supplied dropwise to a surface of a glass plate (Eagle XG, manufactured by Corning Incorporated, 5 cm square), and the composition was covered with the mold (x-2), and then the active energy ray-curable resin composition (A-2) was expanded with a hand roll. Irradiation of ultraviolet rays (integrated amount of light: 1,000 mJ/cm$^2$) was performed from an upper side of the mold (x-2) to cure the active energy ray-curable resin composition (A-2). The mold (X-2) was peeled from the glass plate and an uneven resin layer, whereby the substrate (X-2) was obtained. Surface roughness of the substrate (X-2) was measured. AFM measurement results are shown in Table A3.

(Preparation of Substrate (X'-2))

A highly-refractive zirconium liquid (ZRT15WT%-E28, manufactured by CIK NanoTek CO., LTD.) was applied to a surface of the substrate (X-2) using a spin coater, the substrate was left as is at room temperature for 15 minutes, an operation of performing baking on a hot plate at 200°C for one hour was repetitively performed two times, and thus a highly-refractive film of approximately 1.5 $\mu$m was formed to have surface Ra of 10 nm or less, whereby the substrate (X'-2) was obtained.

(Evaluation of Device G)

An organic EL element (E-4) was obtained in the same manner as the device C of Example 1 except that the substrate (X'-2) was used instead of the substrate (X-1). Result of performing the light-emission measurement A of the organic EL element (E-4) are shown in Table A3.

(Evaluation of Device X)

Results of performing the light-emission measurement A of an organic EL element, in which a hemispherical lens was brought into optically close contact with a light extraction surface that was a rear surface of a device forming surface of the organic EL element (E-4) in such a manner that a flat surface side of the hemispherical lens came into contact with matching oil, are shown in Table A3.

(Example 3)

(Preparation of Mold (y-1) and Substrate (Y'-1))

A mold (y-1), a copy mold (y'-1), and a substrate (Y-1) were obtained by the same method as the mold (x-1) except that the composition (b-1) was used instead of the composition (a-1) for forming an undercoat layer. Results are shown in Table A3.
In addition, a substrate (Y'-1) was prepared in the same manner as Example 1.

(Evaluation of Device X)

Results of performing the light-emission measurement A of an organic EL element, in which a hemispherical lens was brought into optically close contact with a light extraction surface that was a rear surface of a device forming surface of an organic EL element (E-5) in such a manner that a flat surface side of the hemispherical lens came into contact with matching oil, are shown in Table A3.

(Example 4)

(Preparation of Mold (y-2) and Substrate (Y'-2)

A mold (y-2), a copy mold (y'-2), and substrates (Y-2) and (Y'-2) were obtained by the same method as the mold (x-1) except that the composition (b-2) was used instead of the composition (a-1) for forming an undercoat layer. Results are shown in Table A3.
In addition, the substrate (Y'-2) was prepared in the same manner as Example 1.

(Evaluation of Device X)

Results of performing the light-emission measurement A of an organic EL element, in which a hemispherical lens was brought into optically close contact with a light extraction surface that was a rear surface of a device forming surface of an organic EL element (E-6) in such a manner that a flat surface side of the hemispherical lens came into contact with matching oil, are shown in Table A3.

(Example 5)

(Preparation of Mold (y-3))

A mold (y-3), a copy mold (y'-3), and a substrate (Y-3) were obtained by the same method as the mold (x-1) except that the composition (b-3) was used instead of the composition (a-1) for forming an undercoat layer. Results are shown in Table A3.

(Evaluation of Device X)

Results of performing the light-emission measurement A of an organic EL element, in which a hemispherical lens was brought into optically close contact with a light extraction surface that was a rear surface of a device forming surface of an organic EL element (E-7) in such a manner that a flat surface side of the hemispherical lens came into contact with matching oil, are shown in Table A3.

(Example 6)

(Preparation of Mold (y-4))

A mold (y-4), a copy mold (y'-4), and a substrate (Y-4) were obtained by the same method as Example 1 except that the composition (b-4) was used instead of the composition (a-1) for forming an undercoat layer. Results are shown in Table A3.

(Evaluation of Device H)

Results of performing the light-emission measurement A of an organic EL element (F-8), in which a microlens sheet cut into 3 cm square was brought into optically close contact with a light extraction surface that was a rear surface of a device forming surface of an organic EL element (E-8) in such a manner that a PET film side came into contact with matching oil, are shown in Table A3.

(Example 7)

(Preparation of Mold (y-5))

A mold (y-5), a copy mold (y'-5), and a substrate (Y-5) were obtained by the same method as Example 1 except that the composition (b-5) was used instead of the composition (a-1) for forming an undercoat layer. Results are shown in Table A3.

(Evaluation of Device X)

Results of performing the light-emission measurement A of an organic EL element, in which a hemispherical lens was brought into optically close contact with a light extraction surface that was a rear surface of a device forming surface of an organic EL element (E-9) in such a manner that a flat surface side of the hemispherical lens came into contact with matching oil, are shown in Table A3.

(Example 8)

(Preparation of Mold (y-6))

A mold (y-6) and substrates (Y-6) and (Y'-6) were obtained by same method as the substrate (x-1) except that the composition (b-6) was used instead of the composition (a-2) for forming an undercoat layer. Results are shown in Table A3.

(Evaluation of Device X)

Results of performing the light-emission measurement A of an organic EL element, in which a hemispherical lens was brought into optically close contact with a light extraction surface that was a rear surface of a device forming surface of an organic EL element (E-10) in such a manner that a flat surface side of the hemispherical lens came into contact with matching oil, are shown in Table A3.

(Example 9)

(Preparation of Mold (y-7))

A mold (y-7) and substrates (Y-7) and (Y'-7) were obtained by the same method as the mold (x-2) except that the composition (b-7) was used instead of the composition (a-2) for forming an undercoat layer. Results are shown in Table A3.

(Evaluation of Device X)

Results of performing the light-emission measurement A of an organic EL element, in which a hemispherical lens was brought into optically close contact with a light extraction surface that was a rear surface of a device forming surface of an organic EL element (E-11) in such a manner that a flat surface side of the hemispherical lens came into contact with matching oil, are shown in Table A3.

(Example 10)

(Preparation of Mold (y-8))

A mold (y-8), a copy mold (y'-8), and substrates (Y-8) and (Y'-8) were obtained by the same method as the mold (x-1) except that the composition (b-8) was used instead of the composition (a-1) for forming an undercoat layer. Results are shown in Table A3.

(Evaluation of Device X)

Results of performing the light-emission measurement A of an organic EL element, in which a hemispherical lens was brought into optically close contact with a light extraction surface that was a rear surface of a device forming surface of an organic EL element (E-12) in such a manner that a flat surface side of the hemispherical lens came into contact with matching oil, are shown in Table A3.

(Example 11)

(Preparation of Mold (y-9))

A mold (y-9), a copy mold (y'-9), and substrates (Y-9) and (Y'-9) were obtained by the same method as the mold (x-1) except that the composition (b-9) was used instead of the composition (a-1) for forming an undercoat layer. Results are shown in Table A3.

(Evaluation of Device X)

Results of performing the light-emission measurement A of an organic EL element, in which a hemispherical lens was brought into optically close contact with a light extraction surface that was a rear surface of a device forming surface of an organic EL element (E-13) in such a manner that a flat surface side of the hemispherical lens came into contact with matching oil, are shown in Table A3.

(Example 12)

(Preparation of Mold (y-10))

A mold (y-10), a copy mold (y'-10), and substrates (Y-10) and (Y'-10) were obtained by the same method as the mold (x-1) except that the composition (b-10) was used instead of the composition (a-1) for forming an undercoat layer. Results are shown in Table A3.

(Evaluation of Device X)

Results of performing the light-emission measurement A of an organic EL element, in which a hemispherical lens was brought into optically close contact with a light extraction surface that was a rear surface of a device forming surface of an organic EL element (E-14) in such a manner that a flat surface side of the hemispherical lens came into contact with matching oil, are shown in Table A3.

(Comparative Example 1)

An organic EL element (G-1) was prepared in the same manner as the device G of Example 2 except that a glass plate (Eagle XG, manufactured by Coming Incorporated, 25 mm square) was used instead of the substrate (X'-1). The light-emission measurement A of the organic EL element (G-1) was performed, and it could be confirmed that when a current of 1 mA/cm$^2$ was allowed to flow, luminance was 270 cd/m$^2$ at a voltage of 6.7 V.

(Comparative Example 2)

An organic EL element (H-1) was prepared in the same manner as the device I of Example 1 except that a glass plate (Eagle XG, manufactured by Coming Incorporated, 25 mm square) was used instead of the substrate (X'-1). The sealing glass side of the organic EL element (H-1) was set as a light extraction surface, and the light-emission measurement A of the organic EL element (H-1) was performed, and it could be confirmed that when a current of 1 mA/cm$^2$ was allowed to flow, luminance was 325 cd/m$^2$ at a voltage of 7.5 V.

(Comparative Example 3) Blast

Blast particles (A400S, alumina particles) were supplied to a mirror-surface SUS plate of 20 cm square at a pressure of 0.3 MPa, a velocity of 20 mm/sec, a pitch of 2.5 mm, and a supplied amount of 30%, and were processed on the SUS plate using a blast apparatus (PAM107, manufactured by Yokohama Nicchu Co., Ltd.), whereby a mold (B-1) was prepared.
The active energy ray-curable resin composition (A-1) was supplied dropwise to a surface of the mold (b-1), and the composition was covered with a PET film (HK-31, manufactured by HYNT), and then the active energy ray-curable resin composition (A-1) was expanded with a hand roll. Irradiation of ultraviolet rays (an integrated amount of light: 1,000 mJ/cm$^2$) was performed from an upper side of the PET film to cure the active energy ray-curable resin composition (A-1). The PET film and an uneven resin layer were peeled from the mold (b-1), whereby a copy mold (b'-1) was obtained.

(Preparation of Substrate (B-1))

The active energy ray-curable resin composition (A-2) was supplied dropwise to a surface of a glass plate Eagle XG, manufactured by Corning Incorporated; 5 cm square), and the composition was covered with the copy mold (b'-1), and then the active energy ray-curable resin composition (A-2) was expanded with a hand roll. Irradiation of ultraviolet rays (an integrated amount of light: 1,000 mJ/cm$^2$) was performed from an upper side of the copy mold (b'-1) to cure the active energy ray-curable resin composition (A-2). The copy mold (b'-1) was peeled from the glass plate and an uneven resin layer, whereby a substrate (B-1) was obtained. Surface roughness of the substrate (B-1) was measured. AFM measurement results are shown in Table A1.

(Preparation of Substrate (B'-1))

A highly-refractive zirconium liquid (ZRT15WT%-E28, manufactured by CIK NanoTek CO., LTD.) was applied to a surface of the substrate (B-1) using a spin coater, the substrate was left as is at room temperature for 15 minutes, an operation of performing baking on a hot plate at 200°C for one hour was repetitively performed three times, and thus a highly-refractive film of approximately 2.0 $\mu$m was formed to have surface Ra of 10 nm or less, whereby the substrate (B'-1) was obtained.

The device G, H, and X were prepared in the same manner as Examples 1 and 2 except that the substrate (B'-1) was used instead of the substrate (X'-1), and evaluation thereof was performed. When Comparative Examples 1 and 2 are set to 100%, a progress rate is shown in Table A3.

(Comparative Example 4) Dot

The active energy ray-curable resin composition (A-1) was supplied dropwise to a surface of a filler array mold (manufactured by KYODO INTERNATIONAL, INC., height: 1 $\mu$m, concave-convex pitch: 4 $\mu$m, three-way arrangement, and material: quarts), and the composition was covered with a PET film (HK-31, manufactured by HYNT), and then the active energy ray-curable resin composition (A-1) was expanded with a hand roll. Irradiation of ultraviolet rays (integrated amount of light: 1,000 mJ/cm$^2$) was performed from an upper side of the PET film to cure the active energy ray-curable resin composition (A-1). The PET film and an uneven resin layer were peeled from a line-and-space mold, whereby a copy mold (c-2) having a hole array shape was obtained.

(Preparation of Substrate (C-2))

The active energy ray-curable resin composition (A-2) was supplied dropwise to a surface of a glass plate Eagle XG (manufactured by Coming Incorporated; 5 cm square), and the composition was covered with the copy mold (c-2), and then the active energy ray-curable resin composition (A-2) was expanded with a hand roll. Irradiation of ultraviolet rays (integrated amount of light: 1,000 mJ/cm$^2$) was performed from an upper side of the copy mold (c-2) to cure the active energy ray-curable resin composition (A-2). The copy mold (c-2) was peeled from the glass plate and an uneven resin layer, whereby a substrate (C-2) having a filler array shape was obtained. Surface roughness of the substrate (C-2) was measured. AFM measurement results are shown in Table A1.

(Preparation of Substrate (C'-2))

A highly refractive zirconium liquid (ZRT15WT%-E28, manufactured by CIK NanoTek CO., LTD.) was applied to a surface of the substrate (C-2) using a spin coater, the substrate was left as is at room temperature for 15 minutes, an operation of performing baking on a hot plate at 200°C for one hour was repetitively performed two times, and thus a highly-refractive film film of approximately 1.5 $\mu$m was formed to have surface Ra of 10 nm or less, whereby the substrate (C'-2) was obtained.

The device G, H, and X were prepared in the same manner as Examples 1 and 2 except that the substrate (C'-2) was used instead of the substrate (X'-1), and evaluation thereof was performed. When Comparative Examples 1 and 2 are set to 100%, a progress rate is shown in Table A3.

(Table A3)

| | Average particle size/concentration | Expression (1) (Ra'max-Ra'min)/Ra | Film adhesion Evaluation Result of device A | Bottom emission | | | | | Top emission | |
|---|---|---|---|---|---|---|---|---|---|---|
| | | | | Evaluation Result of device C | Evaluation Result of device D | Evaluation Result of device G | Evaluation Result of device H | Evaluation Result of device X | Evaluation Result of device E | Evaluation Result of device I |
| Comparative Example 3 | | 0.12 | | | | 129% AA | 198% AA | 214% AA | | |
| Comparative Example 4 | | 1.16 | | | | 140% C | 209% B | 267% C | | |
| Example 1 | | 0.46 | 120% | 152% AA | 260% A | | 218% AA | 232% AA | 165% AA | 142% AA |
| Example 2 | | 0.42 | 126% | | | 144% AA | 220% AA | 241% AA | | |
| Example 3 | 0.3 μm/34% | 0.13 | | | | | | 250% AA | | |
| Example 5 | 1.5 μm/1.7% | 0.40 | | | | | | 231% AA | | |
| Example 7 | 2.5 μm/34.1% | 0.45 | | | | | | 231% AA | | |
| Example 8 | 2.5 μm/11.1% | 0.82 | | | | | | 230% A | | |
| Example 9 | 2.5 μm/33.3% | 0.72 | | | | | | 245% A | | |
| Example 10 | distribution 3 μm/14.7% | 0.20 | | | | | | 244% AA | | |
| Example 11 | 5 μm/14.7% | 0.60 | | | | | | 224% AA | | |

<External Appearance Evaluation>

External appearance of a laminated body was observed with naked eyes, and determination was made based on the following standards.

A: Iris color is strongly expressed on a surface.
B: Iris color is expressed on the surface.
C: Iris color of the surface is not sufficient.

<Preparation of Urethane(meth)acrylate (A)>

(1) 1,606 g of Adipic acid, 589 g of ethyleneglycol, and 152 g of propyleneglycol were prepared in a 3L four-mouth flask provided with a distillation column, and generated water was removed by evaporation while heating the resultant mixture at 200°C. A point of time at which an outflow of water disappeared and an acid value became 1.0 or less was set as an end point, and polyesterdiol was obtained.

(2) Separately, 174 g of tolylenediisocyanate and 0.3 g of dibutyltin dilaurate were prepared in a 3L four-mouth flask, and the resultant mixture was heated until an internal temperature of a water bath reached to 50°C.

(3) 1,950 g of the polyesterdiol that was synthesized in (1) was prepared in a thermally insulated dropping funnel (thermal insulation of 60°C). An internal temperature of the flask was maintained at 50°C while stirring the flask content that was adjusted in (2), polyesterdiol in the dropping funnel was added dropwise at a constant velocity for four hours, and then the resultant mixture was stirred for reaction at a constant temperature for two hours.

(4) Next, a temperature of the flask content was raised to 60°C, and the flask content was stirred at a constant temperature for one hour. Liquid in which 116 g of 2-hydroxyethyl acrylate, 0.3 g of 2,6-di-tertiarybutyl-4-methylphenol, and 0.3 g of hydroquinone monomethyl ether were uniformly mixed and dissolved was prepared in another dropping funnel. The liquid inside the dropping funnel was added dropwise at a constant velocity for two hours while maintaining an internal temperature of the flask at 75°C, and then respective components were allowed to react with each other at a constant temperature for four hours, whereby urethane acrylate (UA) having a number average molecular weight of 4,600 in terms of polystyrene by GPC measurement was prepared.

[Example C1]

Each component was weighed in a stainless steel vessel according to a mixing composition shown in Table C1, and the respective components were stirred for approximately 30 minutes until the entirety of the resultant mixture became uniform, whereby a composition for forming an undercoat layer was prepared.
Next, a rectangular test film, which was molded from a PET resin and had a length of 10 cm, a width of 10 cm, and a

thickness of 188 $\mu$m, was coated with a composition for forming an undercoat layer using a bar coater to have a thickness of approximately 15 $\mu$m after being cured.

Next, the composition was heated at 60°C for three minutes to vaporize an organic solvent. Then, the composition was irradiated with ultraviolet rays, in which when measured by ultraviolet ray actinometer ("ORC-UV-351", manufactured by ORC MANUFACTURING CO., LTD.), an integrated amount of light having a wavelength of 340 to 380 nm became energy of 1,000 mJ/cm$^2$, in the air using a high-pressure mercury lamp to form an undercoat layer on an ABS resin.

Next, aluminum was deposited on the undercoat layer according to a vacuum deposition method to form a metal layer having a thickness of 70 nm, whereby a laminated body was obtained.

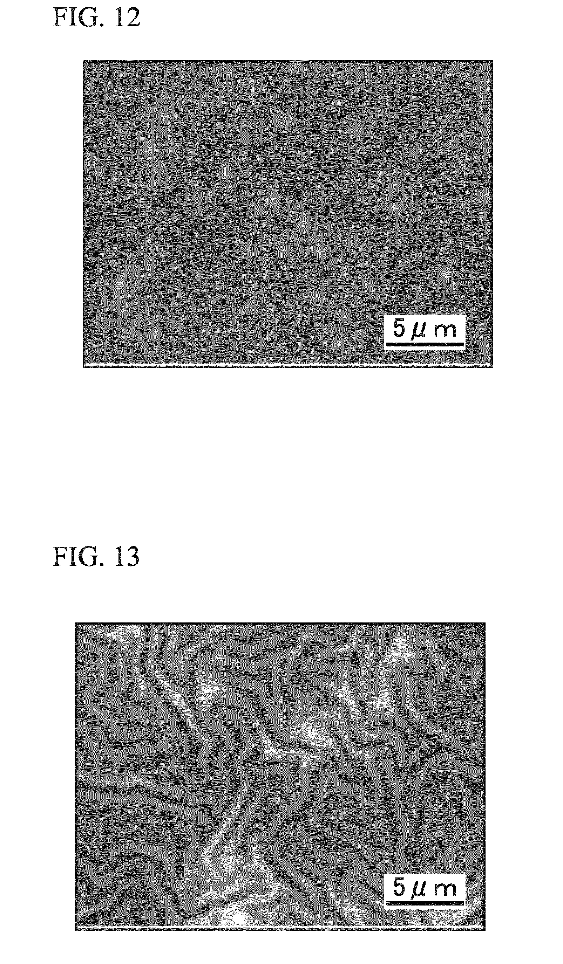

An external appearance evaluation was performed with respect to the laminated body that was obtained. Results thereof are shown in Table C1. In addition, a structure of a surface of the laminated body was observed with an atomic force microscope. An atomic force microscope image is shown in FIG. 12.

[Example C2 and Comparative Example C1]

A composition for forming an undercoat layer was prepared according to a mixing composition shown in Table C1 similarly to Example C1, and a laminated body was prepared using the composition and was evaluated. Results are shown in Table C1. In addition, an atomic force microscope image of the laminated body that was obtained is shown in FIGS. 13 and 14.

| (Table C1) | | | Example C1 | Example C2 | Comparative Example C1 |
|---|---|---|---|---|---|
| Composition for forming undercoat layer [parts by mass] | (A) component | UA | 39.2 | 52.4 | 59 |
| | (B) component | THFA | 13.0 | 17.3 | 19.5 |
| | | TDIHPA | 13.0 | 17.3 | 19.5 |
| | (C) component | BNP | 0.7 | 0.9 | 1.0 |
| | | HCPK | 0.7 | 0.9 | 1.0 |
| | (D) component | Tospearl 130 | 33.4 | 11.2 | 0.0 |
| | Organic solvent | Toluene | 52.5 | 51.3 | 50.0 |
| | | PGM | 100 | 100 | 100 |
| Evaluation of external appearance | | | A | B | C |

Abbreviations in Table C 1 are as follows.

UA: Urethane acylate

THFA: Tetrahydrofurfuryl acrylate (manufactured by OSAKA ORGANIC CHEMICAL INDUSTRY LTD.) TDIHPA: Urethane diacrylate composed of tolylenediisocyanate and 2-hydroxypropyl acrylate

BNP: Benzophenone

HCPK: 1-hydroxycyclohexylphenylketone

Tospearl 130: silicone resin fine particles ("tospearl 130", manufactured by Momentive Performance Materials Inc., average particle size: 3.0 $\mu$m, true specific gravity (25°C): 1.32, bulk specific gravity: 0.36, and specific surface area: 20 m$^2$/g)

PGM: Propylene glycol monomethyl ether

As is clear from Table C1, the laminated bodies, which were obtained in Examples C1 and C2, could express the iris color stronger than that of the laminated body that was obtained in Comparative Example C1.

In addition, as is clear from the atomic force microscope images shown in FIGS. 12 to 14, the laminated bodies, which were obtained in Examples C1 and C2, had an uneven structure finer than that of the laminated body that was obtained in Comparative Example C1.

As described above, the laminated body having a fine uneven structure is applicable to not only exterior parts that need iris color, but also members that improve light extraction efficiency of organic EL elements or improve photoincorporation efficiency of solar cells.

Industrial Applicability

The organic EL elements of the invention have high light-extraction efficiency, and thus may be appropriately used for surface emitting bodies that are constituted by the organic EL elements, and the like.

Reference Signs List

110: Mold
112: Mold base material
114: Undercoat layer
116: Metal thin film
120: Article
130: Surface-emitting body
132: Transparent base material
134: Transparent electrode
136: Rear surface electrode
138: Light-emitting layer
140: Protective plate for solar cell
142: Base material main body
160: Thin film based solar cell
162: Transparent base material
164: Base material main body
170: Thin film solar cell element
210: Surface-emitting body
212: Transparent base material
212a: Transparent supporting body
212b: Undercoat layer
212c: Metal layer
214: Transparent electrode
216: Rear surface electrode
218: Light-emitting layer
310: Laminated body
311: Base material
312: Undercoat layer
313': Aluminum
313: Metal layer
410: Organic EL element
411: First electrode
412: Second electrode
413: Organic semiconductor layer
414: Substrate
415: Light extraction film
416: Sealing layer
417: Externally attached member for light extraction
418: High refractive index film
419: Photoelectric conversion layer
420: Reflective film
421: Hemispherical lens
430: Thin film solar cell

**Claims**

1. A mold having an uneven structure,
   wherein surface roughness Ra of the uneven structure, a maximum value Ra' (max) and a minimum value Ra' (min) of line roughness Ra' satisfy the following Expression (1):

$$0.13 \leq (Ra'(max)-Ra'(min))/Ra \leq 0.82 \qquad (1).$$

**2.** The mold according to claim 1,
wherein in the mold having the uneven structure, aluminum or an alloy thereof is deposited on a surface of an undercoat layer that is formed on a surface of a base material and is formed from a hardened material of the following composition I or II for forming an undercoat layer:

composition I for forming an undercoat layer comprising,

45 to 95% by mass of urethane(meth)acrylate (1A
1 to 50% by mass of a compound (1B) having a radically polymerizable double bond (provided that, the urethane(meth)acrylate (1A) is excluded), and
0.1 to 15% by mass of a photopolymerization initiator (1C), and

composition II for forming an undercoat layer comprising,

25 to 90% by mass of urethane(meth)acrylate (2A),
1 to 50% by mass of a compound (2B) having a radically polymerizable double bond (provided that, the urethane(meth)acrylate (2A) is excluded),
0.1 to 15% by mass of a photopolymerization initiator (2C), and
1 to 60% by mass of fine particles (2D).

**3.** A light extraction substrate having an uneven structure for a surface-emitting body, wherein surface roughness Ra of the uneven structure and a maximum value Ra' (max) and a minimum value Ra' (min) of line roughness Ra' satisfy the following Expression (1):

$$0.13 \leq (Ra'(max)-Ra'(min))/Ra \leq 0.82 \qquad (1)$$

**4.** The light extraction substrate for a surface-emitting body according to claim 3,
wherein the extraction substrate for a surface-emitting body includes a transparent base material and a layer having an uneven structure.

**5.** The light extraction substrate for a surface-emitting body according to claim 3 or 4,
where the uneven structure is obtained by transferring concavity and convexity of the mold according to claim 1 or 2.

**6.** The light extraction substrate for a surface-emitting body according to claim 4,
wherein the layer having the uneven structure includes an undercoat layer formed from a hardened material of the following composition I or II for forming an undercoat layer, and a metal layer that is formed by depositing aluminum on the undercoat layer:

(composition I for forming an undercoat layer) comprising,

45 to 95% by mass of urethane(meth)acrylate (A),
1 to 50% by mass of a compound (B) having a radically polymerizable double bond (provided that, the urethane(meth)acrylate (A) is excluded), and
0.1 to 15% by mass of a photopolymerization initiator (C), and

composition II for forming an undercoat layer comprising,

25 to 90% by mass of urethane(meth)acrylate (A),
1 to 50% by mass of a compound (B) having a radically polymerizable double bond (provided that, the urethane(meth)acrylate (A) is excluded),
0.1 to 15% by mass of a photopolymerization initiator (C), and
1 to 60% by mass of fine particles (D).

**7.** A light extraction substrate for a surface-emitting body,
wherein the uneven structure of the light extraction substrate for a surface-emitting body according to any one of claims 3 to 6 is buried with and is flattened by a film in which a difference in a refractive index with the light extraction substrate for a surface-emitting body is higher by 0.1 or more.

**8.** A surface-emitting body comprising:

the light extraction substrate for a surface-emitting body according to any one of claims 3 to 7;
a transparent electrode that is provided on a surface of the light extraction substrate for a surface-emitting body;
a rear surface electrode that is provided to be spaced from the transparent electrode and is constituted by a metal thin film; and
a light-emitting layer that is provided between the transparent electrode and the rear surface electrode.

**9.** A protective plate for a solar cell,
wherein the protective plate includes the light extraction substrate for a surface-emitting body according to any one of claims 3 to 7.

**10.** A thin film solar cell comprising:

the light extraction substrate for a surface-emitting body according to any one of claims 3 to 7; and
a thin film solar cell element that is provided on a surface of the light extraction substrate for a surface-emitting body,
wherein the thin film solar cell element is provided to the light extraction substrate for a surface-emitting body on a side at which concavity and convexity is provided.

FIG. 1

110

116

114

112

FIG. 2

FIG. 3

FIG. 4

FIG. 5

FIG. 6

FIG. 7

## FIG. 8

## FIG. 9

5 μm

FIG. 10

FIG. 11

(a)

(b)

(c)

FIG. 12

5μm

FIG. 13

5μm

FIG. 14

FIG. 15

FIG. 16

410

415
416
412
413
411
414

FIG. 17

410

412
413
411
414

FIG. 18

410

FIG. 19

410

FIG. 20

410

417

416

412
413
411
414

FIG. 21

410

412

413

411

418

414

FIG. 22

410

FIG. 23

410

FIG. 24

410

417

416

412

413

411

418

420

414

FIG. 25

430

412

413

411

414

FIG. 26

FIG. 27

FIG. 28

FIG. 29

FIG. 30

FIG. 31

FIG. 32

FIG. 33

FIG. 34

FIG. 35

FIG. 36

FIG. 37

FIG. 38

FIG. 39

FIG. 40

| **INTERNATIONAL SEARCH REPORT** | International application No. |
| | PCT/JP2011/072655 |

**A. CLASSIFICATION OF SUBJECT MATTER**
*B29C33/42*(2006.01)i, *B29C33/38*(2006.01)i, *B29C59/02*(2006.01)i,
*G02B5/18*(2006.01)i, *H01L21/027*(2006.01)i, *H01L31/04*(2006.01)i,
*H01L51/50*(2006.01)i, *H05B33/02*(2006.01)i, *H05B33/10*(2006.01)i,
According to International Patent Classification (IPC) or to both national classification and IPC

**B. FIELDS SEARCHED**

Minimum documentation searched (classification system followed by classification symbols)
B29C33/42, B29C33/38, B29C59/02, G02B5/18, H01L21/027, H01L31/04,
H01L51/50, H05B33/02, H05B33/10, H05B33/14, B29L9/00, B29L31/00

Documentation searched other than minimum documentation to the extent that such documents are included in the fields searched
Jitsuyo Shinan Koho          1922-1996     Jitsuyo Shinan Toroku Koho     1996-2011
Kokai Jitsuyo Shinan Koho     1971-2011     Toroku Jitsuyo Shinan Koho     1994-2011

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2008-246714 A  (Nippon Zeon Co., Ltd.),<br>16 October 2008 (16.10.2008),<br>paragraphs [0001], [0007] to [0009]<br>(Family: none) | 1,3-5<br>2,6-10 |
| A | JP 2009-37810 A  (Sumitomo Chemical Co., Ltd.),<br>19 February 2009 (19.02.2009),<br>claims; paragraphs [0015] to [0017]<br>(Family: none) | 1-10 |
| A | JP 2009-152148 A  (Rohm Co., Ltd.),<br>09 July 2009 (09.07.2009),<br>paragraphs [0001], [0004], [0045]<br>& US 2009/0174319 A1 | 1-10 |

☒  Further documents are listed in the continuation of Box C.          ☐  See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>20 December, 2011 (20.12.11) | Date of mailing of the international search report<br>27 December, 2011 (27.12.11) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2011/072655 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2008-189914 A  (Mitsubishi Rayon Co., Ltd.), 21 August 2008 (21.08.2008), claims; paragraphs [0026], [0027] (Family: none) | 1-10 |

Form PCT/ISA/210 (continuation of second sheet) (July 2009)

| **INTERNATIONAL SEARCH REPORT** | International application No. |
|---|---|
| | PCT/JP2011/072655 |

Continuation of A. CLASSIFICATION OF SUBJECT MATTER
  (International Patent Classification (IPC))

$H05B33/14$(2006.01)i, $B29L9/00$(2006.01)n, $B29L31/00$(2006.01)n

      (According to International Patent Classification (IPC) or to both national
      classification and IPC)

Form PCT/ISA/210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010220196 A
- JP 2010220197 A
- JP 2010220198 A
- JP 2991183 B
- JP 2007054827 A
- JP 2010138529 A
- WO 2008069324 A

**Non-patent literature cited in the description**

- **WON HOE KOO.** Light extraction from organic light-emitting diodes enhanced by spontaneously formed buckles. *Nature Photonics,* 2010, vol. 4, 222-226